# EUROPEAN PATENT APPLICATION

(11) **EP 2 949 779 A1**
(43) Date of publication of application: **02.12.2015**
(21) Application number: 14743534.1
(22) Date of filing: 21.01.2014
(51) Int. Cl.: C23C 14/32, C23C 14/06

(54) **PLASMA DEVICE, CARBON THIN FILM MANUFACTURING METHOD AND COATING METHOD USING PLASMA DEVICE**

(30) Priority: 22.01.2013 JP 2013009363; 24.01.2013 JP 2013010820
(71) Applicant: Nissin Electric Co., Ltd., Kyoto 615-8686 (JP)
(72) Inventor: KATO, Kenji, Kyoto-shi Kyoto 615-8686 (JP); TAKAHASHI, Masato, Kyoto-shi Kyoto 615-8686 (JP); SUN, Qi, Kyoto-shi Kyoto 615-8686 (JP); MIKAMI, Takashi, Kyoto-shi Kyoto 615-8686 (JP); MIYAZAKI, Toshihiro, Kyoto-shi Kyoto 615-8686 (JP)
(74) Representative: Becker Kurig Straus
(86) International application number: PCT/JP2014/051141
(87) International publication number: WO 2014/115733

(57) **Abstract**

A plasma device (10) including a vacuum container (1), an arc-type evaporation source (3), a negative electrode member (4), a shutter (5), a power source (7), and a trigger electrode (8) is described. The arc-type evaporation source (3) is fixed to the side wall of the vacuum container (1) so as to face the substrate (20). The negative electrode member (4) is made from vitreous carbon having a protrusion and is mounted on the arc-type evaporation source (3). The power source (7) applies a negative voltage to the arc-type evaporation source (3). The trigger electrode (8) comes into contact with or separates away from the protrusion on the negative electrode member (4). A negative voltage is applied to the arc-type evaporation source (3), the trigger electrode (8) is brought into contact with the protrusion on the negative electrode member (4), an arc discharge is generated, the shutter (5) is opened, and a carbon thin film is formed on the substrate (20).

## Description

### BACKGROUND OF THE INVENTION

### Field of the Invention

The invention relates to a plasma device and a carbon thin film manufacturing method and a carbon thin film coating method that use the plasma device.

### Description of Related Art

Conventionally, among arc-type evaporation sources used in a thin film forming device for forming a thin film through arc discharge, an arc-type evaporation source that prevents coarse particles from attaching to the substrate is known (Patent Literature 1).

The arc-type evaporation source includes a vacuum container, a plasma duct, a porous member, a magnetic coil, and an evaporation source. The plasma duct has one end attached to the vacuum container. The evaporation source is attached to the other end of the plasma duct.

The magnetic coil is wound around the plasma duct. The magnetic coil leads the plasma generated near the evaporation source to the vicinity of the substrate that is disposed in the vacuum container.

The porous member is mounted on the inner wall of the plasma duct to capture coarse particles that are emitted from a negative electrode material attached to the evaporation source.

In this way, the conventional vacuum arc vapor deposition device connects the evaporation source to the vacuum container through the plasma duct and captures the coarse particles emitted from the negative electrode material with the porous member disposed on the inner wall of the plasma duct, so as to prevent the coarse particles from flying to the substrate.
Patent Literature 1: Japanese Patent Publication No. 2002-105628

### SUMMARY OF THE INVENTION

In the conventional vacuum arc vapor deposition device, however, graphite (carbon) is used as the negative electrode material and the graphite is manufactured by sintering carbon particles. Therefore, a particle boundary exists. As a result, when graphite is used as the negative electrode material, the negative electrode material may crack along the particle boundary and cause the problem of generation of coarse particles.

In view of the above, the invention provides a plasma device that is capable of suppressing cracking of the negative electrode material.

The invention further provides a carbon thin film manufacturing method for suppressing cracking of the negative electrode material to manufacture a carbon thin film.

Moreover, the invention further provides a carbon thin film coating method for suppressing cracking of the negative electrode material to coat a carbon thin film.

According to an embodiment of the invention, the plasma device includes a vacuum container, an arc-type evaporation source, a negative electrode member, a holding member, a discharge starting means, and a power source. The arc-type evaporation source is fixed to the vacuum container. The negative electrode member is attached to the arc-type evaporation source. The holding member holds a substrate that is disposed to face the negative electrode member. The discharge starting means starts a discharge. The power source applies a negative voltage to the arc-type evaporation source. The negative electrode member includes at least one columnar portion that includes a vitreous carbon and has a columnar shape. The discharge starting means starts the discharge such that a plasma is emitted from the at least one columnar portion of the negative electrode member.

According to an embodiment of the invention, the carbon thin film manufacturing method includes: a first process of attaching a negative electrode member to an arc-type evaporation source that is fixed to a vacuum container to face a substrate, wherein the negative electrode member includes at least one columnar portion that includes a vitreous carbon and has a columnar shape; a second process of applying a negative voltage to the arc-type evaporation source; and a third process of starting a discharge such that a plasma is emitted from the at least one columnar portion of the negative electrode member.

According to an embodiment of the invention, the coating method is for coating a carbon thin film on a surface of a substrate that includes any of a metal, ceramics, a resin, a semiconductor, and any combination of the foregoing. The coating method includes: a first process of holding the substrate to face an arc-type evaporation source fixed to a vacuum container; a second process of attaching a negative electrode member to the arc-type evaporation source, wherein the negative electrode member comprises at least one columnar portion that comprises a vitreous carbon and has a columnar shape; a third process of applying a negative voltage to the arc-type evaporation source; and a fourth process of starting a discharge such that a plasma is emitted from the at least one columnar portion of the negative electrode member.

The plasma device according to an embodiment of the invention applies a negative voltage to the arc-type evaporation source and generates a plasma to be emitted from the at least one columnar portion (including the vitreous carbon) of the negative electrode member, so as to manufacture a carbon thin film. As a result, heat distortion of the protrusion is reduced and atomic carbon is released from the columnar portion of the negative electrode member. In addition, the vitreous carbon has no particle boundary.

Accordingly, since the heat distortion of the protrusion is reduced and the vitreous carbon has no particle boundary, cracking of the negative electrode member may be suppressed.

In the carbon thin film manufacturing method according to an embodiment of the invention, a negative voltage is applied to the arc-type evaporation source and a plasma is generated to be emitted from the at least one columnar portion (including the vitreous carbon) of the negative electrode member, so as to manufacture a carbon thin film. Consequently, as described above, the carbon thin film may be manufactured with cracking of the negative electrode member suppressed.

In the carbon thin film coating method according to an embodiment of the invention, a negative voltage is applied to the arc-type evaporation source and a plasma is generated to be emitted from the at least one columnar portion (including the vitreous carbon) of the negative electrode member, so as to coat a carbon thin film on the surface of the substrate. Consequently, as described above, the carbon thin film may be coated on the substrate with cracking of the negative electrode member suppressed.

### BRIEF DESCRIPTION OF THE DRAWINGS

FIG. 1 is a schematic diagram showing the structure of the plasma device according to the first embodiment of the invention.
FIG. 2 is a perspective diagram of the negative electrode member shown in FIG. 1.
FIG. 3 is a cross-sectional diagram of the negative electrode member along the line III-III of FIG. 2.
FIG. 4 is a flow chart showing the carbon thin film manufacturing method using the plasma device shown in FIG. 1.
FIG. 5(a) and FIG. 5(b) are diagrams showing the surface shape of the carbon thin film.
FIG. 6 is a cross-sectional diagram of another negative electrode member according to the first embodiment.
FIG. 7 is a schematic diagram of yet another negative electrode member according to the first embodiment.
FIG. 8 is a cross-sectional diagram of the negative electrode member along the line VIII-VIII of FIG. 7.
FIG. 9 is a schematic diagram of yet another negative electrode member according to the first embodiment.
FIG. 10 is a cross-sectional diagram of the negative electrode member along the line X-X of FIG. 9.
FIG. 11 is a schematic diagram of yet another negative electrode member according to the first embodiment.
FIG. 12 is a cross-sectional diagram of the negative electrode member along the line XII-XII of FIG. 11.
FIG. 13 is a schematic diagram of yet another negative electrode member according to the first embodiment.
FIG. 14 is a cross-sectional diagram of the negative electrode member along the line XIV-XIV of FIG. 13.
FIG. 15 is a schematic diagram of yet another negative electrode member according to the first embodiment.
FIG. 16 is a cross-sectional diagram of the negative electrode member along the line XVI-XVI of FIG. 15.
FIG. 17 is a schematic diagram of yet another negative electrode member according to the first embodiment.
FIG. 18 is a cross-sectional diagram of the negative electrode member along the line XVIII-XVIII of FIG. 17.
FIG. 19 is a schematic diagram of yet another negative electrode member according to the first embodiment.
FIG. 20 is a cross-sectional diagram of the negative electrode member along the line XX-XX of FIG. 19.
FIG. 21 is a schematic diagram of yet another negative electrode member according to the first embodiment.
FIG. 22 is a cross-sectional diagram of the negative electrode member along the line XXII-XXII of FIG. 21.
FIG. 23 is a schematic diagram of yet another negative electrode member according to the first embodiment.
FIG. 24 is a cross-sectional diagram of the negative electrode member along the line XXIV-XXIV of FIG. 23.
FIG. 25 is a schematic diagram of yet another negative electrode member according to the first embodiment.
FIG. 26 is a cross-sectional diagram of the negative electrode member along the line XXVI-XXVI of FIG. 25.
FIG. 27 is a conceptual diagram of yet another negative electrode member according to the first embodiment.
FIG. 28 is a cross-sectional diagram of the negative electrode member along the line XXVIII-XXVIII of FIG. 27.
FIG. 29 is a schematic diagram showing the structure of another plasma device according to the first embodiment.
FIG. 30 is a schematic diagram showing the structure of the plasma device according to the second embodiment.
FIG. 31 is a schematic diagram showing the structure of the negative electrode member of FIG. 30.
FIG. 32 is a schematic diagram showing the structure of the air-powered mechanism of FIG. 30.
FIG. 33 is a diagram illustrating the mechanism for bringing the trigger electrode of FIG. 30 respectively in contact with all the vitreous carbons of the negative electrode member.
FIG. 34 is a flow chart showing the carbon thin film manufacturing method using the plasma device shown in FIG. 30.
FIG. 35 is a schematic diagram showing the structure of another plasma device according to the second embodiment.
FIG. 36 is a diagram illustrating the mechanism for bringing the trigger electrode of FIG. 35 respectively in contact with all the vitreous carbons of the negative electrode member.
FIG. 37 is a schematic diagram showing the structure of the plasma device according to the third embodiment.
FIG. 38 is a schematic diagram showing the structure of the delivery mechanism of FIG. 37.
FIG. 39 is a flow chart showing the carbon thin film manufacturing method using the plasma device shown in FIG. 37.
FIG. 40 is a schematic diagram showing the structure of the plasma device according to the fourth embodiment.
FIG. 41 is a cross-sectional diagram of one end of the trigger electrode shown in FIG. 40.
FIG. 42 is a plan view of one end of the trigger electrode shown in FIG. 40 when viewed from the side of the negative electrode member.
FIG. 43 is a schematic diagram showing the structure of the plasma device according to the fifth embodiment.
FIG. 44 is a cross-sectional diagram of one end of the trigger electrode shown in FIG. 43.
FIG. 45 is a plan view of one end of the trigger electrode shown in FIG. 43 when viewed from the side of the negative electrode member.
FIG. 46 is a conceptual diagram illustrating the trigger electrode of FIG. 43 in contact with the protrusion of the negative electrode member.
FIG. 47 is a cross-sectional diagram of another trigger electrode according to the fifth embodiment.
FIG. 48 is a schematic diagram showing the structure of the plasma device according to the sixth embodiment.
FIG. 49 is a diagram showing the temporal variation of the arc voltage.
FIG. 50 is a flow chart showing the carbon thin film manufacturing method using the plasma device shown in FIG. 48.
FIG. 51 is a schematic diagram showing the structure of the plasma device according to the seventh embodiment.
FIG. 52 is a flow chart showing the carbon thin film manufacturing method using the plasma device shown in FIG. 51.
FIG. 53 is a schematic diagram showing the structure of the plasma device according to the eighth embodiment.
FIG. 54 is a diagram illustrating positions of the permanent magnets shown in FIG. 53.
FIG. 55(a) and FIG. 55(b) are conceptual diagrams illustrating the function of the permanent magnets shown in FIG. 53.
FIG. 56 is a flow chart showing the carbon thin film manufacturing method using the plasma device shown in FIG. 53.
FIG. 57 is a schematic diagram showing the structure of the plasma device according to the ninth embodiment.
FIG. 58(a), FIG. 58(b), and FIG. 58(c) are diagrams illustrating the function of the permanent magnet shown in FIG. 57.
FIG. 59 is a flow chart showing the carbon thin film manufacturing method using the plasma device shown in FIG. 57.
FIG. 60 is a schematic diagram showing the structure of another plasma device according to the ninth embodiment.
FIG. 61(a), FIG. 61(b), and FIG. 61(c) are diagrams illustrating the function of the electromagnet (the coil and the power source) shown in FIG. 60.
FIG. 62 is a schematic diagram showing the structure of the plasma device according to the tenth embodiment.
FIG. 63 is a diagram showing the relation between the axial magnetic field and the arc current density based on the percentage of the discharge being not arc-extinguished.
FIG. 64 is a diagram showing the relation between the axial magnetic field and the arc current density based on the percentage of the arc spot not moving to the main body.
FIG. 65 is a perspective view of the vitreous carbon before discharge.
FIG. 66 is a view of the vitreous carbon after the first discharge is completed.
FIG. 67 is a view of the vitreous carbon after the second discharge is completed.
FIG. 68 is a view of the negative electrode member before discharge.
FIG. 69 is a view of the protrusion after discharge, which uses the vitreous carbon (protrusion) having a diameter of 3 mmϕ.
FIG. 70 is a view of the protrusion after discharge, which uses the vitreous carbon (protrusion) having a diameter of 5.2 mmϕ.
FIG. 71 is a view of the protrusion after discharge, which uses the vitreous carbon (protrusion) having a diameter of 2 mmϕ.
FIG. 72 is a schematic diagram showing the structure of another plasma device according to the tenth embodiment.
FIG. 73 is an enlarged diagram of the negative electrode member and the coil shown in FIG. 72.
FIG. 74 is a diagram showing another coil according to the tenth embodiment.
FIG. 75 is a structural diagram showing the structure of yet another plasma device according to the tenth embodiment.
FIG. 76 is an enlarged diagram of the arc-type evaporation source, the negative electrode member, and the coil shown in FIG. 75.
FIG. 77 is a flow chart showing the carbon thin film manufacturing method using the plasma device shown in FIG. 62.
FIG. 78 is a schematic diagram showing the structure of the plasma device according to the eleventh embodiment.
FIG. 79 is a plan view of the permanent magnet, the gears, and the counterweight shown in FIG. 78 when viewed from the side of the substrate.
FIG. 80 is a schematic diagram showing the structure of another plasma device according to the eleventh embodiment.
FIG. 81 is a flow chart showing the carbon thin film manufacturing method using the plasma device shown in FIG. 78.
FIG. 82 is a schematic diagram showing the structure of the plasma device according to the twelfth embodiment.
FIG. 83 is a schematic diagram showing the structure of the plasma device according to the thirteenth embodiment.
FIG. 84 is a flow chart showing the carbon thin film manufacturing method using the plasma device shown in FIG. 83.
FIG. 85 is a schematic diagram showing the structure of the plasma device according to the fourteenth embodiment.
FIG. 86 is a flow chart showing the carbon thin film manufacturing method using the plasma device shown in FIG. 85.
FIG. 87 is a schematic diagram showing the structure of the plasma device according to the fifteenth embodiment.
FIG. 88 is a flow chart showing the carbon thin film manufacturing method using the plasma device shown in FIG. 87.
FIG. 89(a) and FIG. 89(b) are diagrams of the negative electrode member according to an embodiment of the invention.

### DESCRIPTION OF THE EMBODIMENTS

Embodiments of the invention are described in detail below with reference to the figures. The same or equivalent parts in the figures are assigned with the same reference numerals and descriptions thereof are not repeated hereinafter.

### [First Embodiment]

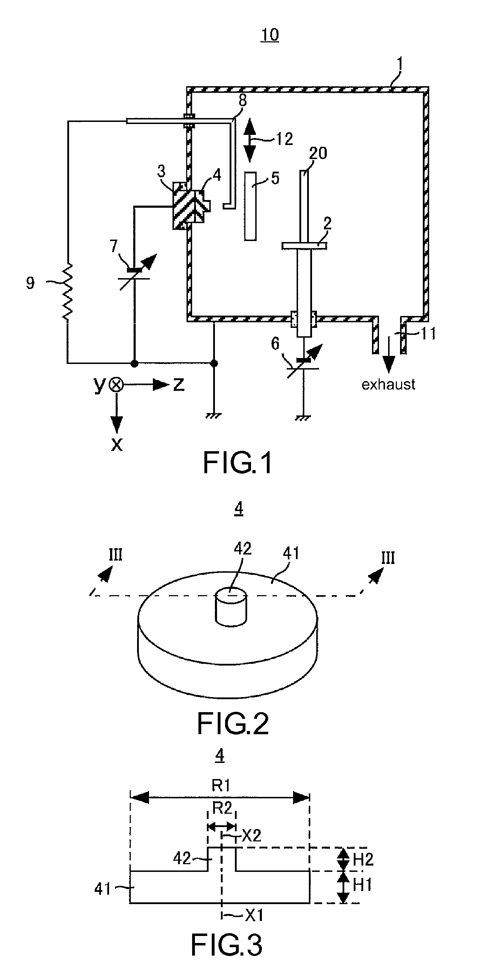

FIG. 1 is a schematic diagram showing the structure of a plasma device according to the first embodiment of the invention. With reference to FIG. 1, the plasma device of the first embodiment of the invention includes a vacuum container 1, a holding member 2, an arc-type evaporation source 3, a negative electrode member 4, a shutter 5, power sources 6 and 7, a trigger electrode 8, and a resistor 9.

Regarding the plasma device 10, the x axis, y axis, and z axis are defined as shown in FIG. 1.

The vacuum container 1 has an exhaust port 11 and the vacuum container 1 is exhausted by an exhaust device (not shown) through the exhaust port 11 to create a vacuum. The vacuum container 1 is connected to a ground node GND.

The holding member 2 is disposed in the vacuum container 1. The arc-type evaporation source 3 is fixed to a side wall of the vacuum container 1.

The negative electrode member 4 is attached to a surface of the arc-type evaporation source 3 on the side of a substrate 20. The negative electrode member 4 includes a vitreous carbon. The vitreous carbon is produced by calcining and carbonizing a thermosetting resin such as a phenol resin. The vitreous carbon has a structure where carbon atoms are arranged in an amorphous state and no particle boundary exists. Since there is no particle boundary, the negative electrode member 4 may include a conductive diamond. Besides, the negative electrode member 4 has a protrusion that protrudes toward the side of the substrate 20.

Specific examples of the vitreous carbon are the vitreous carbon produced by Nisshinbo Chemical Inc. or the glassy carbon produced by Tokai Carbon Co., Ltd. According to the embodiment of the invention, the vitreous carbon includes glassy carbon, amorphous carbon, non-shaped carbon, unshaped carbon, and non-graphite carbon.

The shutter 5 is disposed between the negative electrode member 4 and the substrate 20 to face the negative electrode member 4.

The power source 6 is connected between the holding member 2 and the ground node GND. The power source 7 is connected between the arc-type evaporation source 3 and the ground node GND.

A portion of the trigger electrode 8 passes through the side wall of the vacuum container 1 to be disposed in the vacuum container 1 while the rest of the trigger electrode 8 is outside the vacuum container 1. The trigger electrode 8 includes molybdenum (Mo), for example, and is connected to the ground node GND through the resistor 9. The resistor 9 is connected between the trigger electrode 8 and the ground node GND.

The holding member 2 holds the substrate 20. The arc-type evaporation source 3 partially heats the negative electrode member 4 by an arc discharge between the negative electrode member 4 and the vacuum container 1 so as to evaporate the negative electrode material.

The shutter 5 is moved in the direction of the arrow 12 by an opening and closing mechanism (not shown).

The power source 6 applies a negative voltage to the substrate 20 through the holding member 2. The power source 7 applies a negative voltage to the arc-type evaporation source 3.

The trigger electrode 8 is brought into contact with or separated from the negative electrode member 4 by a reciprocating drive device (not shown). The resistor 9 suppresses an arc current from flowing to the trigger electrode 8.

FIG. 2 is a perspective diagram of the negative electrode member 4 shown in FIG. 1. FIG. 3 is a cross-sectional diagram of the negative electrode member 4 along the line III-III of FIG. 2.

With reference to FIG. 2 and FIG. 3, the negative electrode member 4 includes a main body 41 and a protrusion 42. The main body 41 has a disc shape. The protrusion 42 has a columnar shape. The protrusion 42 is disposed on the main body 41 with a central axis X2 of the protrusion 42 coinciding with a central axis X1 of the main body 41. The main body 41 and the protrusion 42 are manufactured integrally.

The main body 41 has a diameter R1 of 64 mmϕ and a height H1 of 12 mm, for example. The protrusion 42 has a diameter R2 of several cmϕ or less and a height H2 of several mm or more. The diameter R2 of the protrusion 42 is 3 mmϕ or 6 mmϕ, for example.

The negative electrode member 4 is manufactured by the following method. A thermosetting resin such as a phenol resin is calcined and carbonized to manufacture a columnar vitreous carbon. Then, the obtained vitreous carbon is lathed to form the protrusion 42, so as to obtain the negative electrode member 4. The method of forming the protrusion 42 is not limited to lathing and may also include etching (including both wet etching and dry etching). Any method may be used as long as the protrusion 42 can be formed.

When the diameter R2 of the protrusion 42 is 6 mmϕ, the cross-sectional area of the protrusion 42 in the direction perpendicular to the central axis X2 is π × 3 mm × 3 mm = 28.3 mm², and the cross-sectional area of the main body 41 in the direction perpendicular to the central axis X1 is π × 32 mm × 32 mm = 3215.4 mm². As a result, the ratio of the cross-sectional area of the protrusion 42 to the cross-sectional area of the main body 41 is about 1/113.

Consequently, by reducing heat transfer components in the protrusion 42, heat is not easily lost from the protrusion 42 and it becomes easy to heat the entire protrusion 42 uniformly. Thus, heat distortion is reduced.

Since the vitreous carbon does not have a particle boundary, when the vitreous carbon is used as the negative electrode member 4, atomic carbon is released from the negative electrode member 4 during the arc discharge.

Therefore, cracking of the negative electrode member 4 may be suppressed.

As described above, because the atomic carbon is released from the negative electrode member 4, particles are not generated. As a result, with use of the negative electrode member 4, a sparkless discharge may be generated. The sparkless discharge is a discharge that does not generate particles. In this specification, the particles refer to carbon particles having the sizes of 50 nm to several m.

On the other hand, a sintered body obtained by sintering particles of carbon is not suitable as the negative electrode member 4. The reason is explained below. The sintered body of carbon is formed by compacting and sintering particles of carbon, and thus has a particle boundary. Hence, if the sintered body of carbon is used as the negative electrode member 4, the negative electrode member 4 would crack from the particle boundary during the arc discharge and cause particles to be released from the negative electrode member 4.

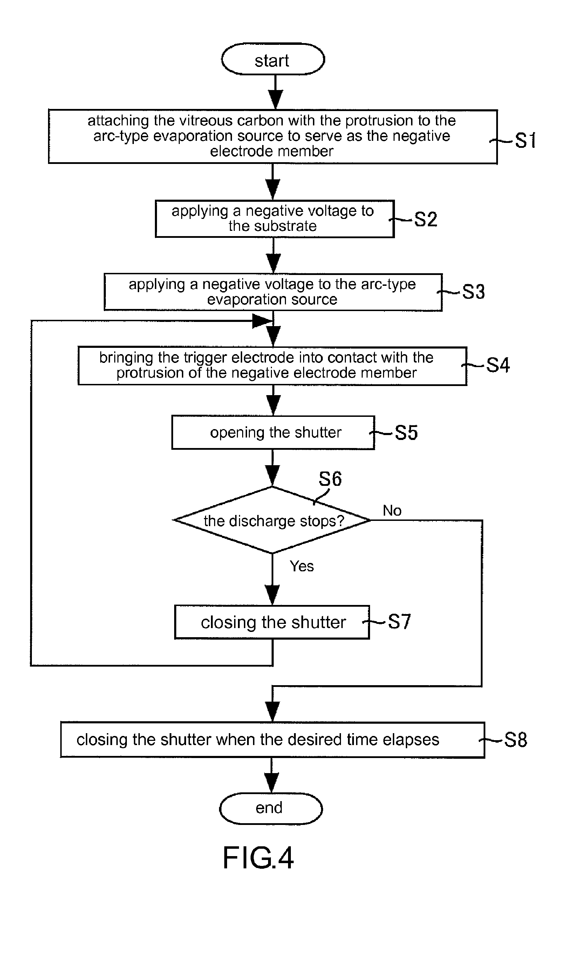

FIG. 4 is a flow chart showing a carbon thin film manufacturing method using the plasma device 10 shown in FIG. 1. With reference to FIG. 4, when the production of a carbon thin film starts, the vitreous carbon with the protrusion 42 is attached to the arc-type evaporation source 3 to serve as the negative electrode member 4 (Step S1).

Next, the vacuum container 1 is exhausted through the exhaust port 11 and the pressure in the vacuum container 1 is set to 5 × 10⁻⁴Pa.

Then, a negative voltage of -10V to -300V is applied to the substrate 20 by the power source 6 (Step S2), and a negative voltage of -15V to -50V is applied to the arc-type evaporation source 3 by the power source 7 (Step S3).

The trigger electrode 8 is brought into contact with the protrusion 42 of the negative electrode member 4 (Step S4) and then separated from the negative electrode member 4 by the reciprocating drive device (not shown). Thereby, the arc discharge starts and an arc spot appears on the surface of the negative electrode member 4. The arc spot is a molten portion of the negative electrode member 4 and emits strong light.

Thereafter, the shutter 5 is opened (Step S5). Thereby, a carbon thin film (DLC: Dimond Like Carbon) is formed on the substrate 20. Next, the operator of the plasma device 10 determines whether the discharge has stopped (Step S6). Since the arc spot emits strong light, the operator of the plasma device 10 determines that the discharge does not stop if the arc spot continues emitting light and determines that the discharge has stopped if the arc spot stops emitting light.

In Step S6, if it is determined that the discharge has stopped, the shutter 5 is closed (Step S7) and then the aforementioned Step S4 to Step S6 are repeated.

On the other hand, in Step S6, if it is determined that the discharge does not stop, the shutter 5 is closed when a desired time elapses (Step S8). Thereby, the production of the carbon thin film is completed.

The carbon thin film manufactured by the aforementioned Step S1 to Step S8 includes an amorphous carbon thin film, a diamond-like carbon thin film, a tetrahedral amorphous carbon film, an amorphous hard carbon thin film, and a hard carbon thin film.

In the first embodiment, the power source 6 may apply a voltage of 0V to the substrate 20. In addition, the carbon thin film may be manufactured with the shutter 5 opened. Therefore, the carbon thin film manufacturing method according to the first embodiment may at least include Steps S1, S3, and S4 as shown in FIG. 4.

In this way, the carbon thin film is formed on the substrate 20 by arc discharge using the negative electrode member 4 having the protrusion 42 and including the vitreous carbon.

Consequently, heat distortion of the protrusion 42 is reduced. Since the negative electrode member 4 (the vitreous carbon) has no particle boundary, cracking of the negative electrode member 4 along the particle boundary may be suppressed.

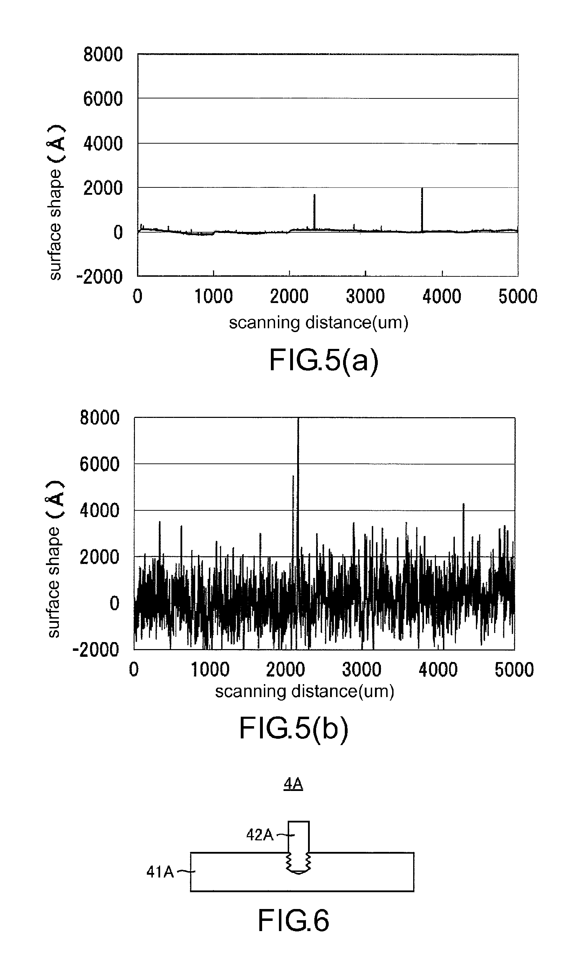

FIG. 5(a) and FIG. 5(b) are diagrams showing the results of measuring the surface shape of the carbon thin film under the same condition with use of the stylus type surface shape measuring instrument Dektak150 (produced by Veeco Instruments Inc.). In FIG. 5(a) and FIG. 5(b), the vertical axis indicates the surface shape of the carbon thin film and the horizontal axis indicates the scanning distance (the length measured). In both FIG. 5(a) and FIG. 5(b), after the vacuum container 1 was exhausted by the exhaust device (not shown) until 9.9 × 10⁻³Pa is reached, the arc current and the film thickness were set to 80A and 2000Å to respectively form carbon thin films on the substrate (having a diameter of 20 mm, a thickness of 2 mm, SKH51 made, mirror-polished finish). The only difference therebetween is the negative electrode member during film formation, wherein FIG. 5(a) illustrates a situation of using the vitreous carbon as the negative electrode member 4 and FIG. 5(b) illustrates a situation of using a carbon material with a sintered structure as the negative electrode member 4.

In both FIG. 5(a) and FIG. 5(b), the peaks protruding like needles in the plus direction from the level of 0Å represent the coarse particles in the carbon thin film (the coarse particles = due to the presence of the particles, the surface shape becomes convex), and it is apparent that the difference in the number of the coarse particles in the carbon thin film results from the difference of the negative electrode member. As described above, this difference derives from the structures of the vitreous carbon and the carbon material having the sintered structure. It plainly indicates that extremely few or almost no coarse particles are released from the vitreous carbon that has no particle boundary.

In an example, when the number of coarse particles of 3000Å or more is compared, 0 is found in FIG. 5(a) where the vitreous carbon was used as the negative electrode member 4. In contrast thereto, 21 are found in FIG. 5(b) where the carbon material with the sintered structure was used as the negative electrode member 4. When the number of coarse particles of 2000Å or more is compared, 1 is found in FIG. 5(a) where the vitreous carbon was used as the negative electrode member 4. In contrast thereto, 58 are found in FIG. 5(b) where the carbon material with the sintered structure was used as the negative electrode member 4. When the number of coarse particles of 1000Å or more is compared, 2 are found in FIG. 5(a) where the vitreous carbon was used as the negative electrode member 4. In contrast thereto, the number found in FIG. 5(b) where the carbon material with the sintered structure was used as the negative electrode member 4 is countless. According to the results, the number of coarse particles in the carbon thin film may be significantly reduced when the vitreous carbon was used as the negative electrode member 4. Meanwhile, it is possible to significantly reduce (improve) the surface roughness of the carbon thin film when the vitreous carbon was used as the negative electrode member 4.

In FIG. 5(a) and FIG. 5(b), the substrate surface corresponds to the level of 2000Å and the surface of the carbon thin film corresponds to the level of 0Å (due to influence of waviness or warp of the substrate, it is not a straight line at the level of 0Å in the vertical axis). The waviness or warp of the substrate is completely different from the peaks that protrude like needles due to the coarse particles and is unlikely to be misidentified as the presence or number of the coarse particles.

Moreover, in FIG. 5(b), there are numerous peaks that protrude like needles in the minus direction from the level of 0Å in the vertical axis. These indicate traces that are formed once the captured coarse particles are detached from the carbon thin film (the surface of the carbon thin film becomes concave when the coarse particles are detached). From this point, it is also determined that numerous coarse particles are released in the case of using the carbon material with the sintered structure as the negative electrode member 4.

Thus, it is demonstrated that, with use of the vitreous carbon as the negative electrode member 4, the surface roughness of the carbon thin film is reduced remarkably. The reason is that, when the vitreous carbon is used as the negative electrode member 4, atomic carbon is released from the negative electrode member 4, as described above, and the released atomic carbon contributes to the formation of the carbon thin film.

FIG. 6 is a cross-sectional diagram of another negative electrode member according to the first embodiment. In the first embodiment, the plasma device 10 may be provided with a negative electrode member 4A, as shown in FIG. 6, in place of the negative electrode member 4.

With reference to FIG. 6, the negative electrode member 4A includes a main body 41A and a protrusion 42A. The main body 41A is made by forming a M5 female thread in the main body 41 shown in FIG. 2 and FIG. 3. The main body 41A has the same size as the main body 41 and is made of the same material as the main body 41.

The protrusion 42A has a structure formed with a M5 male thread on the base side to mesh with the M5 female thread in the main body 41A. The protrusion 42A has the same diameter and shape as the protrusion 42, and the height of a portion of the protrusion 42A that protrudes from the main body 41A is 9 mm, for example. Moreover, the protrusion 42A is made of the same material as the main body 41A.

By using the negative electrode member 4A, it is possible to replace only the protrusion 42A and use the main body 41A repeatedly.

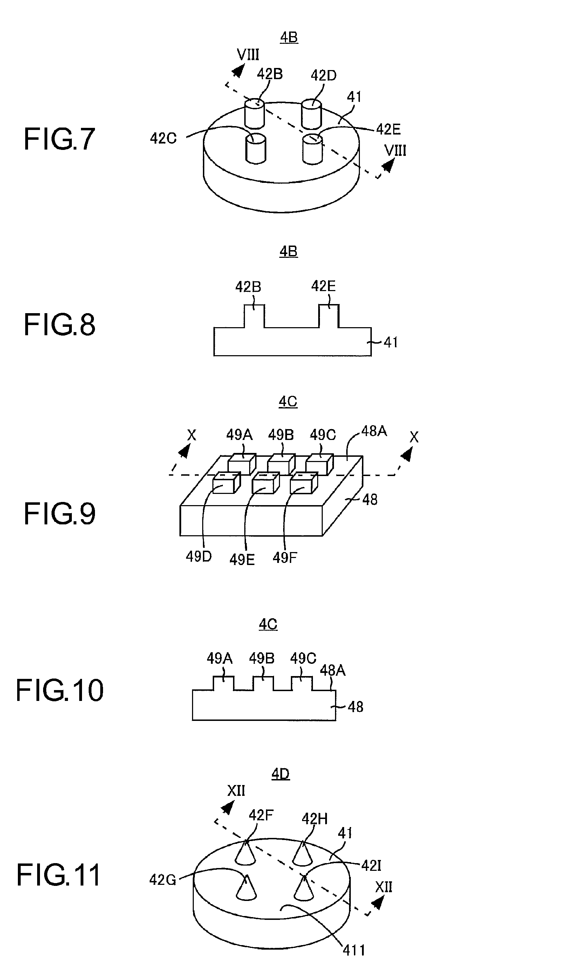

FIG. 7 is a schematic diagram of yet another negative electrode member according to the first embodiment. FIG. 8 is a cross-sectional diagram of a negative electrode member 4B along the line VIII-VIII of FIG. 7.

In the first embodiment, the plasma device 10 may be provided with the negative electrode member 4B, as shown in FIG. 7 and FIG. 8, in place of the negative electrode member 4.

With reference to FIG. 7 and FIG. 8, the negative electrode member 4B is the same as the negative electrode member 4 except that the protrusion 42 of the negative electrode member 4 of FIG. 2 is replaced by protrusions 42B, 42C, 42D, and 42E.

Each of the protrusions 42B, 42C, 42D, and 42E has a columnar shape and includes the vitreous carbon. Each of the protrusions 42B, 42C, 42D, and 42E has the same diameter and shape as the protrusion 42. Each of the protrusions 42B, 42C, 42D, and 42E has a height of 9 mm, for example. In addition, the protrusions 42B, 42C, 42D, and 42E are disposed on the main body 41 in a grid pattern, for example. In this case, the protrusions 42B, 42C, 42D, and 42E are disposed at a random interval. Furthermore, the main body 41 and the protrusions 42B, 42C, 42D, and 42E are manufactured integrally. The negative electrode member 4 is attached to the arc-type evaporation source 3 by fixing the main body 41 to the arc-type evaporation source 3. Accordingly, the protrusions 42B, 42C, 42D, and 42E protrude toward the side of the substrate 20.

The negative electrode member 4 is manufactured by lathing or etching the vitreous carbon.

However, the arrangement of the protrusions 42B, 42C, 42D, and 42E of the negative electrode member 4B is not limited to a grid pattern, and the protrusions 42B, 42C, 42D, and 42E may be disposed randomly at any interval.

Moreover, the number of the protrusions of the negative electrode member 4B is not limited to 4 (i.e. the protrusions 42B, 42C, 42D, and 42E). The negative electrode member 4B may include 2, 3, 5, or more protrusions. Generally, the negative electrode member 4B may include two protrusions or more. The two or more protrusions may be disposed in a grid pattern or disposed randomly at any interval. Further, the two or more protrusions may have the same or different diameters.

FIG. 9 is a schematic diagram of yet another negative electrode member according to the first embodiment. In addition, FIG. 10 is a cross-sectional diagram of a negative electrode member 4C along the line X-X of FIG. 9.

In the first embodiment, the plasma device 10 may be provided with the negative electrode member 4C, as shown in FIG. 9 and FIG. 10, in place of the negative electrode member 4.

With reference to FIG. 9 and FIG. 10, the negative electrode member 4C includes a main body 48 and protrusions 49A, 49B, 49C, 49D, 49E, and 49F.

The main body 48 has a plate shape with a square surface 48A and includes the vitreous carbon. The length of a side of the main body 48 is 64 mm, for example. Besides, the main body 48 has the same height H1 (= 10 mm) as the main body 41.

Each of the protrusions 49A, 49B, 49C, 49D, 49E, and 49F has a prismatic shape, a cross-sectional shape of which cut by a plane parallel to the surface 48A is square. Each of the protrusions 49A, 49B, 49C, 49D, 49E, and 49F includes the vitreous carbon. A side of each of the protrusions 49A, 49B, 49C, 49D, 49E, and 49F has a length of several cm or less. Each of the protrusions 49A, 49B, 49C, 49D, 49E, and 49F has a height of several mm or more. In addition, the protrusions 49A, 49B, 49C, 49D, 49E, and 49F are disposed on the main body 48 in a grid pattern, for example. In this case, the protrusions 49A, 49B, 49C, 49D, 49E, and 49F are disposed at a random interval. Furthermore, the main body 48 and the protrusions 49A, 49B, 49C, 49D, 49E, and 49F are manufactured integrally. The negative electrode member 4C is attached to the arc-type evaporation source 3 by fixing the main body 48 to the arc-type evaporation source 3. Accordingly, the protrusions 49A, 49B, 49C, 49D, 49E, and 49F protrude toward the side of the substrate 20.

The negative electrode member 4C is manufactured by the same method as the negative electrode member 4.

The arrangement of the protrusions 49A, 49B, 49C, 49D, 49E, and 49F of the negative electrode member 4C is not limited to a grid pattern, and the protrusions 49A, 49B, 49C, 49D, 49E, and 49F may be disposed randomly at any interval.

Moreover, the number of the protrusions of the negative electrode member 4C is not limited to 6 (i.e. the protrusions 49A, 49B, 49C, 49D, 49E, and 49F). The negative electrode member 4C may include 1 to 5, 7 or more protrusions. Generally, the negative electrode member 4C may include one protrusion or more. In the case where the negative electrode member 4C includes two or more protrusions, the two or more protrusions may be disposed in a grid pattern or disposed randomly at any interval. Further, the two or more protrusions may have the same or different lengths on one side.

In addition, the cross-sectional shape of the main body 48 may be square or rectangular. In this case, the lengths of the long side and the short side of the rectangle are random values.

In addition, the cross-sectional shape of each of the protrusions 49A, 49B, 49C, 49D, 49E, and 49F may be square or rectangular. In this case, the lengths of the long side and the short side of the rectangle are set to several cm or less.

Furthermore, the main body of the negative electrode member 4C is not limited to a plate shape having a rectangular cross-sectional shape. The main body may have a plate shape with a triangular cross-sectional shape or a pentagonal cross-sectional shape. Generally, the main body may have a plate shape that has a polygonal cross-sectional shape.

Besides, the protrusion of the negative electrode member 4C is not limited to a prismatic shape having a rectangular cross-sectional shape. The protrusion may have a prismatic shape with a triangular cross-sectional shape or a pentagonal cross-sectional shape. Generally, the protrusion may have a prismatic shape that has a polygonal cross-sectional shape.

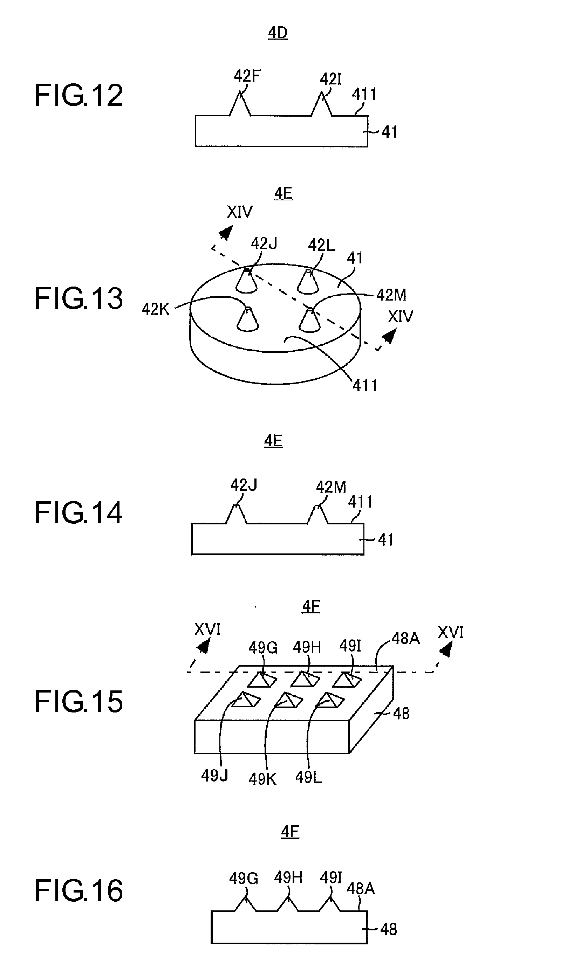

FIG. 11 is a schematic diagram of yet another negative electrode member according to the first embodiment. FIG. 12 is a cross-sectional diagram of a negative electrode member 4D along the line XII-XII of FIG. 11.

In the first embodiment, the plasma device 10 may be provided with the negative electrode member 4D, as shown in FIG. 11 and FIG. 12, in place of the negative electrode member 4.

With reference to FIG. 11 and FIG. 12, the negative electrode member 4D is the same as the negative electrode member 4 except that the protrusion 42 of the negative electrode member 4 of FIG. 2 is replaced by protrusions 42F, 42G, 42H, and 42I.

Each of the protrusions 42F, 42G, 42H, and 421 has a conical shape and includes the vitreous carbon. Each of the protrusions 42F, 42G, 42H, and 421 has a diameter of several cmϕ or less on a surface 411 of the main body 41. Each of the protrusions 42F, 42G, 42H, and 421 has a height of 9 mm, for example. In addition, the protrusions 42F, 42G, 42H, and 421 are disposed on the main body 41 in a grid pattern, for example. In this case, the protrusions 42F, 42G, 42H, and 421 are disposed at a random interval. Furthermore, the main body 41 and the protrusions 42F, 42G, 42H, and 421 are manufactured integrally. The negative electrode member 4D is attached to the arc-type evaporation source 3 by fixing the main body 41 to the arc-type evaporation source 3. Accordingly, the protrusions 42F, 42G, 42H, and 421 protrude toward the side of the substrate 20.

The negative electrode member 4D is manufactured by lathing or etching the vitreous carbon.

The arrangement of the protrusions 42F, 42G, 42H, and 421 of the negative electrode member 4D is not limited to a grid pattern, and the protrusions 42F, 42G, 42H, and 421 may be disposed randomly at any interval.

Moreover, the number of the protrusions of the negative electrode member 4D is not limited to 4 (i.e. the protrusions 42F, 42G, 42H, and 421). The negative electrode member 4D may include 2, 3, 5, or more protrusions. Generally, the negative electrode member 4D may include two protrusions or more. The two or more protrusions may be disposed in a grid pattern or disposed randomly at any interval. Further, the two or more protrusions may have the same or different diameters on the surface 411 of the main body 41.

FIG. 13 is a schematic diagram of yet another negative electrode member according to the first embodiment. In addition, FIG. 14 is a cross-sectional diagram of a negative electrode member 4E along the line XIV-XIV of FIG. 13.

In the first embodiment, the plasma device 10 may be provided with the negative electrode member 4E, as shown in FIG. 13 and FIG. 14, in place of the negative electrode member 4.

With reference to FIG. 13 and FIG. 14, the negative electrode member 4E is the same as the negative electrode member 4 except that the protrusion 42 of the negative electrode member 4 of FIG. 2 is replaced by protrusions 42J, 42K, 42L, and 42M.

Each of the protrusions 42J, 42K, 42L, and 42M has a truncated conical shape and includes the vitreous carbon. Each of the protrusions 42J, 42K, 42L, and 42M has a diameter of several cmϕ or less on the surface 411 of the main body 41 and has a diameter on the tip portion, which is smaller than the diameter on the surface 411. Each of the protrusions 42J, 42K, 42L, and 42M has a height of 9 mm, for example. In addition, the protrusions 42J, 42K, 42L, and 42M are disposed on the main body 41 in a grid pattern, for example. In this case, the protrusions 42J, 42K, 42L, and 42M are disposed at a random interval. Furthermore, the main body 41 and the protrusions 42J, 42K, 42L, and 42M are manufactured integrally. The negative electrode member 4E is attached to the arc-type evaporation source 3 by fixing the main body 41 to the arc-type evaporation source 3. Accordingly, the protrusions 42J, 42K, 42L, and 42M protrude toward the side of the substrate 20.

The negative electrode member 4E is manufactured by lathing or etching the vitreous carbon.

The arrangement of the protrusions 42J, 42K, 42L, and 42M of the negative electrode member 4E is not limited to a grid pattern, and the protrusions 42J, 42K, 42L, and 42M may be disposed randomly at any interval.

Moreover, the number of the protrusions of the negative electrode member 4E is not limited to 4 (i.e. the protrusions 42J, 42K, 42L, and 42M). The negative electrode member 4E may include 2, 3, 5, or more protrusions. Generally, the negative electrode member 4E may include two protrusions or more. The two or more protrusions may be disposed in a grid pattern or disposed randomly at any interval. Further, the two or more protrusions may have the same or different diameters on the surface 411 of the main body 41.

FIG. 15 is a schematic diagram of yet another negative electrode member according to the first embodiment. FIG. 16 is a cross-sectional diagram of a negative electrode member 4F along the line XVI-XVI of FIG. 15.

In the first embodiment, the plasma device 10 may be provided with the negative electrode member 4F, as shown in FIG. 15 and FIG. 16, in place of the negative electrode member 4.

With reference to FIG. 15 and FIG. 16, the negative electrode member 4F is the same as the negative electrode member 4C except that the protrusions 49A, 49B, 49C, 49D, 49E, and 49F of the negative electrode member 4C of FIG. 9 and FIG. 10 are replaced by protrusions 49G, 49H, 491, 49J, 49K, and 49L.

Each of the protrusions 49G, 49H, 491, 49J, 49K, and 49L has a pyramidal shape and includes the vitreous carbon. Each of the protrusions 49G, 49H, 491, 49J, 49K, and 49L has a square shape on the surface 48A of the main body 48, a side of which has a length of several cm or less. Each of the protrusions 49G, 49H, 491, 49J, 49K, and 49L has a height of 9 mm, for example. In addition, the protrusions 49G, 49H, 491, 49J, 49K, and 49L are disposed on the main body 48 in a grid pattern, for example. In this case, the protrusions 49G, 49H, 491, 49J, 49K, and 49L are disposed at a random interval. Furthermore, the main body 48 and the protrusions 49G, 49H, 491, 49J, 49K, and 49L are manufactured integrally. The negative electrode member 4E is attached to the arc-type evaporation source 3 by fixing the main body 48 to the arc-type evaporation source 3. Accordingly, the protrusions 49G, 49H, 491, 49J, 49K, and 49L protrude toward the side of the substrate 20.

The negative electrode member 4F is manufactured by lathing or etching the vitreous carbon.

The arrangement of the protrusions 49G, 49H, 491, 49J, 49K, and 49L of the negative electrode member 4F is not limited to a grid pattern, and the protrusions 49G, 49H, 491, 49J, 49K, and 49L may be disposed randomly at any interval.

Moreover, the number of the protrusions of the negative electrode member 4F is not limited to 6 (i.e. the protrusions 49G, 49H, 491, 49J, 49K, and 49L). The negative electrode member 4F may include 2, 3, 5, or more protrusions. Generally, the negative electrode member 4F may include two protrusions or more. The two or more protrusions may be disposed in a grid pattern or disposed randomly at any interval. Further, the two or more protrusions may have the same or different lengths on one side on the surface 48A of the main body 48.

The shape of each of the protrusions 49G, 49H, 491, 49J, 49K, and 49L on the surface 48A of the main body 48 is not limited to a square shape, and each of the protrusions 49G, 49H, 491, 49J, 49K, and 49L may have a rectangular shape on the surface 48A of the main body 48. In this case, the lengths of the long side and the short side of the rectangle are several cm or less.

Moreover, each of the protrusions 49G, 49H, 491, 49J, 49K, and 49L may have a triangular shape, a pentagonal shape, or a hexagonal shape on the surface 48A of the main body 48. Generally, each of the protrusions 49G, 49H, 491, 49J, 49K, and 49L may have a polygonal shape. In this case, the length of the longest diagonal of the polygon is several cm or less.

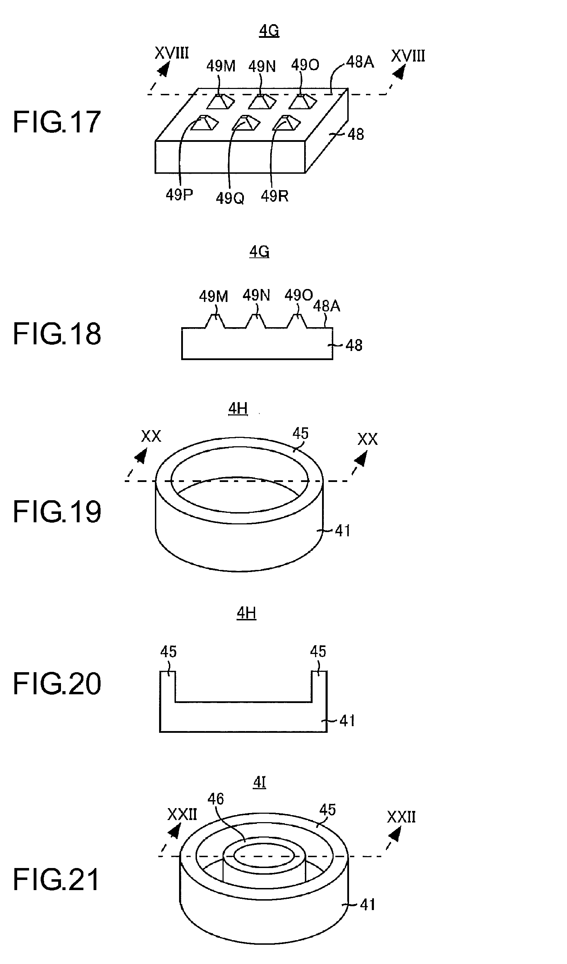

FIG. 17 is a schematic diagram of yet another negative electrode member according to the first embodiment. In addition, FIG. 18 is a cross-sectional diagram of a negative electrode member 4G along the line XVIII-XVIII of FIG. 17.

In the first embodiment, the plasma device 10 may be provided with the negative electrode member 4G, as shown in FIG. 17 and FIG. 18, in place of the negative electrode member 4.

With reference to FIG. 17 and FIG. 18, the negative electrode member 4G is the same as the negative electrode member 4C except that the protrusions 49A, 49B, 49C, 49D, 49E, and 49F of the negative electrode member 4C of FIG. 9 are replaced by protrusions 49M, 49N, 490, 49P, 49Q, and 49R.

Each of the protrusions 49M, 49N, 490, 49P, 49Q, and 49R has a truncated pyramidal shape and includes the vitreous carbon. Each of the protrusions 49M, 49N, 490, 49P, 49Q, and 49R has a square shape with a side being several cm or less on the surface 48A of the main body 48 and has a square shape on the tip portion, a side of which is shorter than the side on the surface 48A. Each of the protrusions 49M, 49N, 490, 49P, 49Q, and 49R has a height of 9 mm, for example. In addition, the protrusions 49M, 49N, 490, 49P, 49Q, and 49R are disposed on the main body 48 in a grid pattern, for example. In this case, the protrusions 49M, 49N, 490, 49P, 49Q, and 49R are disposed at a random interval. Furthermore, the main body 48 and the protrusions 49M, 49N, 490, 49P, 49Q, and 49R are manufactured integrally. The negative electrode member 4G is attached to the arc-type evaporation source 3 by fixing the main body 48 to the arc-type evaporation source 3. Accordingly, the protrusions 49M, 49N, 490, 49P, 49Q, and 49R protrude toward the side of the substrate 20.

The negative electrode member 4G is manufactured by lathing or etching the vitreous carbon.

The arrangement of the protrusions 49M, 49N, 490, 49P, 49Q, and 49R of the negative electrode member 4G is not limited to a grid pattern, and the protrusions 49M, 49N, 490, 49P, 49Q, and 49R may be disposed randomly at any interval.

Moreover, the number of the protrusions of the negative electrode member 4G is not limited to 6 (i.e. the protrusions 49M, 49N, 490, 49P, 49Q, and 49R). The negative electrode member 4G may include 2, 3, 5, or more protrusions. Generally, the negative electrode member 4G may include two protrusions or more. The two or more protrusions may be disposed in a grid pattern or disposed randomly at any interval. Further, the two or more protrusions may have the same or different lengths on one side on the surface 48A of the main body 48.

The shapes of each of the protrusions 49M, 49N, 490, 49P, 49Q, and 49R on the tip portion and the surface 48A of the main body 48 are not limited to a square shape, and each of the protrusions 49M, 49N, 490, 49P, 49Q, and 49R may have a rectangular shape on the tip portion and the surface 48A of the main body 48. In this case, the lengths of the long side and the short side of the rectangle are several cm or less.

Moreover, each of the protrusions 49M, 49N, 490, 49P, 49Q, and 49R may have a triangular shape, a pentagonal shape, or a hexagonal shape on the tip portion and the surface 48A of the main body 48. Generally, the protrusions 49M, 49N, 490, 49P, 49Q, and 49R may have a polygonal shape. In this case, the length of the longest diagonal of the polygon on the surface 48A is several cm or less.

FIG. 19 is a schematic diagram of yet another negative electrode member according to the first embodiment. FIG. 20 is a cross-sectional diagram of a negative electrode member 4H along the line XX-XX of FIG. 19.

In the first embodiment, the plasma device 10 may be provided with the negative electrode member 4H, as shown in FIG. 19 and FIG. 20, in place of the negative electrode member 4.

With reference to FIG. 19 and FIG. 20, the negative electrode member 4H is the same as the negative electrode member 4 except that the protrusion 42 of the negative electrode member 4 of FIG. 2 is replaced by a protrusion 45.

The protrusion 45 has a walled structure with a ring-shaped planar shape and includes the vitreous carbon. The protrusion 45 has an outer diameter equal to the diameter R1 of the main body 41 and a width of 1 mm to 10 mm, for example. The protrusion 45 has a height greater than the width, and the height is several mm to several cm, for example. Moreover, the main body 41 and the protrusion 45 are manufactured integrally. The negative electrode member 4H is attached to the arc-type evaporation source 3 by fixing the main body 41 to the arc-type evaporation source 3. Accordingly, the protrusion 45 protrudes toward the side of the substrate 20.

The negative electrode member 4H is manufactured by lathing or etching the vitreous carbon.

Nevertheless, the outer diameter of the protrusion 45 is not necessarily equal to the diameter R1 of the main body 41 and may be smaller than the diameter R1 of the main body 41.

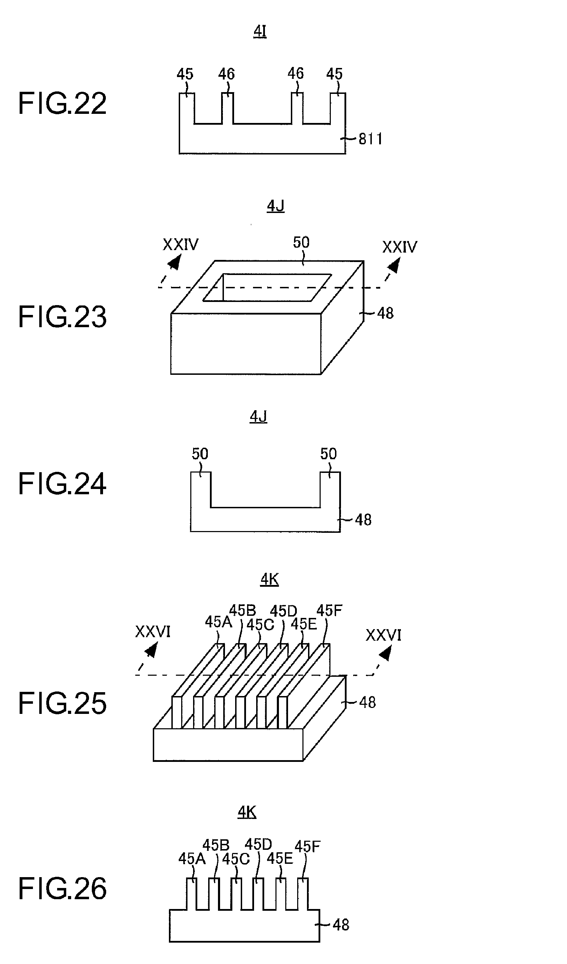

FIG. 21 is a schematic diagram of yet another negative electrode member according to the first embodiment. FIG. 22 is a cross-sectional diagram of a negative electrode member 41 along the line XXII-XXII of FIG. 21.

In the first embodiment, the plasma device 10 may be provided with the negative electrode member 41, as shown in FIG. 21 and FIG. 22, in place of the negative electrode member 4.

With reference to FIG. 21 and FIG. 22, the negative electrode member 41 is the same as the negative electrode member 4H except that a protrusion 46 is further added to the negative electrode member 4H shown in FIG. 19 and FIG. 20.

The protrusion 46 has a walled structure with a ring-shaped planar shape and includes the vitreous carbon. The protrusion 46 is disposed on the inner peripheral side of the protrusion 45 and has a width of 1 mm to 10 mm, for example. The protrusion 46 has a height greater than the width, and the height is several mm to several cm, for example. The protrusions 45 and 46 are disposed with a random interval therebetween. Moreover, the main body 41 and the protrusions 45 and 46 are manufactured integrally. The negative electrode member 41 is attached to the arc-type evaporation source 3 by fixing the main body 41 to the arc-type evaporation source 3. Accordingly, the protrusions 45 and 46 protrude toward the side of the substrate 20.

The negative electrode member 41 is manufactured by lathing or etching the vitreous carbon.

The protrusions 45 and 46 may have the same or different widths.

FIG. 23 is a schematic diagram of yet another negative electrode member according to the first embodiment. FIG. 24 is a cross-sectional diagram of a negative electrode member 4J along the line XXIV-XXIV of FIG. 23.

In the first embodiment, the plasma device 10 may be provided with the negative electrode member 4J, as shown in FIG. 23 and FIG. 24, in place of the negative electrode member 4.

With reference to FIG. 23 and FIG. 24, the negative electrode member 4J is the same as the negative electrode member 4F except that the protrusions 49G, 49H, 491, 49J, 49K, and 49L of the negative electrode member 4F of FIG. 15 and FIG. 16 are replaced by a protrusion 50.

The protrusion 50 has a walled structure with a rectangular ring-shaped planar shape and includes the vitreous carbon. The protrusion 50 is disposed on the main body 48 along the periphery of the main body 48. In addition, the protrusion 50 has a width of several mm to 1 cm, for example, and the height of the protrusion 50 is greater than the width and is several mm to several cm, for example. Moreover, the protrusion 50 and the main body 48 are manufactured integrally.

The negative electrode member 4J is manufactured by lathing or etching a vitreous carbon having a plate shape. The negative electrode member 4J is attached to the arc-type evaporation source 3 by fixing the main body 48 to the arc-type evaporation source 3. Accordingly, the protrusion 50 protrudes toward the side of the substrate 20.

FIG. 25 is a schematic diagram of yet another negative electrode member according to the first embodiment. FIG. 26 is a cross-sectional diagram of a negative electrode member 4K along the line XXVI-XXVI of FIG. 25.

In the first embodiment, the plasma device 10 may be provided with the negative electrode member 4K, as shown in FIG. 25 and FIG. 26, in place of the negative electrode member 4.

With reference to FIG. 25 and FIG. 26, the negative electrode member 4K is the same as the negative electrode member 4J except that the protrusion 50 of the negative electrode member 4J of FIG. 23 and FIG. 24 is replaced by protrusions 45A, 45B, 45C, 45D, 45E, and 45F.

Each of the protrusions 45A, 45B, 45C, 45D, 45E, and 45F has a walled structure with a linear planar shape and includes the vitreous carbon. Each of the protrusions 45A, 45B, 45C, 45D, 45E, and 45F has a thickness of several mm and a height of several mm to 1 cm, which is greater than the thickness, for example. In addition, the protrusions 45A, 45B, 45C, 45D, 45E, and 45F are disposed substantially in parallel to each other at a desired interval on the main body 48. Furthermore, the main body 48 and the protrusions 45A, 45B, 45C, 45D, 45E, and 45F are manufactured integrally.

The negative electrode member 4K is manufactured by lathing or etching the vitreous carbon having a plate shape to form the protrusions 45A, 45B, 45C, 45D, 45E, and 45F. The negative electrode member 4K is attached to the arc-type evaporation source 3 by fixing the main body 48 to the arc-type evaporation source 3. Accordingly, the protrusions 45A, 45B, 45C, 45D, 45E, and 45F protrude toward the side of the substrate 20.

The number of the protrusions of the negative electrode member 4K is not limited to 6 and may be 1 or more.

Moreover, the six protrusions 45A, 45B, 45C, 45D, 45E, and 45F of the negative electrode member 4K may not be disposed at equal intervals and may be disposed at a random interval.

In the case where the negative electrode member 4K includes a plurality of protrusions, the protrusions may not be disposed in parallel to each other.

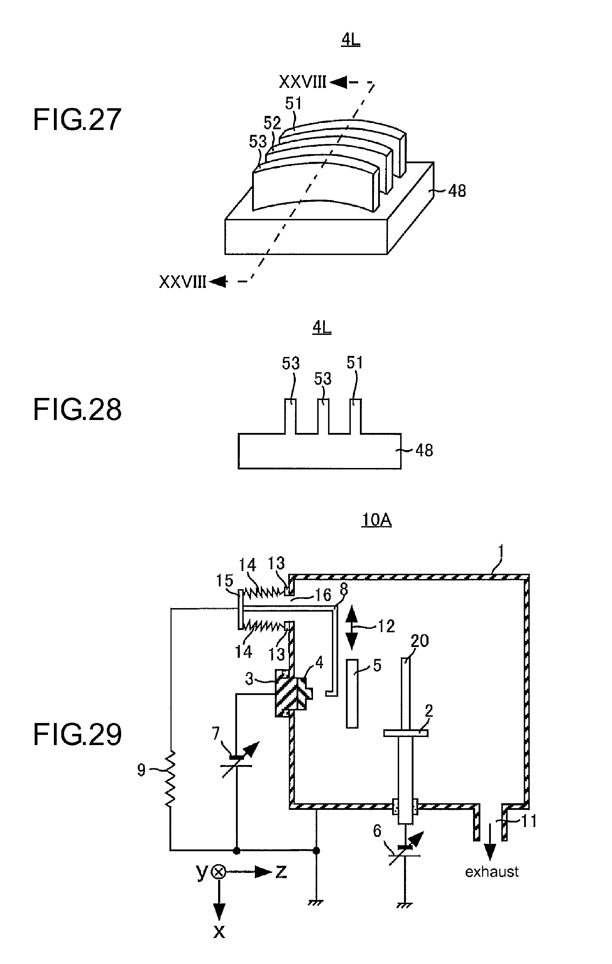

FIG. 27 is a conceptual diagram of yet another negative electrode member according to the first embodiment. In addition, FIG. 28 is a cross-sectional diagram of a negative electrode member 4L along the line XXVIII-XXVIII of FIG. 27.

In the first embodiment, the plasma device 10 may be provided with the negative electrode member 4L, as shown in FIG. 27 and FIG. 28, in place of the negative electrode member 4.

With reference to FIG. 27 and FIG. 28, the negative electrode member 4L is the same as the negative electrode member 4J except that the protrusion 50 of the negative electrode member 4J of FIG. 23 and FIG. 24 is replaced by protrusions 51 to 53.

Each of the protrusions 51 to 53 has a walled structure with an arc-shaped planar shape and includes the vitreous carbon. Each of the protrusions 51 to 53 has a thickness of several mm and a height of several mm to 1 cm, which is greater than the thickness, for example. In addition, the protrusions 51 to 53 are disposed on the main body 48 at a desired interval. Moreover, the main body 48 and the protrusions 51 to 53 are manufactured integrally.

The negative electrode member 4L is manufactured by lathing or etching the vitreous carbon having a plate shape to form the protrusions 51 to 53. The negative electrode member 4L is attached to the arc-type evaporation source 3 by fixing the main body 48 to the arc-type evaporation source 3. Accordingly, the protrusions 51 to 53 protrude toward the side of the substrate 20.

The number of the protrusions of the negative electrode member 4L is not limited to 3 and may be 1 or more.

Moreover, the three protrusions 51 to 53 of the negative electrode member 4L may not be disposed at equal intervals and may be disposed at a random interval.

Furthermore, regarding the negative electrode member used in the first embodiment, the modification for changing the negative electrode member 4 into the negative electrode member 4A may also be applied to the negative electrode members 4B, 4C, 4D, 4E, 4F, and 4G.

The above describes the various negative electrode members 4 and 4A to 4L. Each of the negative electrode members 4 and 4A to 4L has protrusion(s) that protrudes toward the side of the substrate 20. Accordingly, the negative electrode member of the first embodiment may have at least one protrusion that protrudes toward the side of the substrate 20.

In the case where the plasma device 10 is provided with one of the negative electrode members 4A to 4L, a carbon thin film is manufactured according to the flow chart shown in FIG. 4. In this case, in Step S1, one of the negative electrode members 4A to 4L is attached to the arc-type evaporation source 3.

FIG. 29 is a schematic diagram showing the structure of another plasma device according to the first embodiment. The plasma device of the first embodiment may also be a plasma device 10A as shown in FIG. 29.

With reference to FIG. 29, the plasma device 10A is the same as the plasma device 10 except that an insulating member 13, bellows 14, and a holding member 15 are further added to the plasma device 10 of FIG. 1.

The trigger electrode 8 is disposed through a through hole 16 that is formed in the side wall of the vacuum container 1, wherein one end of the trigger electrode 8 faces the negative electrode member 4 and the other end is fixed to the holding member 15.

The insulating member 13 is fixed to the side wall of the vacuum container 1 through an O-ring (not shown) to surround the through hole 16. The bellows 14 are disposed between the insulating member 13 and the holding member 15 and fixed to the insulating member 13 and the holding member 15. The holding member 15 is fixed to the other end of the trigger electrode 8 and includes Mo, for example. Further, the holding member 15 is connected to a ground potential GND through the resistor 9.

The bellows 14 are extendable in the z axis direction, and a portion of the bellows 14 close to the holding member 15 is movable with the movement of the holding member 15 in the x-y plane.

The holding member 15, through operation of the operator of the plasma device 10A, is moved in the z axis direction and moved in the x-y plane.

A wire connecting the resistor 9 and the holding member 15 in fact has a spiral shape. Thus, the holding member 15 is stably connected to the resistor 9 by the wire even when the holding member 15 is moved in the z axis direction and the x-y plane.

By using the plasma device 10A, the trigger electrode 8 may be moved to any location of the protrusion 42 of the negative electrode member 4. Particularly, in the case of using the negative electrode members 4B to 4G that have multiple protrusions and the negative electrode members 4H to 4L that have the walled structures, the trigger electrode 8 may be moved to any location of the protrusion to thoroughly use the protrusions of the negative electrode members 4B to 4L.

In the case where the plasma device 10 or 10A includes one of the negative electrode members 4A to 4L in place of the negative electrode member 4, heat distortion of the protrusion may still be reduced, as in the case of the negative electrode member 4, by which cracking of the negative electrode members 4A to 4L may be suppressed.

The above illustrates that cracking of the negative electrode members 4 and 4A to 4L may be suppressed when the various negative electrode members 4 and 4A to 4L are used to form a carbon thin film by arc discharge. The reason is that the overall temperature of the protrusion (= the protrusion 42, etc.) increases and the heat distortion is eased. Accordingly, in the embodiment of the invention, the negative electrode member may have the structure for increasing the overall temperature of the negative electrode and easing the heat distortion.

### [Second Embodiment]

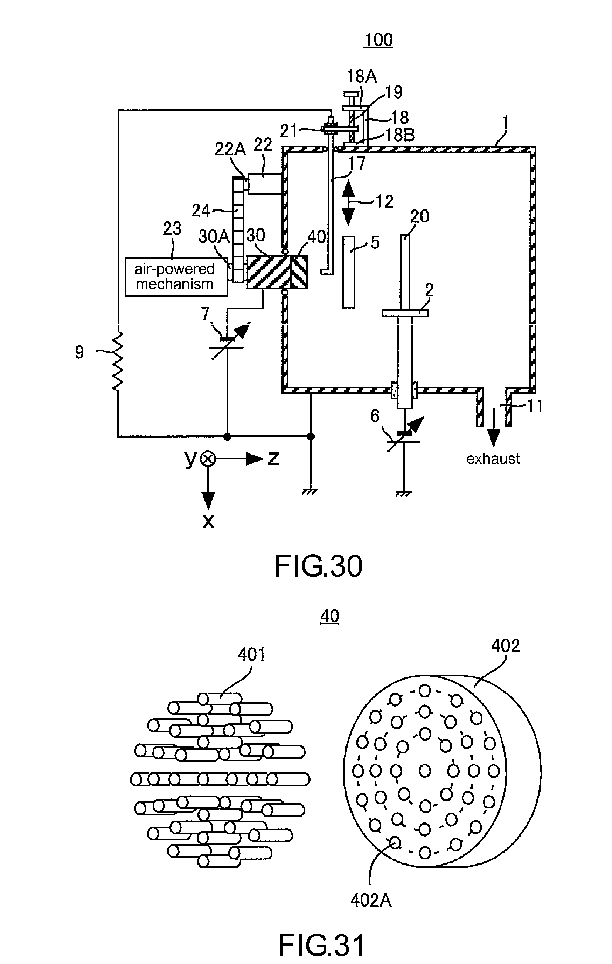

FIG. 30 is a schematic diagram showing the structure of the plasma device according to the second embodiment. With reference to FIG. 30, a plasma device 100 of the second embodiment is the same as the plasma device 10 except that the arc-type evaporation source 3 of the plasma device 10 of FIG. 1 is replaced by an arc-type evaporation source 30, the negative electrode member 4 is replaced by a negative electrode member 40, the trigger electrode 8 is replaced by a trigger electrode 17, and a holding member 18, a screw member 19, a supporting member 21, a motor 22, an air-powered (compressed gas-operated) mechanism 23, and a belt 24 are further added.

The arc-type evaporation source 30 has a columnar shape and is disposed through a through hole formed in the side wall of the vacuum container 1. In this case, an O-ring exists between the side wall of the vacuum container 1 and the arc-type evaporation source 30. Thereby, a vacuum is maintained in the vacuum container 1. Moreover, the arc-type evaporation source 30 has a gear 30A on the side of the air-powered mechanism 23. The arc-type evaporation source 30 is connected to the power source 7.

The negative electrode member 40 is attached to a surface of the arc-type evaporation source 30 inside the vacuum container 1.

One end of the trigger electrode 17 faces the negative electrode member 40 and the other end thereof is fixed to the supporting member 21. The trigger electrode 17 is connected to the ground potential GND through the resistor 9.

The holding member 18 is fixed to the vacuum container 1. The screw member 19 is disposed to pass through a through hole formed in a top member 18A of the holding member 18 and a through hole formed in a bottom member 18B. The screw member 19 is formed with a spiral screw groove and is rotated clockwise or counterclockwise in the y-z plane by the operator of the plasma device 100.

The supporting member 21 is connected with the other end of the trigger electrode 17 and meshes with the screw groove of the screw member 19. When the screw member 19 is rotated clockwise in the y-z plane, the supporting member 21 moves in the negative direction of the x axis; and when the screw member 19 is rotated counterclockwise in the y-z plane, the supporting member 21 moves in the positive direction of the x axis. Accordingly, the trigger electrode 17 moves along the x axis as the screw member 19 rotates in the y-z plane.

The motor 22 is fixed to the side wall of the vacuum container 1. The air-powered mechanism 23 is connected to the gear 30A of the arc-type evaporation source 30 and is supported by a supporting member (not shown). The air-powered mechanism 23 moves the arc-type evaporation source 30 and the negative electrode member 40 along the z axis by the method described below. The belt 24 is installed to a gear 22A of the motor 22 and the gear 30A of the arc-type evaporation source 30.

The gear 22A rotates as the motor 22 rotates, and the belt 24 transmits the rotation of the gear 22A to the gear 30A. Consequently, the arc-type evaporation source 30 and the negative electrode member 40 respectively rotate around the central axis of the arc-type evaporation source 30 and the central axis of the negative electrode member 40 in the x-y plane.

FIG. 31 is a schematic diagram showing the structure of the negative electrode member 40 of FIG. 30. With reference to FIG. 31, the negative electrode member 40 includes a vitreous carbon 401 and an insulating frame 402. The vitreous carbon 401 has a columnar shape and has a diameter of several cmϕ or less and a length of several mm or more. The diameter of the vitreous carbon 401 is 3 mmϕ or 6 mmϕ and the length of the vitreous carbon 401 is 10 mm, for example.

The insulating frame 402 has a disc shape and includes an insulating material having a high melting point (Al₂O₃, Si₃N₄, and hexagonal -BN, for example). The insulating frame 402 has a diameter of 64 mmϕ, for example, and has a thickness equal to the length of the vitreous carbon 401. The insulating frame 402 has through holes 402A, the number of which is equal to the number of the vitreous carbons 401. The through hole 402A has a diameter substantially equal to the diameter of the vitreous carbon 401. The through holes 402A are arranged concentrically.

The vitreous carbons 401 are inserted into the through holes 402A of the insulating frame 402. Since the through holes 402A are arranged concentrically, the vitreous carbons 401 are arranged concentrically as well when inserted into the through holes 402A.

The insulating frame 402 is attached to the arc-type evaporation source 30 with the vitreous carbons 401 inserted into the through holes 402A. Thus, one end of the vitreous carbon 401 is in contact with the arc-type evaporation source 30, and the vitreous carbon 401 is heated when a negative voltage is applied to the arc-type evaporation source 30 to start the discharge.

Because the vitreous carbon 401 has the columnar shape as described above, the vitreous carbon 401 may be regarded as the protrusion (the protrusion 42, etc.) described in the first embodiment. Accordingly, the negative electrode member 40 includes a plurality of protrusions (the vitreous carbons 401) and the insulating frame 402 disposed among the protrusions (the vitreous carbons 401).

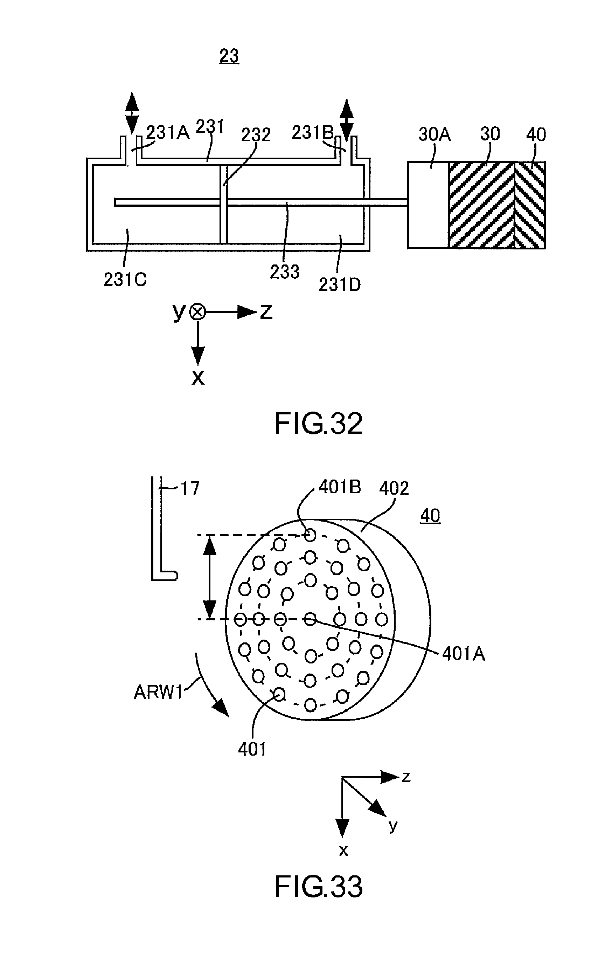

FIG. 32 is a schematic diagram showing the structure of the air-powered mechanism 23 of FIG. 30. With reference to FIG. 32, the air-powered mechanism 23 includes a cylinder 231, a valve 232, and a shaft 233.

The cylinder 231 has a hollow columnar shape and has two input/output ports 231A and 231B on a side wall. A gas (compressed air pressurized to about 0.5MPa, for example) is introduced into the cylinder 231 or the gas in the cylinder 231 is discharged to the outside through the input/output ports 231A and 231B respectively.

The valve 232 has a disc shape. The valve 232 is connected to the shaft 233 and is disposed in contact with the inner wall of the cylinder 231. The valve 232 is movable along the z axis and rotatable in the x-y plane. Since the valve 232 is disposed in contact with the inner wall of the cylinder 231, the cylinder 231 is partitioned into two spatial regions 231C and 231D by the valve 232.

The shaft 233 is fixed to the valve 232 in a manner to pass through the valve 232. One end of the shaft 233 passes through the cylinder 231 to be connected to the gear 30A.

When gases are pushed into and out of the spatial regions 231C and 231D of the cylinder 231 to make the pressure of the spatial region 231D smaller than the pressure of the spatial region 231C, the valve 232 is moved in the positive direction of the z axis and moves the gear 30A, the arc-type evaporation source 30, and the negative electrode member 40 in the positive direction of the z axis (in the direction toward the substrate 20).

In addition, when gases are pushed into and out of the spatial regions 231C and 231D of the cylinder 231 to make the pressure of the spatial region 231C smaller than the pressure of the spatial region 231D, the valve 232 is moved in the negative direction of the z axis and moves the gear 30A, the arc-type evaporation source 30, and the negative electrode member 40 in the negative direction of the z axis (in the direction away from the substrate 20).

In this way, the air-powered mechanism 23 moves the gear 30A, the arc-type evaporation source 30, and the negative electrode member 40 along the z axis by adjusting the pressures of the spatial regions 231C and 231D.

When the gear 30A is rotated in the x-y plane, the valve 232 is rotated in the x-y plane in conjunction with the rotation of the gear 30A. Therefore, the cylinder 231 does not rotate.

A wire that connects the arc-type evaporation source 30 with the power source 7 is not fixed to the arc-type evaporation source 30 but in contact with the arc-type evaporation source 30. Thus, a negative voltage may still be applied to the arc-type evaporation source 30 even when the arc-type evaporation source 30 rotates with the rotation of the gear 30A.

FIG. 33 is a diagram illustrating the mechanism for bringing the trigger electrode 17 of FIG. 30 respectively in contact with all the vitreous carbons 401 of the negative electrode member 40.

With reference to FIG. 33, the trigger electrode 17 is moved by the holding member 18, the screw member 19, and the supporting member 21 along the x axis between the vitreous carbon 401 (vitreous carbon 401A) disposed on the innermost peripheral side and the vitreous carbon 401 (vitreous carbon 401B, for example) disposed on the outermost peripheral side. In addition, the negative electrode member 40 is rotated by the motor 22 in the direction of the arrow ARW1, for example, and stops at any rotation angle.

Consequently, the trigger electrode 17 may be placed to respectively face all the vitreous carbons 401 of the negative electrode member 40.

In the plasma device 100, the trigger electrode 17 is moved in the x axis direction by the holding member 18, the screw member 19, and the supporting member 21, and the arc-type evaporation source 30 and the negative electrode member 40 are rotated by a desired angle by the motor 22, the gear 22A, the belt 24, and the gear 30A, such that the trigger electrode 17 faces one of the vitreous carbons 401. The arc-type evaporation source 30 and the negative electrode member 40 are moved in the z axis direction by the air-powered mechanism 23 to bring the trigger electrode 17 into contact with one of the vitreous carbons 401 of the negative electrode member 40, and then the discharge starts when the trigger electrode 40 moves away.

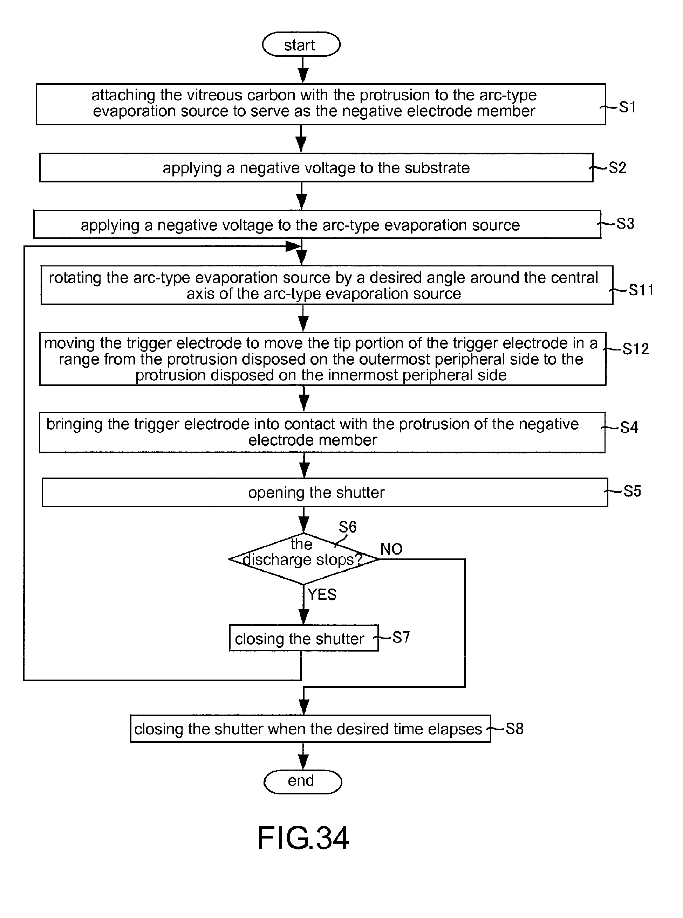

FIG. 34 is a flow chart showing a carbon thin film manufacturing method using the plasma device 100 shown in FIG. 30.

The flow chart of FIG. 34 is the same as the flow chart of FIG. 4 except that Step S11 and Step S 12 are further added between Step S3 and Step S4 in the flow chart of FIG. 4.

With reference to FIG. 34, when the production of a carbon thin film starts, the aforementioned Steps S1 to S3 are performed sequentially.

After Step S3, the arc-type evaporation source 30 is rotated by a desired angle around the central axis of the arc-type evaporation source 30 by the motor 22, the gear 22A, the belt 24, and the gear 30A (Step S11).

Then, the trigger electrode 17 is moved to move the tip portion of the trigger electrode 17 in a range from the vitreous carbon 401 (protrusion) disposed on the outermost peripheral side to the vitreous carbon 401 (protrusion) disposed on the innermost peripheral side (Step S12). Accordingly, the trigger electrode 17 faces one of the vitreous carbons 401 (protrusions).

Next, the aforementioned Steps S4 to S8 are performed sequentially. Thereby, the production of the carbon thin film is completed. In this case, in Step S4, the trigger electrode 17 is brought into contact with one of the vitreous carbons 401 of the negative electrode member 40 by the air-powered mechanism 23 and then separated. The discharge starts when the trigger electrode 17 is moved away from the one vitreous carbon 401.

In the flow chart of FIG. 34, when the discharge stops, Step S11 and Step S12 are repeated. Thus, the trigger electrode 17 may face another vitreous carbon 401 (protrusion) that is different from the vitreous carbon 401 (protrusion) which the trigger electrode 17 faces when the discharge stops. Accordingly, when the discharge stops, the carbon thin film may be manufactured by using other vitreous carbons 401 successively.

Moreover, since the insulating frame 402 is disposed among the vitreous carbons 401 (protrusions), when one of the vitreous carbons 401 is used to generate the arc discharge, the arc spot may be suppressed from moving to other vitreous carbons 401.

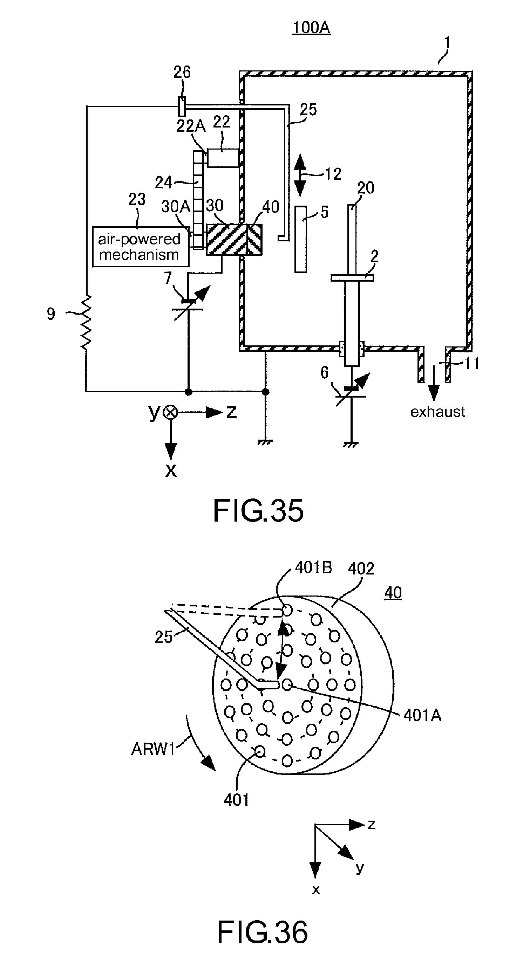

FIG. 35 is a schematic diagram showing the structure of another plasma device according to the second embodiment. The plasma device of the second embodiment may be a plasma device 100A as shown in FIG. 35.

With reference to FIG. 35, the plasma device 100A is the same as the plasma device 100 except that the holding member 18, the screw member 19, and the supporting member 21 of the plasma device 100 of FIG. 30 are omitted, the trigger electrode 17 is replaced by a trigger electrode 25, and a handle member 26 is further added.

The trigger electrode 25 is disposed through a through hole formed in the side wall of the vacuum container 1 such that one end of the trigger electrode 25 faces the negative electrode member 40 and the other end thereof is disposed outside the vacuum container 1. In this case, in the portion of the through hole, an O-ring is disposed between the vacuum container 1 and the trigger electrode 25.

The handle member 26 includes an insulating member and is fixed to the other end of the trigger electrode 25. The handle member 26 is operated by the operator of the plasma device 100A to rotate in the x-y plane.

The trigger electrode 25 is connected to the resistor 9 by a wire through a through hole of the handle member 26.

FIG. 36 is a diagram illustrating the mechanism for bringing the trigger electrode 25 of FIG. 35 respectively in contact with all the vitreous carbons 401 of the negative electrode member 40.

With reference to FIG. 36, by rotating the handle member 26 in the x-y plane, the trigger electrode 25 is moved in an arc between the vitreous carbon 401 (vitreous carbon 401A) disposed on the innermost peripheral side and the vitreous carbon 401 (vitreous carbon 401B, for example) disposed on the outermost peripheral side. In addition, the negative electrode member 40 is rotated by the motor 22 in the direction of the arrow ARW1, for example, and stops at a desired rotation angle.

Consequently, the trigger electrode 25 may be placed to respectively face all the vitreous carbons 401 of the negative electrode member 40.

In the plasma device 100A, the trigger electrode 25 is moved in an arc by the handle member 26, and the arc-type evaporation source 30 and the negative electrode member 40 are rotated by a desired angle by the motor 22, the gear 22A, the belt 24, and the gear 30A, such that the trigger electrode 25 faces one of the vitreous carbons 401. The arc-type evaporation source 30 and the negative electrode member 40 are moved in the z axis direction by the air-powered mechanism 23 to bring the trigger electrode 25 into contact with one of the vitreous carbons 401 of the negative electrode member 40, and then the trigger electrode 25 is separated.

The production of the carbon thin film using the plasma device 100A is carried out according to the flow chart of FIG. 34. In this case, in Step S12, by rotating the handle member 26 in the x-y plane, the trigger electrode 25 is moved in an arc in a range from the vitreous carbon 401 (vitreous carbon 401A) disposed on the innermost peripheral side to the vitreous carbon 401 (vitreous carbon 401B, for example) disposed on the outermost peripheral side.

In the case of using the plasma device 100A, when the discharge stops in Step S6, Step S11 and Step S12 are repeated. Thus, the trigger electrode 25 may face another vitreous carbon 401 (protrusion) that is different from the vitreous carbon 401 (protrusion) which the trigger electrode 25 faces when the discharge stops. Accordingly, when the discharge stops, the carbon thin film may be manufactured by using other vitreous carbons 401 successively.

Moreover, since the insulating frame 402 is disposed among the vitreous carbons 401 (protrusions), when one of the vitreous carbons 401 is used to generate the arc discharge, the arc spot may be suppressed from moving to other vitreous carbons 401.

In the above, because the diameter of the vitreous carbon 401 is substantially equal to the diameter of the through hole 402A of the insulating frame 402, the vitreous carbon 401 is inserted into the through hole 402A to be in contact with the insulating frame 402. However, the vitreous carbon 401 is the main component that is heated during the discharge. Therefore, the temperature difference between the vitreous carbon 401 and the insulating frame 402 of the peripheral portion increases and heat distortion may occur on the vitreous carbon 401 and cause cracking.

In the second embodiment, it is preferable to set the diameter of the through hole 402A of the insulating frame 402 to prevent the vitreous carbon 401 from contacting the insulating frame 402. For example, if the diameter of the vitreous carbon 401 is 10 mmϕ, it is preferable to set the diameter of the through hole 402A to 11 mmϕ to 12 mmϕ.

By doing so, the vitreous carbon 401 does not easily contact the insulating frame 402, and heat distortion is unlikely to occur. Accordingly, cracking of the vitreous carbon 401 may be further suppressed.

As described above, the plasma devices 100 and 100A of the second embodiment bring the trigger electrodes 17 and 25 to respectively face each of the vitreous carbons 401 (protrusions), so as to use all the vitreous carbons 401 (protrusions) to manufacture the carbon thin film.

The plasma device 100 is characterized in that, with a moving mechanism that moves the trigger electrode 17 linearly along the x axis for a desired distance and a rotating mechanism that rotates the negative electrode member 40 by a desired angle, the trigger electrode 17 is brought to respectively face each of the vitreous carbons 401 (protrusions), and the trigger electrode 17 is placed in contact with each of the vitreous carbons 401 (protrusions) or separated therefrom by the air-powered mechanism 23.

In addition, the plasma device 100A is characterized in that, with a moving mechanism that moves the trigger electrode 25 in an arc for a desired distance and a rotating mechanism that rotates the negative electrode member 40 by a desired angle, the trigger electrode 25 is brought to respectively face each of the vitreous carbons 401 (protrusions), and the trigger electrode 17 is placed in contact with each of the vitreous carbons 401 (protrusions) or separated therefrom by the air-powered mechanism 23.

In the second embodiment, the holding member 18, the screw member 19, and the supporting member 21 constitute the "moving mechanism".

In addition, in the second embodiment, the motor 22, the gear 22A, the belt 24, and the gear 30A constitute the "rotating mechanism".

Other descriptions of the second embodiment are the same as those of the first embodiment.

### [Third Embodiment]

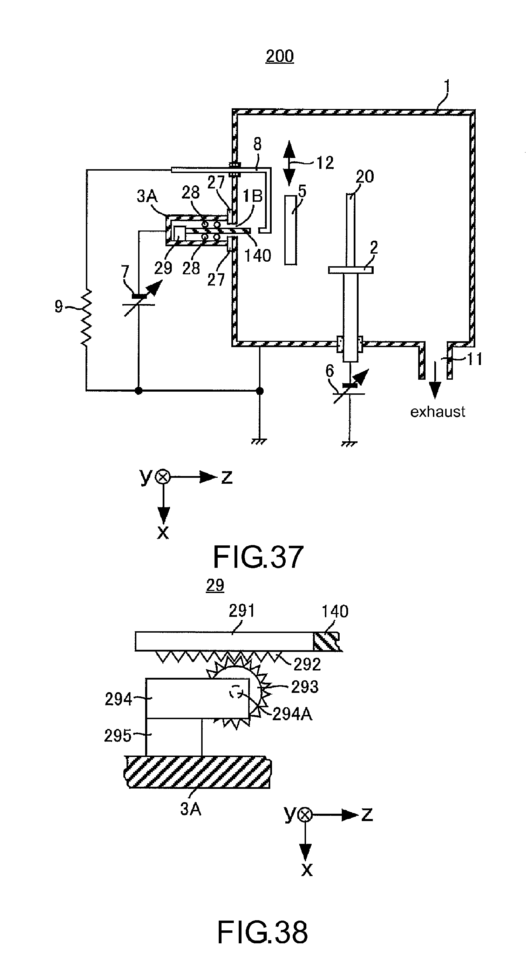

FIG. 37 is a schematic diagram showing the structure of the plasma device according to the third embodiment. With reference to FIG. 37, a plasma device 200 of the third embodiment is the same as the plasma device 10 except that the arc-type evaporation source 3 of the plasma device 10 of FIG. 1 is replaced by an arc-type evaporation source 3A, the negative electrode member 4 is replaced by a negative electrode member 140, and an insulating member 27, a bearing 28, and a delivery mechanism 29 are further added.

The insulating member 27 is fixed to the side wall of the vacuum container 1 through an O-ring (not shown) to surround a through hole 1B formed in the side wall of the vacuum container 1.

The arc-type evaporation source 3A has a hollow columnar shape and is fixed to the insulating member 27. The arc-type evaporation source 3A is connected to the negative electrode of the power source 7.

The negative electrode member 140 includes the same material as the negative electrode member 4 and has a columnar shape. Moreover, the negative electrode member 140 has a diameter of several cmϕ or less and a length of several mm or more, for example. The negative electrode member 140 is disposed through the through hole 1B that is formed in the side wall of the vacuum container 1, wherein one end of the negative electrode member 140 faces one end of the trigger electrode 8.

The bearing 28 includes a metal material and is disposed between the arc-type evaporation source 3A and the negative electrode member 140 and in contact with the arc-type evaporation source 3A and the negative electrode member 140. The negative electrode member 140 is sent out in the z axis direction by the delivery mechanism 29.

The delivery mechanism 29 is disposed in the arc-type evaporation source 3A and sends out the negative electrode member 140 in the z axis direction by the following method.

FIG. 38 is a schematic diagram showing the structure of the delivery mechanism 29 of FIG. 37. With reference to FIG. 38, the delivery mechanism 29 includes a rod member 291, a concave-convex member 292, a gear 293, a motor 294, and a base member 295.

The rod member 291 includes an insulating material and is disposed along the z axis. One end of the rod member 291 is connected with the negative electrode member 140. The concave-convex member 292 is fixed to the rod member 291. The gear 293 is engaged with the concave-convex member 292. The motor 294 is disposed on the base member 295. A rotating shaft 294A of the motor 294 is connected with the gear 293. The base member 295 is disposed on the arc-type evaporation source 3A.

The motor 294 rotates the gear 293 clockwise through the rotating shaft 294A. Consequently, the rod member 291 is sent out in the z axis direction by the rotation of the gear 293. Thus, the delivery mechanism 29 is capable of sending out the negative electrode member 140 in the z axis direction.

As described above, the arc-type evaporation source 3A is fixed to the insulating member 27 and the insulating member 27 is fixed to the side wall of the vacuum container 1 through the O-ring. Thus, the interior of the arc-type evaporation source 3A is maintained at the same pressure as the vacuum container 1.

In addition, because the bearing 28 includes a metal material and is in contact with both the arc-type evaporation source 3A and the negative electrode member 140, by making the trigger electrode 8 in contact with one end of the negative electrode member 140, a current flows through the negative electrode member 140, the bearing 28, and the arc-type evaporation source 3A when an arc discharge is generated between the negative electrode member 140 and the anode (the vacuum container 1). As a result, the temperature of the negative electrode member 140 rises.

In this case, the negative electrode member 140 has the same diameter as the protrusion 42 of the negative electrode member 4, and thus it is heated easily (temperature equalization) and heat distortion is reduced.

Therefore, cracking of the negative electrode member 140 may be suppressed.

In the plasma device 200, when the negative electrode member 140 is consumed by the arc discharge, the negative electrode member 140 is sent out toward the side of the substrate 20 by the delivery mechanism 29 so as to keep the tip portion of the negative electrode member 140 (the tip portion on the side of the substrate 20) at the same position before the consumption.

In this way, the arc discharge may be kept stable for a long time. Thus, a thick carbon thin film may be manufactured. The productivity may be improved.

It is assumed that a timing of moving the negative electrode member 140 toward the side of the substrate 20 is a timing when a certain discharge time has elapsed.

More specifically, the timing when a certain discharge time has elapsed is a timing when one film formation is completed.

Besides, the negative electrode member 140 is sent out toward the side of the substrate 20 by the delivery mechanism 29 in a manner that makes the film thickness distribution of the carbon thin film deposited on the substrate 20 or the film formation rate of the carbon thin film fall in a desired range.

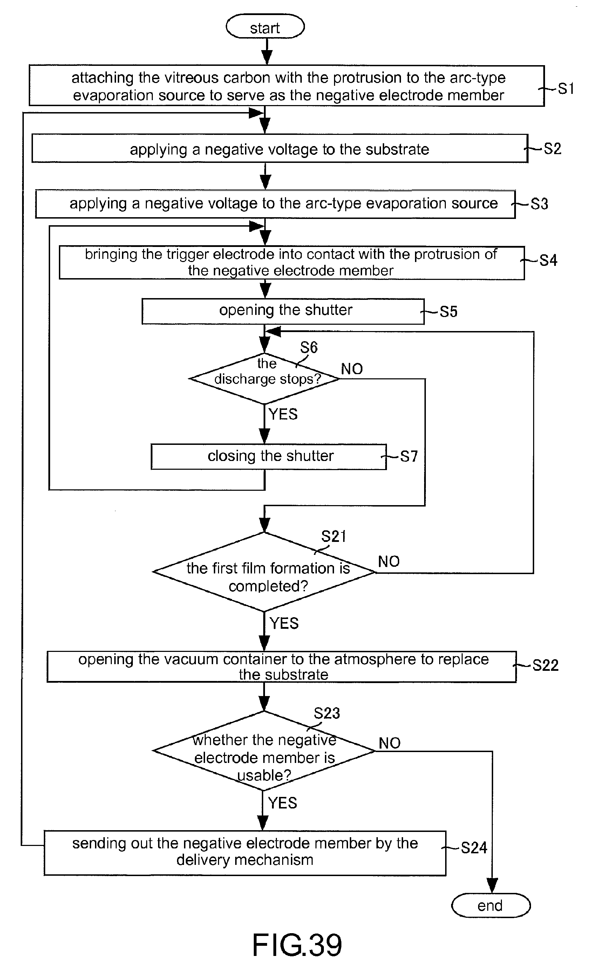

FIG. 39 is a flow chart showing the carbon thin film manufacturing method using the plasma device 200 shown in FIG. 37.

The flow chart of FIG. 39 is the same as the flow chart of FIG. 4 except that Step S21 to Step S24 are further added to the flow chart of FIG. 4.

The flow chart of FIG. 39 illustrates sending out the negative electrode member 140 at the timing when one film formation is completed.

With reference to FIG. 39, when the production of a carbon thin film starts, the aforementioned Steps S1 to S7 are performed sequentially. In Step S6, if it is determined that the discharge does not stop, whether one film formation is completed is further determined (Step S21).

In Step S21, when it is determined that one film formation is not completed yet, Steps S6, S7, and S21 are repeated.

On the other hand, in Step S21, when it is determined that one film formation is completed, the vacuum container 1 is opened to the atmosphere to replace the substrate 20 (Step S22). Further, whether the negative electrode member 140 is usable is determined (Step S23).

In Step S23, when it is determined that the negative electrode member 140 is usable, the delivery mechanism 29 sends out the negative electrode member 140 toward the side of the substrate 20 so as to place the tip portion of the negative electrode member 140 that has been consumed at the same position before consumption (Step S24).

Then, the aforementioned Steps S2 to S7 and S21 to S24 are repeated. In Step S23, if it is determined that the negative electrode member 140 is not usable, the series of operations ends.

As described, according to the flow chart of FIG. 39, by performing one operation to attach the negative electrode member 140 to the arc-type evaporation source 3A, the negative electrode member 140 is repeatedly sent toward the side of the substrate 20 until the negative electrode member 140 becomes unusable. Thus, it is not necessary to frequently replace the negative electrode member and the productivity of the carbon thin film may be improved.

Formation of the carbon thin film is carried out multiple times until the negative electrode member 140 becomes unusable. Since the tip portion of the negative electrode member 140 may be maintained at a certain position for each formation, the arc discharge may be stabilized for a long time and the productivity of the carbon thin film may be significantly improved.

Furthermore, in Step S21, by determining whether the film thickness of the carbon thin film reaches a desired film thickness, the carbon thin film may be repeatedly deposited on the substrate 20 until the desired film thickness is reached, so as to manufacture a thick carbon thin film.

In the plasma device 200, the cross section of the negative electrode member 140 is not limited to a circular shape and may be triangular, rectangular, or pentagonal. Generally, the cross section may be a polygonal shape.

In addition, the plasma device 200 may be provided with a plurality of negative electrode members 140. In that case, a bearing the same as the bearing 28 is disposed between two adjacent negative electrode members 140 to be in contact with the negative electrode members 140.

Further, the plasma device 200 may include one of the negative electrode members 4 and 4A to 4L in place of the negative electrode member 140.

Other descriptions of the third embodiment are the same as those of the first embodiment.

### [Fourth Embodiment]

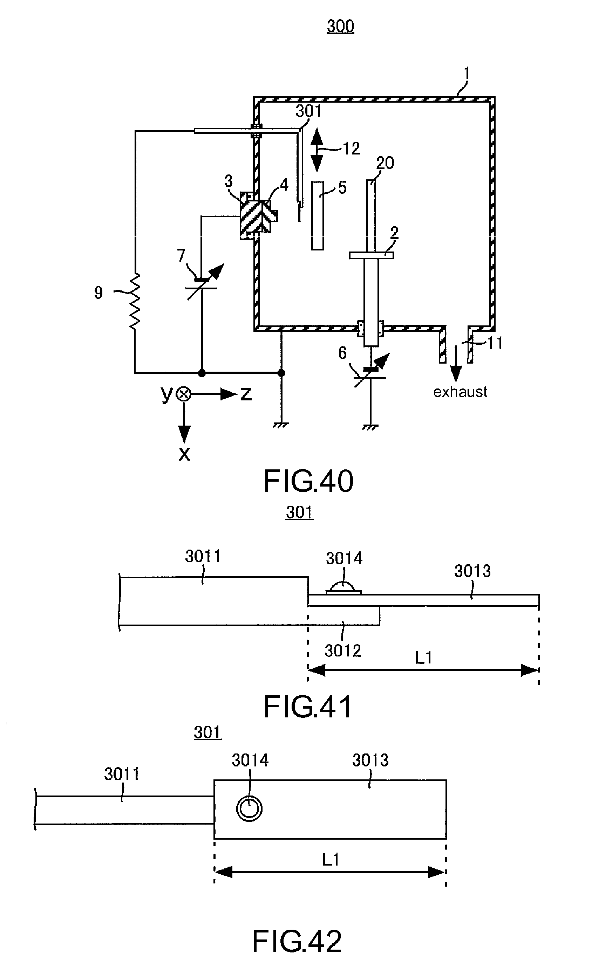

FIG. 40 is a schematic diagram showing the structure of the plasma device according to the fourth embodiment. With reference to FIG. 40, a plasma device 300 of the fourth embodiment is the same as the plasma device 10 except that the trigger electrode 8 of the plasma device 10 of FIG. 1 is replaced by a trigger electrode 301.

A portion of the trigger electrode 301 passes through the side wall of the vacuum container 1 to be disposed in the vacuum container 1 while the rest of the trigger electrode 301 is outside the vacuum container 1. The trigger electrode 301 includes Mo, for example, and is connected to the ground node GND through the resistor 9.

FIG. 41 is a cross-sectional diagram of one end of the trigger electrode 301 shown in FIG. 40. FIG. 42 is a plan view of one end of the trigger electrode 301 shown in FIG. 40 when viewed from the side of the negative electrode member 4.

With reference to FIG. 41 and FIG. 42, the trigger electrode 301 includes a main body 3011, a tip portion 3012, a thin film portion 3013, and a screw 3014.

The main body 3011 has a diameter of 6 mmϕ, for example. The tip portion 3012 is fixed to one end of the main body 3011. The tip portion 3012 has a thickness of 3.1 mm, for example, which is thinner than the main body 3011. The tip portion 3012 has a length of 10 mm, for example. The main body 3011 and the tip portion 3012 are manufactured integrally.

One end of the thin film portion 3013 is fixed to the tip portion 3012 of the trigger electrode 301 by the screw 3014. The thin film portion 3013 includes Mo and is made of a thin plate produced by Nilaco Corporation, for example. The thin film portion 3013 has a length L1 of 30 mm and a thickness of 0.1 mm, for example. Besides, the thin film portion 3013 is wider than the main body 3011.

The screw 3014 is a hexagon socket head M3 screw, for example.

The trigger electrode 301 is disposed such that the thin film portion 3013 faces the negative electrode member 4. By moving the trigger electrode 301 in the z axis direction, the thin film portion 3013 is brought into contact with or separated from the protrusion 42 of the negative electrode member 4. In this case, since the thin film portion 3013 has a thickness of 0.1 mm, the thin film portion 3013 is bent due to the movement of the trigger electrode 301 in the z axis direction. Consequently, damage of the protrusion 42 may be prevented even when the thin film portion 3013 is in contact with the protrusion 42 of the negative electrode member 4.

### <Experiment>

An experiment was carried out to confirm whether the negative electrode member 4 is damaged or not. The experimental method is as follows. The vacuum container 1 was exhausted by an exhaust device (not shown) until 9.9 × 10⁻³ Pa was reached and the arc current was set to 80A. Then, the experiment for determining whether the discharge was arc-ignited normally and whether the negative electrode member 4 was damaged was carried out. The experiment was performed 10 times.

The negative electrode member 4 included the main body 41 composed of graphite and the protrusion 42 composed of a vitreous carbon of 3 mmΦ (GC20SS, produced by Tokai Fine Carbon Machining Co., Ltd.). In addition, the influence of repeated use was eliminated by replacing the negative electrode member 4 every time.

The experiment result is as follows. It was confirmed that the discharge was normally arc-ignited 10 times in a row with use of the trigger electrode 301. The protrusion 42 of the negative electrode member 4 was not damaged, and the thin film portion 3013 has not been replaced.

The above demonstrates that, by using the trigger electrode 301 with the thin film portion 3013 attached to the tip portion 3012, damage of the protrusion 42 of the negative electrode member 4 is prevented and the discharge arc-ignition is performed stably.

In the fourth embodiment, the thin film portion 3013 may also include tungsten, tantalum, SUS304, etc. Moreover, the thickness of the thin film portion 3013 is not limited to 0.1 mm and may be 0.3 mm or 0.5 mm. Generally, the thin film portion 3013 may include a flexible material having conductivity.

The production of the carbon thin film using the plasma device 300 is carried out according to Step S1 to Step S8 of FIG. 4.

Besides, the plasma device of the fourth embodiment may also be the plasma device 10A of FIG. 29 with the trigger electrode 8 replaced by the trigger electrode 301, the plasma device 100 of FIG. 30 with the trigger electrode 17 replaced by the trigger electrode 301, the plasma device 100A of FIG. 35 with the trigger electrode 25 replaced by the trigger electrode 301, or the plasma device 200 of FIG. 37 with the trigger electrode 8 replaced by the trigger electrode 301.

Other descriptions of the fourth embodiment are the same as those of the first to the third embodiments.

### [Fifth Embodiment]

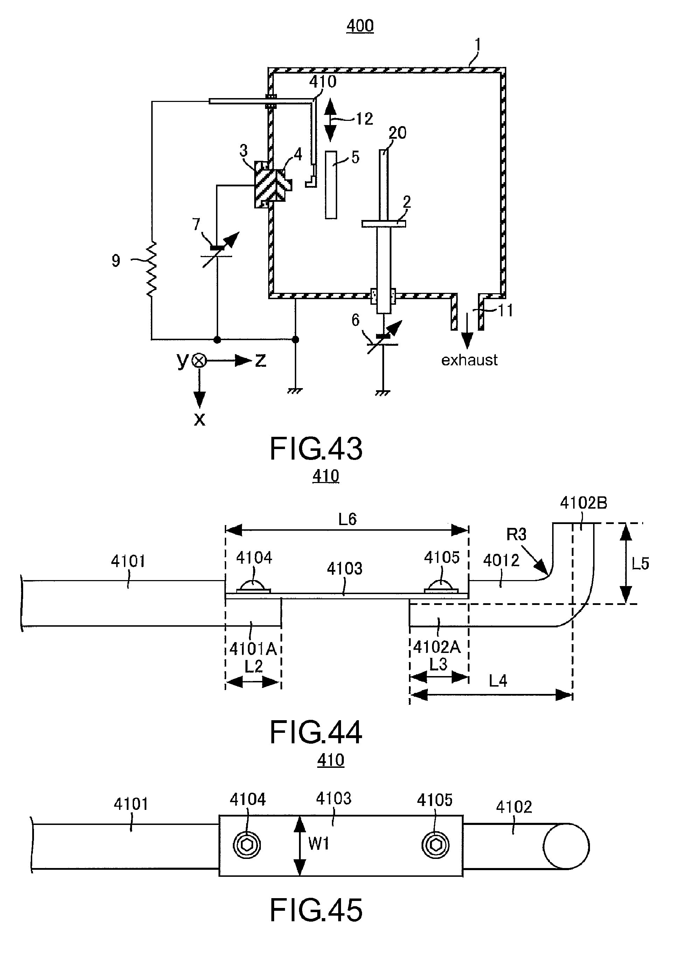

FIG. 43 is a schematic diagram showing the structure of the plasma device according to the fifth embodiment. With reference to FIG. 43, a plasma device 400 of the fifth embodiment is the same as the plasma device 10 except that the trigger electrode 8 of the plasma device 10 of FIG. 1 is replaced by a trigger electrode 410.

A portion of the trigger electrode 410 passes through the side wall of the vacuum container 1 to be disposed in the vacuum container 1 while the rest of the trigger electrode 410 is outside the vacuum container 1. The trigger electrode 410 includes Mo, for example, and is connected to the ground node GND through the resistor 9.

FIG. 44 is a cross-sectional diagram of one end of the trigger electrode 410 shown in FIG. 43. FIG. 45 is a plan view of one end of the trigger electrode 410 shown in FIG. 43 when viewed from the side of the negative electrode member 4.

With reference to FIG. 44 and FIG. 45, the trigger electrode 410 includes a main body 4101, a curved portion 4102, a thin plate portion 4103, and screws 4104 and 4105.

The main body 4101 includes Mo and has a diameter of 3 mmΦ, for example. The main body 4101 has a tip portion 4101A. The tip portion 4101A has a thickness of 1.6 mm and a length L2 of 5 mm, for example.

The curved portion 4102 includes Mo and has a diameter of 3 mmΦ, for example. The curved portion 4102 has a tip portion 4102A and a protrusion 4102B. The tip portion 4102A has a thickness of 1.6 mm and a length L3 of 5 mm, for example.

Regarding the curved portion 4102, a length L4 from an end surface of the tip portion 4102A to the central axis of the protrusion 4102B is 20 mm, for example. Moreover, regarding the curved portion 4102, a length L5 from an end surface of the protrusion 4102B to the central axis of the curved portion 4102 is 10 mm, for example. In addition, a curvature radius R3 of the curved portion 4102 is 3 mm.

Since the diameter of the curved portion 4102 is 3 mmΦ, the curved portion 4102 has a volume greater than the thin film portion 3013 of the trigger electrode 301 described above.

One end of the thin plate portion 4103 is fixed to the tip portion 4101A of the main body 4101 by the screw 4104 and the other end thereof is fixed to the tip portion 4102A of the curved portion 4102 by the screw 4105. The thin plate portion 4103 has a thickness of 0.5 mm, a length L6 of 30 mm, and a width W1 of 10 mm, for example. The thin plate portion 4103 functions as a leaf spring.

The screws 4104 and 4105 are hexagon socket head M2 screws.

The trigger electrode 410 is disposed such that the protrusion 4102B of the curved portion 4102 faces the negative electrode member 4.

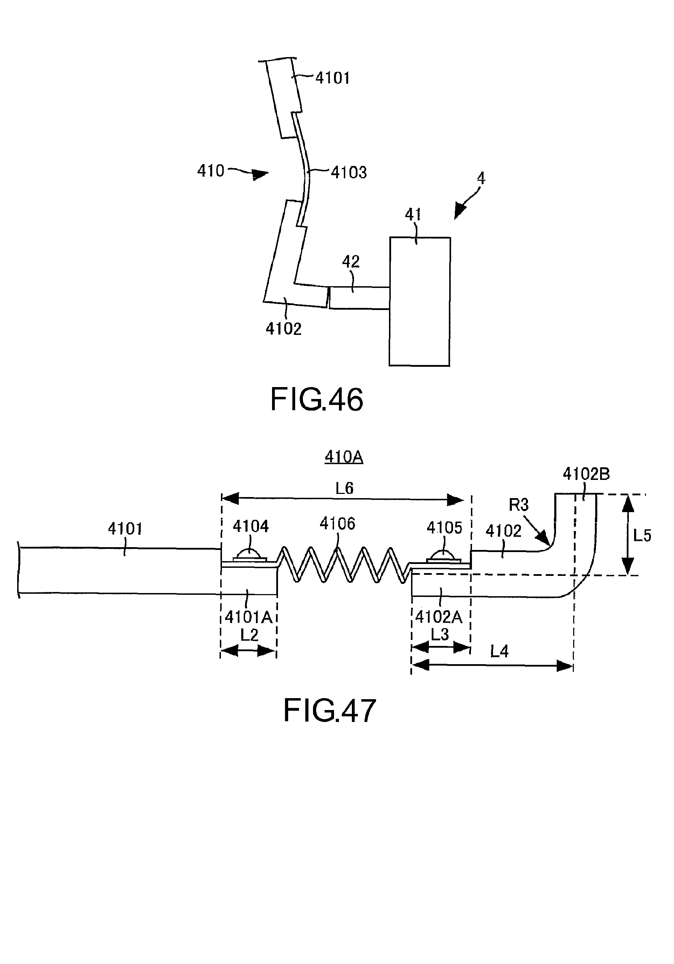

FIG. 46 is a conceptual diagram illustrating the trigger electrode 410 of FIG. 43 in contact with the protrusion 42 of the negative electrode member 4. With reference to FIG. 46, the trigger electrode 410 is moved in the z axis direction, by which the curved portion 4102 of the trigger electrode 410 comes into contact with the protrusion 42 of the negative electrode member 4 and is bent into an arc shape such that the thin plate portion 4103 protrudes toward the side of the negative electrode member 4. Consequently, damage of the protrusion 42 may be prevented even when the curved portion 4102 is in contact with the protrusion 42 of the negative electrode member 4.

Since the curved portion 4102 of the trigger electrode 410 has a volume greater than the thin film portion 3013 of the trigger electrode 301, even when the arc current flows intensively to the contact portion between the trigger electrode 410 and the negative electrode member 4, the curved portion 4102 may be prevented from being easily evaporated and consumed so as to increase the lifespan of the trigger electrode 410.

FIG. 47 is a cross-sectional diagram of another trigger electrode according to the fifth embodiment. The plasma device 400 may be provided with a trigger electrode 410A, as shown in FIG. 47, in place of the trigger electrode 410.

With reference to FIG. 47, the trigger electrode 410A is the same as the trigger electrode 410 except that the thin plate portion 4103 of the trigger electrode 410 of FIG. 45 is replaced by a spring portion 4106.

One end of the spring portion 4106 is fixed to the tip portion 4101A of the main body 4101 by the screw 4104 and the other end thereof is fixed to the tip portion 4102A of the curved portion 4102 by the screw 4105.

The spring portion 4106 has a structure made by winding a wire made of Mo and having a diameter of 8 mmΦ into a spiral shape, for example.

In the case of using the trigger electrode 410A, by moving the trigger electrode 410A in the z axis direction, the curved portion 4102 of the trigger electrode 410A comes in contact with the protrusion 42 of the negative electrode member 4 and is bent into an arc shape such that the spring portion 4106 protrudes toward the side of the negative electrode member 4. Consequently, damage of the protrusion 42 may be prevented even when the curved portion 4102 is in contact with the protrusion 42 of the negative electrode member 4.

Like the trigger electrode 410, the lifespan of the trigger electrode 410A may be increased.

In the fifth embodiment, the thin plate portion 4103 and the spring portion 4106 may also include tungsten, tantalum, SUS304, etc. Moreover, the thickness of the thin plate portion 4103 is not limited to 0.5 mm and may be 0.3 mm or 0.7 mm. Generally, the thin plate portion 4103 and the spring portion 4106 may include a flexible material having conductivity.

The production of the carbon thin film using the plasma device 400 is carried out according to Step S1 to Step S8 of FIG. 4.

Besides, the plasma device of the fifth embodiment may also be the plasma device 10A of FIG. 29 with the trigger electrode 8 replaced by the trigger electrode 410 or 410A, the plasma device 100 of FIG. 30 with the trigger electrode 17 replaced by the trigger electrode 410 or 410A, the plasma device 100A of FIG. 35 with the trigger electrode 25 replaced by the trigger electrode 410 or 410A, or the plasma device 200 of FIG. 37 with the trigger electrode 8 replaced by the trigger electrode 410 or 410A.

Other descriptions of the fifth embodiment are the same as those of the first to the third embodiments.

### [Sixth Embodiment]

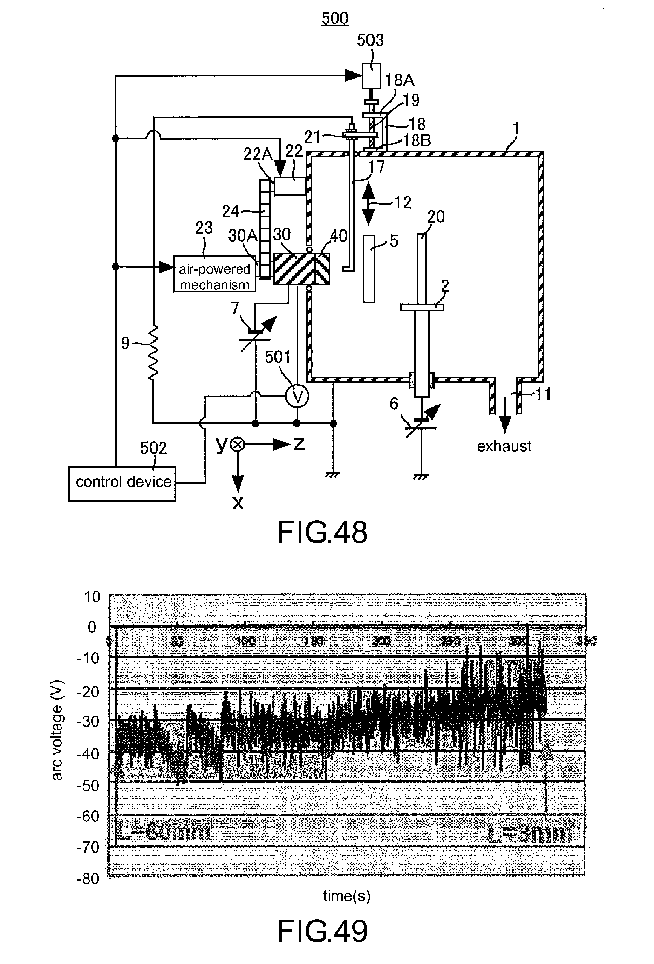

FIG. 48 is a schematic diagram showing the structure of the plasma device according to the sixth embodiment. With reference to FIG. 48, a plasma device 500 of the sixth embodiment is the same as the plasma device 100 except that a voltmeter 501, a control device 502, and a motor 503 are further added to the plasma device 100 of FIG. 30.

The voltmeter 501 is connected between the arc-type evaporation source 30 and the ground potential GND. The voltmeter 501 detects a discharge voltage Vd during the arc discharge and outputs the detected discharge voltage Vd to the control device 502.

The control device 502 receives the discharge voltage Vd from the voltmeter 501. The control device 502 compares an absolute value |Vd| of the discharge voltage Vd with a threshold value Vd_th, and when the absolute value |Vd| is equal to or smaller than the threshold value Vd_th, controls the motor 503 to move the trigger electrode 17 for a desired distance in the x axis direction, controls the motor 22 to rotate the arc-type evaporation source 30 by a desired angle, and controls the air-powered mechanism 23 to make the negative electrode member 40 contact the trigger electrode 17 or separate the negative electrode member 40 therefrom. On the other hand, when the absolute value |Vd| is greater than the threshold value Vd_th, the control device 502 does not control the motors 22 and 503 and the air-powered mechanism 23.

FIG. 49 is a diagram showing the temporal variation of the arc voltage. In FIG. 49, the vertical axis represents the arc voltage (= the discharge voltage Vd) and the horizontal axis represents the time after the discharge starts. The temporal variation of the arc voltage as shown in FIG. 49 was obtained by measurement using the columnar vitreous carbon 401 having a diameter of 3 mmΦ and a length of 60 mm. In this case, the discharge current was set to 80A constantly.

With reference to FIG. 49, the absolute value of the arc voltage (= the discharge voltage Vd) is about 35V immediately after the discharge starts and becomes about 22V at 300 seconds or more after the discharge starts. 300 seconds after the discharge starts, the length of the vitreous carbon 401 is 3 mm.

In the period between 250 seconds and 300 seconds after the discharge starts, the arc voltage (= the discharge voltage Vd) is about -25V. Thus, if the threshold value Vd_th is set to 25V, the control device 502 controls the motor 503 to move the trigger electrode 17 for a desired distance in the x axis direction, controls the motor 22 to rotate the arc-type evaporation source 30 by a desired angle, and controls the air-powered mechanism 23 to make the negative electrode member 40 contact the trigger electrode 17 or separate the negative electrode member 40 therefrom when the absolute value |Vd| is equal to or smaller than 25V (= the threshold value Vd_th). On the other hand, when the absolute value |Vd| is greater than 25V (= the threshold value Vd_th), the control device 502 does not control the motors 22 and 503 and the air-powered mechanism 23.

Thereby, when the length of one of the vitreous carbons 401 becomes about 3 mm, another vitreous carbon 401 may be used to ignite the discharge to deposit the carbon thin film on the substrate 20.

As a result, in the case where multiple vitreous carbons 401 are disposed on a backing plate, after one vitreous carbon 401 is arc-ignited and discharged, if the timing of arc extinction delays, the arc spot would move to the backing plate, which not only damages the backing plate but also causes the evaporant from the backing plate to be mixed into the carbon thin film and results in the problems of low quality and low adhesion of the carbon thin film.

According to the sixth embodiment, however, when the length of one vitreous carbon 401 is reduced to about 3 mm, the arc is extinguished and another vitreous carbon 401 is arc-ignited and discharged. Thus, the aforementioned problems are prevented.

Therefore, damage of the backing plate may be prevented and the quality and adhesion of the carbon thin film may be improved.

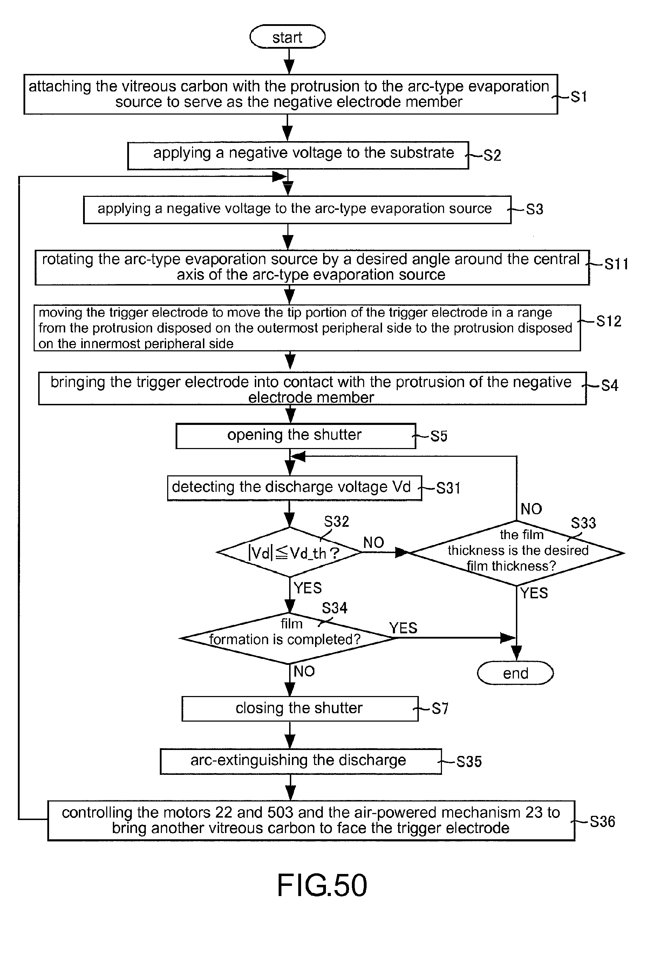

FIG. 50 is a flow chart showing the carbon thin film manufacturing method using the plasma device 500 shown in FIG. 48.

The flow chart of FIG. 50 is the same as the flow chart of FIG. 34 except that Step S6 in the flow chart of FIG. 34 is replaced by Steps S31 and S32, and Step S33 to Step S36 are further added.

With reference to FIG. 50, when the production of the carbon thin film starts with use of the plasma device 500, the aforementioned Steps S1 to S3, S11, S12, S4, and S5 are performed sequentially.

After Step S5, the voltmeter 501 detects the discharge voltage Vd, and the control device 502 determines whether the absolute value |Vd| of the discharge voltage Vd is equal to or smaller than the threshold value Vd_th (Step S32).

In Step S32, when it is determined that the absolute value |Vd| is greater than the threshold value Vd_th, whether the film thickness is the desired film thickness is determined (Step S33). In this case, the film formation rate of the carbon thin film is measured in advance, and the film thickness of the carbon thin film is obtained by multiplying the discharge time by the film formation rate. Then, whether the obtained film thickness is the desired film thickness is determined.

In Step S33, when it is determined that the film thickness reaches the desired film thickness, the series of operations ends.

On the other hand, when it is determined that the film thickness does not reach the desired film thickness in Step S33, the series of operations returns to Step S31, and Steps S31 to S33 are repeated until it is determined that the absolute value |Vd| is equal to or smaller than the threshold value Vd_th in Step S32 or it is determined that the film thickness reaches the desired film thickness in Step S33.

In Step S32, if it is determined that the absolute value |Vd| is equal to or smaller than the threshold value Vd_th, whether to end the film formation is determined (Step S34).

In Step S34, when it is determined not to end the film formation, the aforementioned Step S7 is performed and the discharge is arc-extinguished (Step S35).

Then, the control device 502 controls the motors 22 and 503 and the air-powered mechanism 23 to bring another vitreous carbon 401 to face the trigger electrode 17 (Step S36).

Thereafter, the series of operations returns to Step S3, and the aforementioned Steps S3, S11, S12, S4, S5, S31, S32, S7, S33, S34, S35, and S36 are repeated until it is determined to end the film formation in Step S34. When it is determined to end the film formation in Step S34, the production of the carbon thin film is completed.

The above illustrates that, when it is determined that the absolute value |Vd| of the discharge voltage Vd is equal to or smaller than the threshold value Vd_th, another vitreous carbon 401 is used for performing the discharge. Nevertheless, the sixth embodiment may also be that, when a discharge resistance Rd becomes equal to or smaller than a threshold value Rd_th, another vitreous carbon 401 is used for performing the discharge.

As described above, since the discharge current is constantly 80A, the discharge resistance Rd may be calculated by detecting the discharge voltage Vd. In the above example, immediately after the discharge starts, the discharge resistance Rd is 0.44Ω (Rd = 35/80 = 0.44Ω), and 300 seconds after the discharge starts and thereafter, the discharge resistance Rd becomes 0.28Ω (Rd = 22/80 = 0.28Ω).

Accordingly, by setting the threshold value Rd_th to 0.30Ω, for example, the control device 502 may control the motors 22 and 503 and the air-powered mechanism 23 to bring another vitreous carbon 401 to face the trigger electrode 17 when determining that the discharge resistance Rd is equal to or smaller than the threshold value Rd_th, and not control the motors 22 and 503 and the air-powered mechanism 23 when determining that the discharge resistance Rd is greater than the threshold value Rd_th.

In the case of using the discharge resistance Rd to manufacture the carbon thin film, the carbon thin film is also manufactured according to the flow chart shown in FIG. 50. In this case, when receiving the discharge voltage Vd from the voltmeter 501, the control device 502 calculates the discharge resistance Rd and determines whether the discharge resistance Rd is equal to or smaller than the threshold value Rd_th in Step S32.

In the case of using the discharge resistance Rd to manufacture the carbon thin film, the aforementioned effects may still be achieved.

Moreover, in the sixth embodiment, when a certain time (= 300 seconds, for example) has elapsed after the discharge starts, the vitreous carbon 401 that is being used may be arc-extinguished and another vitreous carbon 401 may be arc-ignited.

In that case, the time that has elapsed after the discharge starts is measured in Step S31, and whether the elapsed time is equal to or greater than the threshold value (= 300 seconds) is determined in Step S32. When the elapsed time is equal to or greater than the threshold value (= 300 seconds), Steps S34, S7, S35, and S36 are performed sequentially and the series of operations returns to Step S3. On the other hand, if the elapsed time is smaller than the threshold value (= 300 seconds), the series of operations moves on to Step S33.

In the case of manufacturing the carbon thin film using the time that has elapsed after the discharge starts, the aforementioned effects may still be achieved.

When receiving the discharge voltage Vd from the voltmeter 501, the control device 502 may integrate the received discharge voltage Vd by an integration circuit and obtain an absolute value of the integrated value of the discharge voltage Vd to serve as the absolute value |Vd|. The reason is that, since the discharge voltage Vd fluctuates sharply as shown in FIG. 49, the comparison between the absolute value of the integrated value of the discharge voltage Vd and the threshold value Vd_th is more accurate.

Moreover, in the sixth embodiment, the plasma device 500 may be provided with one of the trigger electrodes 301, 410, and 410A in place of the trigger electrode 17.

Other descriptions of the sixth embodiment are the same as those of the first, fourth, and fifth embodiments.

### [Seventh Embodiment]

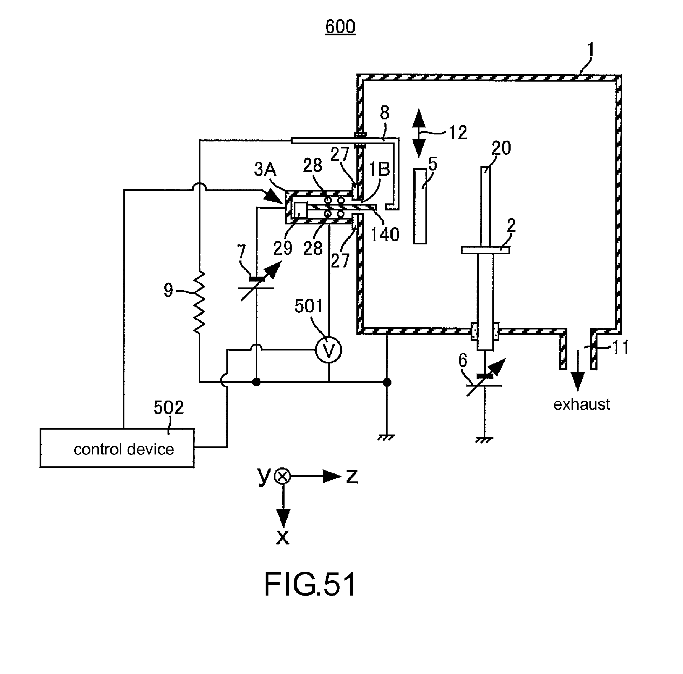

FIG. 51 is a schematic diagram showing the structure of the plasma device according to the seventh embodiment. With reference to FIG. 51, a plasma device 600 of the seventh embodiment is the same as the plasma device 200 except that the voltmeter 501 and the control device 502 are further added to the plasma device 200 of FIG. 37.

In the plasma device 600, the voltmeter 501 is connected between the arc-type evaporation source 3A and the ground potential GND.

The control device 502 determines whether the absolute value |Vd| of the discharge voltage Vd is equal to or smaller than the threshold value Vd_th, as described above. When determining that the absolute value |Vd| of the discharge voltage Vd is equal to or smaller than the threshold value Vd_th, the control device 502 controls the delivery mechanism 29 to send out the negative electrode member 140 for a certain distance toward the side of the substrate 20. On the other hand, when determining that the absolute value |Vd| of the discharge voltage Vd is greater than the threshold value Vd_th, the control device 502 does not control the delivery mechanism 29.

In the above example, when 300 seconds have elapsed after the discharge starts, the length of the columnar negative electrode member 140 is reduced to 3 mm from 60 mm.

Accordingly, when determining that the absolute value |Vd| is equal to or smaller than the threshold value Vd_th, the control device 502 controls the delivery mechanism 29 to send out the negative electrode member 140 57 mm (= 60 mm - 3 mm) toward the side of the substrate 20.

Consequently, the tip portion of the negative electrode member 140 remains at a certain position to maintain arc-ignition, and thus the arc discharge may be generated stably.

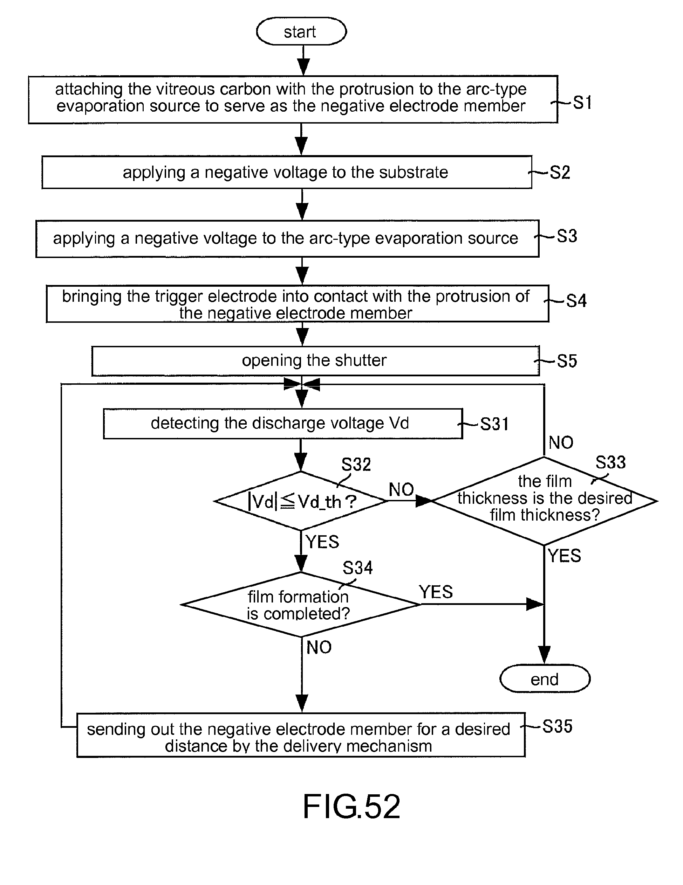

FIG. 52 is a flow chart showing the carbon thin film manufacturing method using the plasma device 600 shown in FIG. 51.

The flow chart of FIG. 52 is the same as the flow chart of FIG. 39 except that Steps S21 to S24 in the flow chart of FIG. 39 are omitted, Steps S6 and S7 are replaced by Steps S31 to S34, and Step S35 is further added.

With reference to FIG. 52, when the production of a carbon thin film starts, the aforementioned Steps S1 to S5 and S31 to S34 are performed sequentially.

In Step S34, when it is determined not to end the film formation, the negative electrode member 140 is sent out by the delivery mechanism 29 for a desired distance toward the side of the substrate 20 (Step S35).

Thereafter, the series of operations returns to Step S31, and the aforementioned Steps S31 to S35 are repeated until it is determined to end the film formation in Step S34. When it is determined to end the film formation in Step S34, the production of the carbon thin film is completed.

The above illustrates that the negative electrode member 140 is sent out for a desired distance toward the side of the substrate 20 when it is determined that the absolute value |Vd| of the discharge voltage Vd is equal to or smaller than the threshold value Vd_th. Nevertheless, the seventh embodiment may also be that the negative electrode member 140 is sent out for a desired distance toward the side of the substrate 20 when the discharge resistance Rd is equal to or smaller than the threshold value Rd_th.

As described above, since the discharge current is constantly 80A, the discharge resistance Rd may be calculated by detecting the discharge voltage Vd. In the above example, immediately after the discharge starts, the discharge resistance Rd is 0.44Ω (Rd = 35/80 = 0.44Ω), and 300 seconds after the discharge starts and thereafter, the discharge resistance Rd becomes 0.28Ω (Rd = 22/80 = 0.28Ω).

Accordingly, by setting the threshold value Rd_th to 0.30Ω, for example, the control device 502 may control the delivery mechanism 29 to send out the negative electrode member 140 for a desired distance toward the side of the substrate 20 when determining that the discharge resistance Rd is equal to or smaller than the threshold value Rd_th, and not control the delivery mechanism 29 when determining that the discharge resistance Rd is greater than the threshold value Rd_th.

In the case of using the discharge resistance Rd to manufacture the carbon thin film, the carbon thin film is also manufactured according to the flow chart shown in FIG. 52. In this case, when receiving the discharge voltage Vd from the voltmeter 501, the control device 502 calculates the discharge resistance Rd and determines whether the discharge resistance Rd is equal to or smaller than the threshold value Rd_th in Step S32.

In the case of using the discharge resistance Rd to manufacture the carbon thin film, the aforementioned effects may still be achieved.

Moreover, in the seventh embodiment, when a certain time (= 300 seconds, for example) has elapsed after the discharge starts, the vitreous carbon 401 that is being used may be arc-extinguished and the negative electrode member 140 may be sent out for a desired distance toward the side of the substrate 20.

In that case, the time that has elapsed after the discharge starts is measured in Step S31, and whether the elapsed time is equal to or greater than the threshold value (= 300 seconds) is determined in Step S32. When the elapsed time becomes equal to or greater than the threshold value (= 300 seconds), Steps S34 and S35 are performed sequentially and the series of operations returns to Step S31. On the other hand, if the elapsed time is smaller than the threshold value (= 300 seconds), the series of operations moves on to Step S33.

In the case of manufacturing the carbon thin film using the time that has elapsed after the discharge starts, the aforementioned effects may still be achieved.

Furthermore, in the seventh embodiment, the plasma device 600 may be provided with one of the trigger electrodes 301, 410, and 410A in place of the trigger electrode 8.

Other descriptions of the seventh embodiment are the same as those of the first, fourth, fifth, and sixth embodiments.

### [Eighth Embodiment]

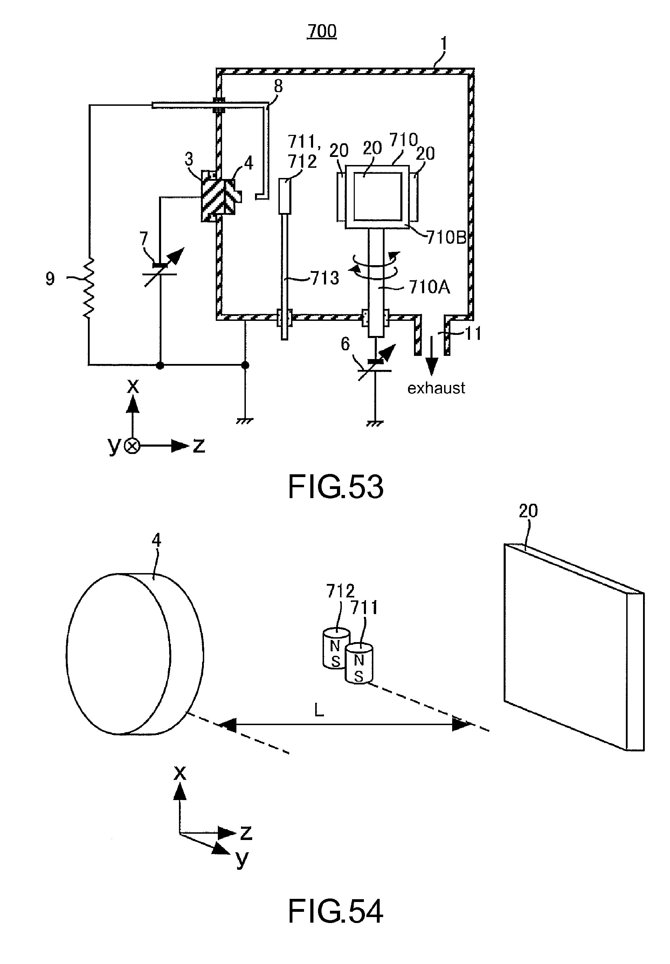

FIG. 53 is a schematic diagram showing the structure of the plasma device according to the eighth embodiment. With reference to FIG. 53, a plasma device 700 of the eighth embodiment is the same as the plasma device 10 except that the holding member 2 of the plasma device 10 of FIG. 1 is replaced by a holding member 710, and permanent magnets 711 and 712 and a supporting member 713 are further added.

The holding member 710 is disposed in the vacuum container 1 and includes a columnar portion 710A and a support portion 710B. The columnar portion 710A and the support portion 710B both include a metal. The columnar portion 710A is disposed through a bottom surface of the vacuum container 1. The support portion 710B has a cubic shape and is fixed to the columnar portion 710A, for example. The columnar portion 710A is rotated in the y-z plane by a rotating device (not shown). Thus, the support portion 710B rotates in the y-z plane along with the rotation of the columnar portion 710A.

The permanent magnets 711 and 712 respectively have a columnar shape and are disposed along the x axis between the negative electrode member 4 and the substrate 20.

In the plasma device 700, the power source 6 is connected between the holding member 710 and the ground node GND. A portion of the supporting member 713 passes through the bottom surface of the vacuum container 1 to be disposed in the vacuum container 1 while the rest of the supporting member 713 is outside the vacuum container 1. In this case, an O-ring is disposed between the supporting member 713 and the bottom surface of the vacuum container 1.

The holding member 710 holds a plurality of substrates 20 with the support portion 710B and rotates the substrates 20 in the y-z plane. The permanent magnets 711 and 712 generate a magnetic field, which diffuses a beam-shaped plasma.

The power source 6 applies a negative voltage to the substrates 20 through the holding member 710. The supporting member 713 supports the permanent magnets 711 and 712 and moves the permanent magnets 711 and 712 along the x axis (a direction from the bottom surface to the ceiling of the vacuum container 1) by a reciprocating drive device (not shown).

FIG. 54 is a diagram illustrating the positions of the permanent magnets 711 and 712 shown in FIG. 53. With reference to FIG. 54, the permanent magnets 711 and 712 each have a diameter of 5 mmϕ and a length of 20 mm, for example. The permanent magnets 711 and 712 are disposed substantially in parallel with the length direction thereof being along the direction from the bottom surface to the ceiling of the vacuum container 1 (the x axis direction) between the negative electrode member 4 and the substrate 20. In this case, an interval between the permanent magnet 711 and the permanent magnet 712 is 20 mm, for example. The permanent magnets 711 and 712 are disposed with two ends thereof in the x axis direction being the same pole. In addition, the permanent magnets 711 and 712 are disposed to face the negative electrode member 4 in a manner that a distance L from permanent magnets 711 and 712 to the surface of the negative electrode member 4 on the side of the substrate 20 is 200 mm or less.

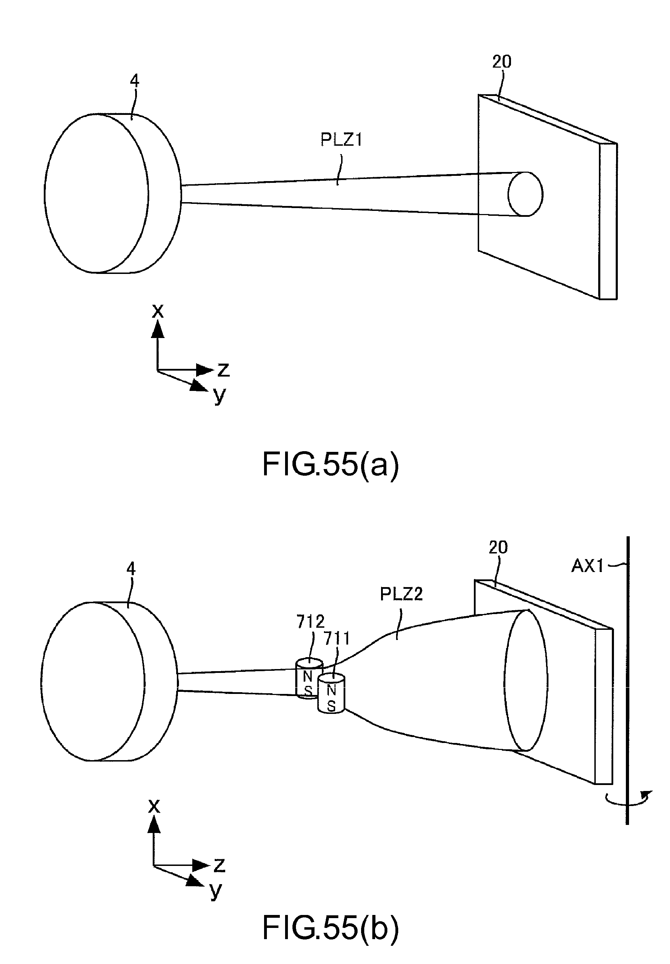

FIG. 55(a) and FIG. 55(b) are conceptual diagrams illustrating the function of the permanent magnets 711 and 712 shown in FIG. 53. With reference to FIG. 55(a), in a case where the permanent magnets 711 and 712 are not disposed between the negative electrode member 4 and the substrate 20, when a negative voltage is applied to the negative electrode member 4 and the trigger electrode 8 contacts the protrusion 42 of the negative electrode member 4 and is then separated therefrom, an arc discharge is generated at the moment the trigger electrode 8 is separated from the protrusion 42 of the negative electrode member 4. A beam-shaped plasma PLZ1 is emitted from the protrusion 42 of the negative electrode member 4 in a direction toward the substrate 20. A diameter of the beam-shaped plasma PLZ1 on the surface of the substrate 20 is tens of mmϕ to 100 mmϕ (see FIG. 55(a)), for example.

In a case where the permanent magnets 711 and 712 are disposed in the plasma PLZ1 by moving the supporting member 713 in the x axis direction, the beam-shaped plasma PLZ1 emitted from the protrusion 42 of the negative electrode member 4 is diffused by the two permanent magnets 711 and 712 in the x axis direction (the direction from the bottom surface to the ceiling of the vacuum container 1). As a result, a plasma PLZ2 is formed (see FIG. 55(b)).

Because the substrate 20 is rotated around a central axis AX1 (the central axis of the support portion 710B) disposed along the direction from the bottom surface to the ceiling of the vacuum container 1, the plasma PLZ2 is emitted to the entire surface of the substrate 20. Accordingly, the beam-shaped plasma PLZ1 is diffused by the permanent magnets 711 and 712 to form a carbon thin film over a wide area.

As described, the two permanent magnets 711 and 712 are disposed in the plasma PLZ1 between the negative electrode member 4 and the substrate 20 and are substantially in parallel with the length direction thereof being along the direction from the bottom surface to the ceiling of the vacuum container 1.

Although diffusion of the beam-shaped plasma PLZ1 in the y axis direction due to the permanent magnets 711 and 712 disposed between the negative electrode member 4 and the substrate 20 is not confirmed, the plasma PLZ1 may also diffuse in the y axis direction.

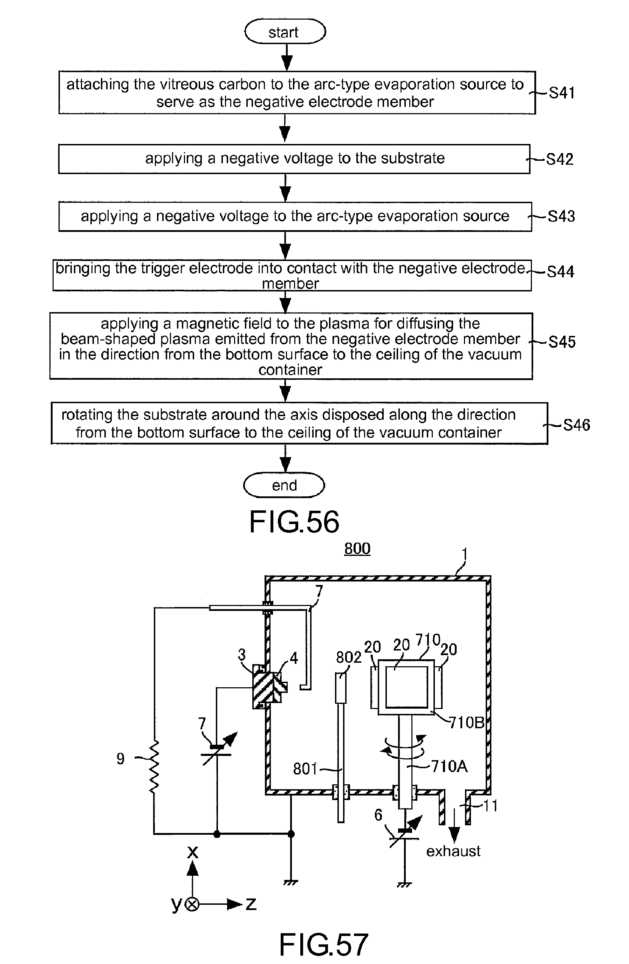

FIG. 56 is a flow chart showing the carbon thin film manufacturing method using the plasma device 700 shown in FIG. 53. With reference to FIG. 56, when the production of a carbon thin film starts, the vitreous carbon is attached to the arc-type evaporation source 3 to serve as the negative electrode member 4 (Step S41).

The vacuum container 1 is exhausted through the exhaust port 11 and the pressure in the vacuum container 1 is set to 5 × 10⁻⁴ Pa.

Then, a negative voltage of -10V to -300V is applied to the substrate 20 from the power source 6 (Step S42), and a negative voltage of -15V to -50V is applied to the arc-type evaporation source 3 from the power source 7 (Step S43).

The trigger electrode 8 is brought into contact with the protrusion 42 of the negative electrode member 4 by a reciprocating drive device (not shown) (Step S44). Thereafter, the trigger electrode 8 is separated from the protrusion 42 of the negative electrode member 4. By doing so, arc discharge starts at the moment the trigger electrode 8 is separated from the protrusion 42 of the negative electrode member 4, and an arc spot appears on the surface of the protrusion 42 of the negative electrode member 4.

By moving the supporting member 713 in the x axis direction (the direction from the bottom surface to the ceiling of the vacuum container 1) to dispose the two permanent magnets 711 and 712 in the plasma PLZ1, the magnetic field is applied to the plasma PLZ1 for diffusing the beam-shaped plasma PLZ1 emitted from the protrusion 42 of the negative electrode member 4 in the direction from the bottom surface to the ceiling of the vacuum container 1 (Step S45).

Thereafter, the substrate 20 is rotated around the axis (the central axis AX1) disposed along the direction from the bottom surface to the ceiling of the vacuum container 1 (Step S46). Then, when a desired time elapses, the production of the carbon thin film is completed.

Like this, in the carbon thin film manufacturing process shown in FIG. 56, the magnetic field for diffusing the beam-shaped plasma PLZ1 in the direction from the bottom surface to the ceiling of the vacuum container 1 is applied to the plasma PLZ1 and the substrate 20 is rotated around the axis disposed along the direction from the bottom surface to the ceiling of the vacuum container 1 to form the carbon thin film on the substrate 20. Therefore, the carbon thin film is formed on the entire surface of the substrate 20.

Accordingly, the carbon thin film is formed over a wide area.

In the plasma device 10, the power source 6 may apply a voltage of 0V to the substrate 20. Moreover, even if the substrate 20 is not rotated, by using the magnetic field of the permanent magnets 711 and 712 to diffuse the plasma PLZ1, the carbon thin film may be formed over a wider area in comparison with simply using the plasma PLZ1. Therefore, the carbon thin film manufacturing method using the plasma device 700 may at least include Steps S41 and S43 to S45 as shown in FIG. 56. In addition, the plasma device 700 may not be provided with the rotating mechanism of the substrate 20.

The above illustrates that the plasma device 700 includes two permanent magnets 711 and 712. However, the eighth embodiment is not limited thereto, and the plasma device 700 may also be provided with two electromagnets disposed in the same manner as the permanent magnets 711 and 712 to replace the permanent magnets 711 and 712.

Besides, the above illustrates that the permanent magnets 711 and 712 are disposed with two ends thereof in the x axis direction being the same pole. However, the eighth embodiment is not limited thereto, and the two ends in the x axis direction may also be different poles.

### [Ninth Embodiment]

FIG. 57 is a schematic diagram showing the structure of the plasma device according to the ninth embodiment. With reference to FIG. 57, a plasma device 800 of the ninth embodiment is the same as the plasma device 700 except that the supporting member 713 of the plasma device 700 of FIG. 53 is replaced by a supporting member 801, and the permanent magnets 711 and 712 are replaced by a permanent magnet 802.

A portion of the supporting member 801 passes through the bottom surface of the vacuum container 1 to be disposed in the vacuum container 1 while the rest of the supporting member 801 is outside the vacuum container 1. In this case, an O-ring is disposed between the supporting member 801 and the bottom surface of the vacuum container 1.

The permanent magnet 802 is fixed to the supporting member 801. The permanent magnet 802 has the same shape and size as the permanent magnet 711.

The supporting member 801 is reciprocated along the x axis by a reciprocating drive device (not shown). Consequently, the permanent magnet 802 is reciprocated along the direction from the bottom surface to the ceiling of the vacuum container 1 between the negative electrode member 4 and the substrate 20.

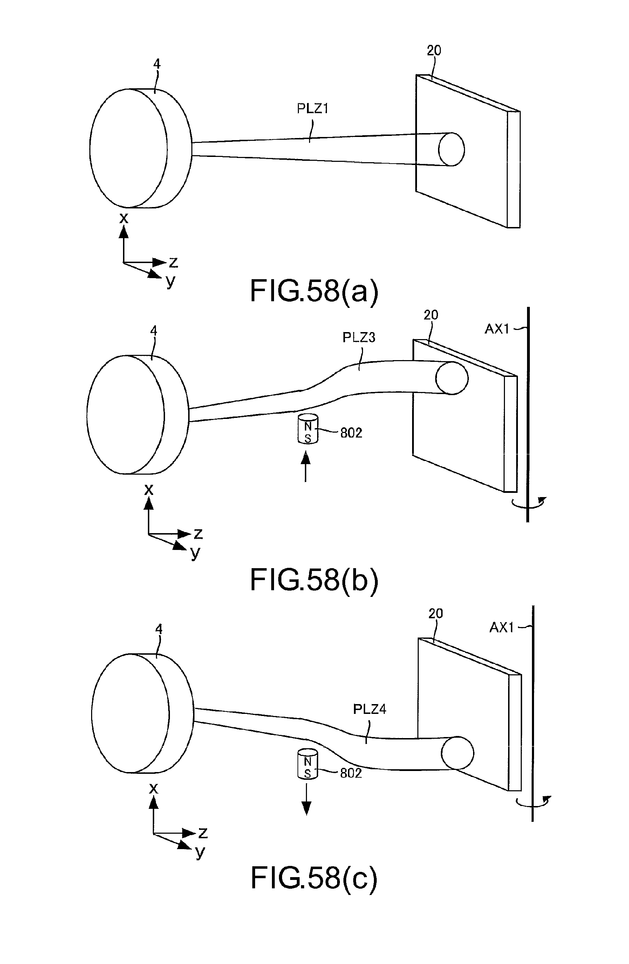

FIG. 58(a), FIG. 58(b), and FIG. 58(c) are diagrams illustrating the function of the permanent magnet 802 shown in FIG. 57. With reference to FIG. 58(a), FIG. 58(b), and FIG. 58(c), in a case where the permanent magnet 802 is not disposed between the negative electrode member 4 and the substrate 20, the plasma PLZ1 is generated as described above (see FIG. 58(a)).

When the supporting member 801 is moved in the positive direction of the x axis to bring the permanent magnet 802 close to the plasma PLZ1, the plasma PLZ1 is scanned in the positive direction of the x axis and a plasma PLZ3 is formed (see FIG. 58(b)).

Moreover, when the supporting member 801 is moved in the negative direction of the x axis to bring the permanent magnet 802 away from the plasma PLZ1, the plasma PLZ1 is scanned in the negative direction of the x axis and a plasma PLZ4 is formed (see FIG. 58(c)).

Accordingly, by reciprocating the permanent magnet 802 along the x axis with the supporting member 801 between the negative electrode member 4 and the substrate 20, the plasma PLZ1 is scanned along the x axis direction (the direction from the bottom surface to the ceiling of the vacuum container 1).

Then, the substrate 20 is rotated around the central axis AX1, as described above. As a result, the carbon thin film is formed on the entire surface of the substrate 20.

Accordingly, the carbon thin film is formed over a wide area.

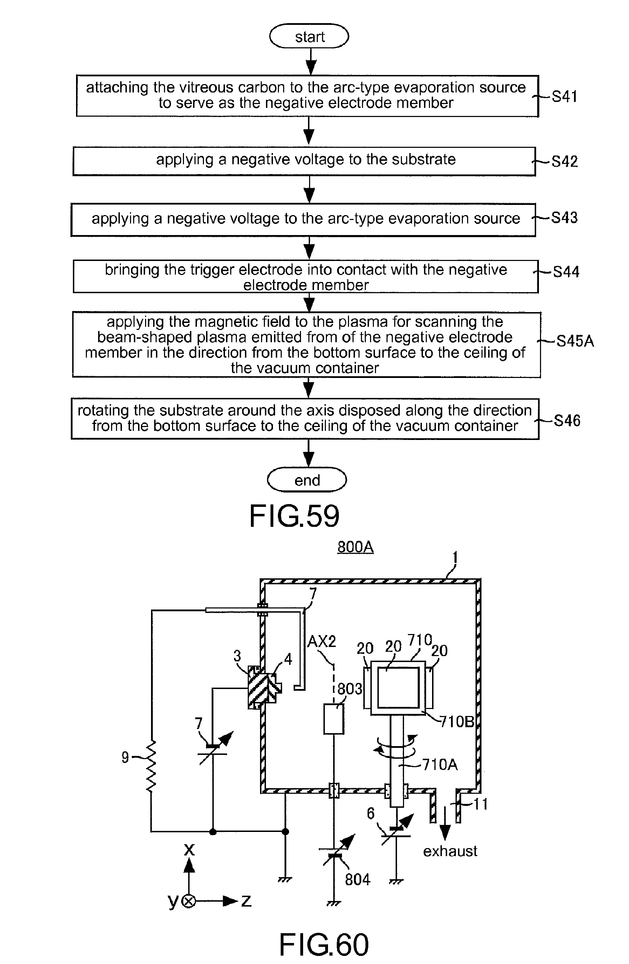

FIG. 59 is a flow chart showing the carbon thin film manufacturing method using the plasma device 800 shown in FIG. 57.

The flow chart of FIG. 59 is the same as the flow chart of FIG. 56 except that Step S45 in the flow chart of FIG. 56 is replaced by Step S45A.

With reference to FIG. 59, when the production of a carbon thin film starts, the aforementioned Steps S41 to S44 are performed sequentially.

After Step S44, the permanent magnet 802 is reciprocated in the direction from the bottom surface to the ceiling of the vacuum container 1 by the supporting member 801, and the magnetic field for scanning the beam-shaped plasma PLZ1 emitted from the protrusion 42 of the negative electrode member 4 in the direction from the bottom surface to the ceiling of the vacuum container 1 is applied to the plasma PLZ1 (Step S45A).

Thereafter, the aforementioned Step S46 is performed, and when a desired time elapses, the production of the carbon thin film is completed.

Like this, in the carbon thin film manufacturing process shown in FIG. 59, the magnetic field for scanning the beam-shaped plasma PLZ1 in the direction from the bottom surface to the ceiling of the vacuum container 1 is applied to the plasma PLZ1 and the substrate 20 is rotated around the axis disposed along the direction from the bottom surface to the ceiling of the vacuum container 1 to form the carbon thin film on the substrate 20. Therefore, the carbon thin film is formed on the entire surface of the substrate 20.

Accordingly, the carbon thin film may be formed over a wide area.

In the plasma device 800, the power source 6 may apply a voltage of 0V to the substrate 20. Moreover, even if the substrate 20 is not rotated, by using the magnetic field of the permanent magnet 802 to scan the plasma PLZ1, the carbon thin film may be formed over a wider area in comparison with simply using the plasma PLZ1. Therefore, the carbon thin film manufacturing method using the plasma device 800 may at least include Steps S41, S43, S44, and S45A as shown in FIG. 59.

FIG. 60 is a schematic diagram showing the structure of another plasma device according to the ninth embodiment. The plasma device of the ninth embodiment may be a plasma device 800A as shown in FIG. 60.

With reference to FIG. 60, the plasma device 800A is the same as the plasma device 800 except that the supporting member 801 and the permanent magnet 802 of the plasma device 800 of FIG. 57 are replaced by a coil 803 and a power source 804.

The coil 803 is wound around a central axis AX2 disposed along the direction from the bottom surface to the ceiling of the vacuum container 1. The coil 803 is disposed between the negative electrode member 4 and the substrate 20.

The power source 804 is connected to the coil 803. The power source 804 applies a current that changes periodically in magnitude to the coil 803.

The coil 803 and the power source 804 constitute an electromagnet.

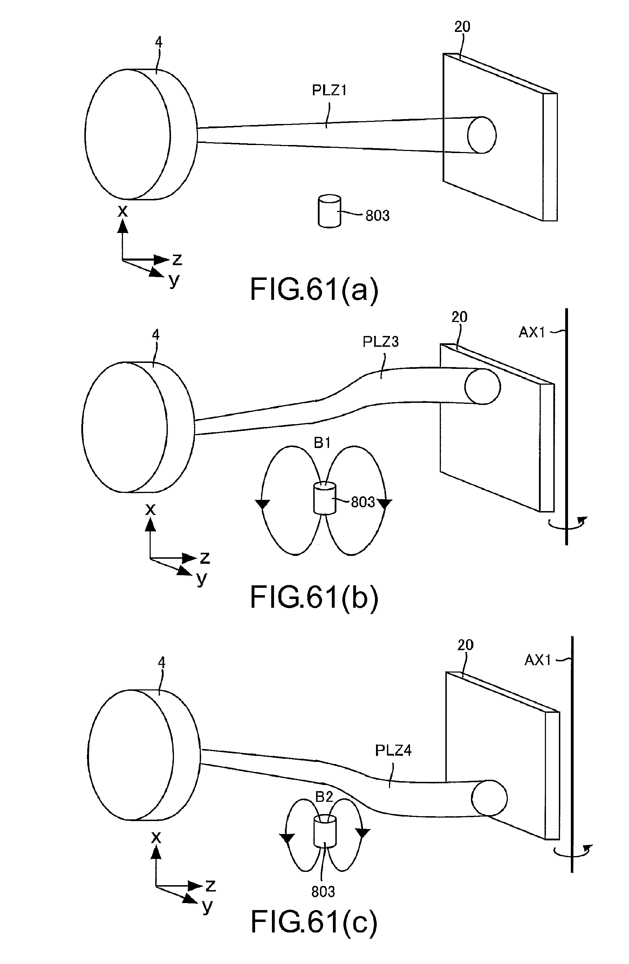

FIG. 61(a), FIG. 61(b), and FIG. 61(c) are diagrams illustrating the function of the electromagnet (the coil 803 and the power source 804) shown in FIG. 60. With reference to FIG. 61(a), FIG. 61(b), and FIG. 61(c), in a case where no current flows through the coil 803, no magnetic field exists between the negative electrode member 4 and the substrate 20, and therefore the plasma PLZ1 is generated as described above (see FIG. 61(a)).

When the power source 804 applies a current I1 to the coil 803, a magnetic field with a magnetic flux density B1 is generated. Consequently, the plasma PLZ1 is scanned in the positive direction of the x axis and the plasma PLZ3 is formed (see FIG. 61(b)).

In addition, when the power source 804 applies a current 12 (<I1) to the coil 803, a magnetic field with a magnetic flux density B2 (<B1) is generated. Consequently, the plasma PLZ1 is scanned in the negative direction of the x axis and the plasma PLZ4 is formed (see FIG. 61(c)).

Accordingly, by periodically changing the magnitude of the current applied to the coil 803 between the negative electrode member 4 and the substrate 20, the plasma PLZ1 is scanned along the x axis direction (the direction from the bottom surface to the ceiling of the vacuum container 1).

Then, the substrate 20 is rotated around the central axis AX1, as described above. As a result, the carbon thin film is formed on the entire surface of the substrate 20.

Accordingly, the carbon thin film may be formed over a wide area.

The carbon thin film manufacturing method using the plasma device 800A of FIG. 60 is carried out according to the flow chart of FIG. 59.

In this case, in Step S45A, the magnetic field for scanning the beam-shaped plasma PLZ1 emitted from the protrusion 42 of the negative electrode member 4 in the direction from the bottom surface to the ceiling of the vacuum container 1 is applied to the plasma PLZ1 by periodically changing the magnitude of the current applied to the coil 803.

Other descriptions of the ninth embodiment are the same as those of the eighth embodiment.

### [Tenth Embodiment]

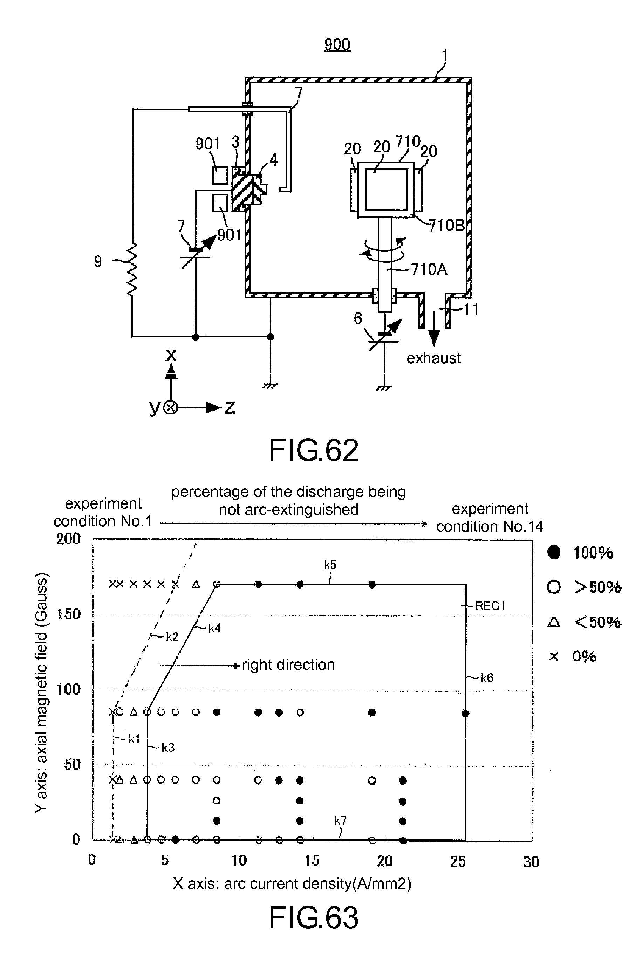

FIG. 62 is a schematic diagram showing the structure of the plasma device according to the tenth embodiment. With reference to FIG. 62, a plasma device 900 of the tenth embodiment is the same as the plasma device 800 except that the supporting member 801 and the permanent magnet 802 of the plasma device 800 of FIG. 57 are replaced by a permanent magnet 901.

The permanent magnet 901 has a ring shape and is disposed outside the vacuum container 1 and close to the arc-type evaporation source 3. More specifically, the permanent magnet 901 is disposed with the central axis thereof coinciding with the central axis of the arc-type evaporation source 3. The N pole of the permanent magnet 901 is on the side of the arc-type evaporation source 3 and the S pole thereof is on the side opposite to the arc-type evaporation source 3. Thus, the permanent magnet 901 is disposed on the side opposite to the substrate 20 with respect to the negative electrode member 4. The permanent magnet 901 applies an axial magnetic field (in the direction from the negative electrode member 4 to the substrate 20) with respect to the negative electrode member 4. A magnetization direction of the permanent magnet 901 may be the axial direction (the direction from the negative electrode member 4 to the substrate 20), and the S pole of the permanent magnet 901 may be on the side of the arc-type evaporation source 3.

### <Experiment 1>

An experiment was carried out to examine the percentage of the discharge being arc-extinguished and the percentage of the arc spot not moving.

### (Experimental Method)

The negative electrode member 4, including the main body 41 made of a sintered carbon (sintered graphite) IG510 (produced by Toyo Tanso Co., Ltd.) and the protrusion 42 made of a vitreous carbon GC20SS (produced by Tokai Fine Carbon Machining Co., Ltd.), was used. The diameter of the protrusion 42 is 2 mmΦ, 3 mmΦ, or 5.2 mmΦ.

The arc current was changed to 30A, 40A, 60A, 80A, 100A, and 150A, and the axial magnetic field was changed to 0Gauss, 13Gauss, 26Gauss, 40Gauss, 85Gauss, and 170Gauss. The arc current density (A/mm²) was determined by the arc current/(the cross-sectional area of the vitreous carbon (protrusion 42)). The axial magnetic field was obtained by measuring the value at the tip of the protrusion 42 using a gauss meter (Model 410-SCT produced by Lake Shore Cryotronics, Inc.). When the axial magnetic field was changed to 13Gauss, 26Gauss, 40Gauss, 85Gauss, and 170Gauss, the magnetic field in the radial direction of the protrusion 42 was 2Gauss, 5Gauss, 8Gauss, 14Gauss, and 32Gauss respectively.

The diameter of the vitreous carbon, the arc current, and the arc current density under the experimental conditions 1 to 14 are shown in Table 1.

**[Table 1]**

| Experiment Condition No. | Diameter of Vitreous Carbon (mm) | Arc Current (A) | Arc Current Density (A/mm²) |
|---|---|---|---|
| 1 | 5.2 | 30 | 1.413 |
| 2 | 5.2 | 40 | 1.884 |
| 3 | 5.2 | 60 | 2.827 |
| 4 | 5.2 | 80 | 3.769 |
| 5 | 5.2 | 100 | 4.711 |
| 6 | 3 | 40 | 5.662 |
| 7 | 5.2 | 150 | 7.067 |
| 8 | 3 | 60 | 8.493 |
| 9 | 3 | 80 | 11.323 |
| 10 | 2 | 40 | 12.739 |
| 11 | 3 | 100 | 14.154 |
| 12 | 2 | 60 | 19.108 |
| 13 | 3 | 150 | 21.231 |
| 14 | 2 | 80 | 25.478 |

The experiment was carried out N times (N = 3-7) based on each of the experimental conditions 1 to 14 shown in Table 1.

The vacuum container 1 was exhausted by an exhaust device (not shown) until 9.9 × 10-3Pa was reached and the protrusion 42 of the negative electrode member 4 including the vitreous carbon was arc-ignited to discharge, and then whether the discharge is not arc-extinguished and whether the arc spot does not move within 60 seconds were confirmed.

### (Experiment Result)

FIG. 63 is a diagram showing the relation between the axial magnetic field and the arc current density based on the percentage of the discharge being not arc-extinguished.

In FIG. 63, the vertical axis represents the axial magnetic field and the horizontal axis represents the arc current density. In addition, • indicates the relation between the axial magnetic field and the arc current density where the percentage of the discharge being not arc-extinguished is 100%; ○ indicates the relation between the axial magnetic field and the arc current density where the percentage of the discharge being not arc-extinguished is greater than 50%; Δ indicates the relation between the axial magnetic field and the arc current density where the percentage of the discharge being not arc-extinguished is smaller than 50%; and × indicates the relation between the axial magnetic field and the arc current density where the percentage of the discharge being not arc-extinguished is 0%. The percentage of the discharge being not arc-extinguished was determined by the following: (the number of times that the discharge was not arc-extinguished under the same condition)/(the total number of times N under the same condition) × 100%. Moreover, the arc current density is defined as x and the axial magnetic field is defined as y.

With reference to FIG. 63, when the axial magnetic field y is set to 0Gauss to reduce the arc current density, at the arc current density of 1.413A/mm², the percentage of the discharge not being arc-extinguished becomes 0% (that is, the percentage of the discharge being arc-extinguished is 100%). Regarding the reason, it is considered that, when the arc current density is reduced, the vitreous carbon of the protrusion 42 itself or the arc spot portion formed by the discharge is not sufficiently heated and thus it is difficult to release thermal electrons. Moreover, when the axial magnetic field is applied, a force is generated to move the arc spot in the circumferential direction. Thus, it becomes easier to extinguish. When the axial magnetic field is 170Gauss, even though the arc current density is 5.662A/mm², the percentage of the discharge being not arc-extinguished becomes 0%.

Here, it is assumed that a straight line connecting a point where the arc current density is 1.413A/mm² and the axial magnetic field is 0Gauss and a point where the arc current density is 1.413A/mm² and the axial magnetic field is 85Gauss is k1, and a straight line connecting a point where the arc current density is 1.413A/mm² and the axial magnetic field is 85Gauss and a point where the arc current density is 5.662A/mm² and the axial magnetic field is 170Gauss is k2. The straight line 2 is represented by y-20.008x + 56.723. Therefore, in the region on the right side of the straight line k1 and the straight line k2, the percentage of the discharge being not arc-extinguished is greater than 0.

In addition, in a region REG1, the percentage of the discharge being not arc-extinguished is greater than 50%. Here, it is assumed that there are straight lines k3 to k7. The straight line k3 is represented by x = 3.769A/mm². The straight line k4 is represented by y = 17.9932x + 17.1836. The straight line k5 is represented by y = 170Gauss. The straight line k6 is represented by x = 25.478A/mm². The straight line k7 is represented by y = 0Gauss.

Accordingly, the region REG1 includes the straight lines k3 to k7 and the region surrounded by the straight lines k3 to k7.

Therefore, the arc discharge is generated in the condition that the arc current density and the axial magnetic field fall into the region on the right side of the straight line k1 and the straight line k2.

Preferably, the arc discharge is generated using the arc current density and the axial magnetic field that fall on the straight lines k3 to k7 or the arc current density and the axial magnetic field that fall in the region surrounded by the straight lines k3 to k7.

Thereby, the percentage of the discharge being not arc-extinguished may be made greater than 0%, or preferably greater than 50%.

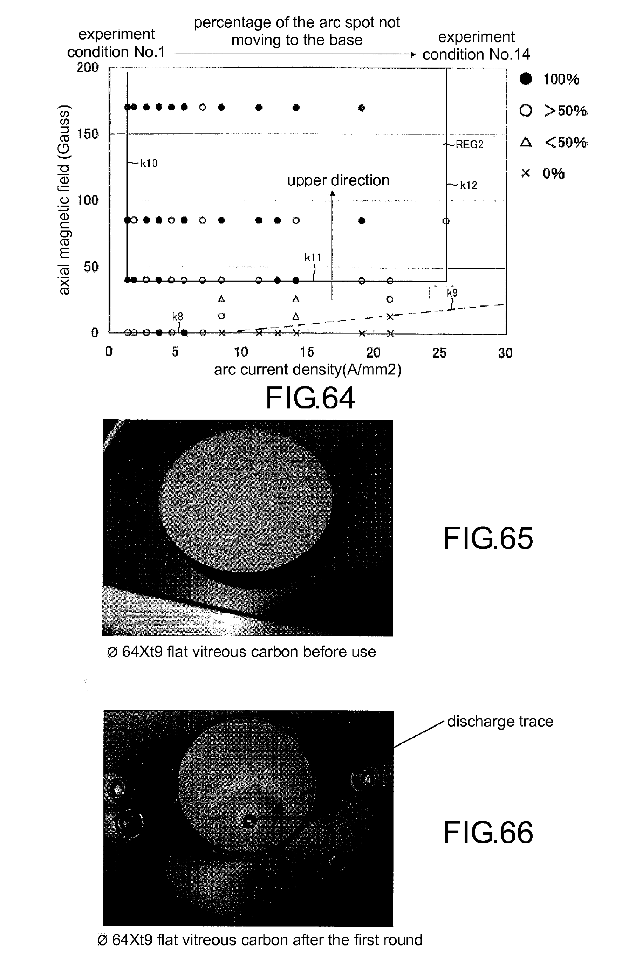

FIG. 64 is a diagram showing the relation between the axial magnetic field and the arc current density based on the percentage of the arc spot not moving to the main body 41.

In FIG. 64, the vertical axis represents the axial magnetic field and the horizontal axis represents the arc current density. In addition, • indicates the relation between the axial magnetic field and the arc current density where the percentage of the arc spot not moving to the main body 41 is 100%; ○ indicates the relation between the axial magnetic field and the arc current density where the percentage of the arc spot not moving to the main body 41 is greater than 50%; Δ indicates the relation between the axial magnetic field and the arc current density where the percentage of the arc spot not moving to the main body 41 is smaller than 50%; and × indicates the relation between the axial magnetic field and the arc current density where the percentage of the arc spot not moving to the main body 41 is 0%. The percentage of the arc spot not moving to the main body 41 was determined by the following: (the number of times of the arc spot not moving to the main body 41 under the same condition)/(the total number of times N under the same condition) × 100%. Moreover, the arc current density is defined as x and the axial magnetic field is defined as y.

With reference to FIG. 64, if the arc current density is increased while the axial magnetic field is 0Gauss, at 8.493A/mm², the percentage of the arc spot not moving to the main body 41 becomes 0% (that is, the percentage that the arc spot moves is 100%).

Regarding the reason, it is considered that when the arc current density is increased to 8.493A/mm², the force, which moves the arc spot toward the side of the main body 41 due to the magnetic field formed when the arc current flows through the vitreous carbon of the protrusion 42, is greater than the force that continues the discharge at the protrusion 42. Regarding this, it is effective to apply the axial magnetic field to generate the force for moving the arc spot in the circumferential direction of the protrusion 42, and even if the arc current density is 21.231A/mm², the movement of the arc spot to the main body 41 may be suppressed by setting the transverse magnetic field to 26Gauss.

Here, it is assumed that a straight line connecting a point where the arc current density is 1.413A/mm² and the axial magnetic field is 0Gauss and a point where the arc current density is 8.493A/mm² and the axial magnetic field is 0Gauss is k8, and a straight line connecting a point where the arc current density is 8.493A/mm² and the axial magnetic field is 0Gauss and a point where the arc current density is 21.231A/mm² and the axial magnetic field is 13Gauss is k9. The straight line k9 is represented by y = 1.021x-8.667. Thus, by using the axial magnetic field and the arc current density on the straight line k8 or in the region on the upper side of the straight line k8 and the straight line k9, the percentage of the arc spot not moving to the main body 41 becomes greater than 0%.

Moreover, in a region REG2, the percentage of the arc spot not moving to the main body 41 is greater than 50%. Here, it is assumed that there are straight lines k10 to k12. The straight line k10 is represented by x = 1.413A/mm². The straight line k11 is represented by y = 40Gauss. The straight line k12 is represented by x = 25.478A/mm².

Accordingly, the region REG2 includes the straight lines k10 to k12 and the region surrounded by the straight lines k10 to k12.

Therefore, the arc discharge is generated in the condition that the arc current density and the axial magnetic field fall on the straight line k8 or in the region on the upper side of the straight line k8 and the straight line k9.

Preferably, the arc discharge is generated using the arc current density and the axial magnetic field that fall on the straight lines k10 to k12 or the arc current density and the axial magnetic field that fall in the region surrounded by the straight lines k10 to k12.

Thereby, the percentage of the arc spot not moving to the main body 41 may be made greater than 0%, or preferably greater than 50%.

According to the results shown in FIG. 63 and FIG. 64, by using the axial magnetic field and the arc current density that fall in the region on the right side of the straight line k1 and the straight line k2, and on the straight line k8 or in the region on the upper side of the straight line k8 and the straight line k9, the percentage of the discharge being not arc-extinguished may be greater than 0% and the percentage of the arc spot not moving to the main body 41 may be greater than 0%. Consequently, the carbon thin film may be manufactured stably.

As described above, it is demonstrated that, by using the permanent magnet 901 to apply the axial magnetic field, the percentage of the discharge being not arc-extinguished may be made greater than 0% and the percentage of the arc spot not moving to the main body 41 may be made greater than 0%.

### <Experiment 2>

The experiment was carried out to examine whether the negative electrode member cracks due to the arc discharge.

### (i) in the case of using a flat vitreous carbon

A flat vitreous carbon (GC20SS, produced by Tokai Fine Carbon Machining Co., Ltd.) having a diameter of 64 mmΦ and a thickness of 9 mm was used as the negative electrode member. In addition, a sintered graphite (IG510, produced by Toyo Tanso Co., Ltd.) having a diameter of 64 mmΦ and a thickness of 11 mm was used as the base (= the main body 41). A configuration with the sintered graphite disposed on the backing plate and the vitreous carbon disposed on the sintered graphite was disposed on the arc-type evaporation source 3.

Then, the vacuum container 1 was exhausted by an exhaust device (not shown) until 9.9 × 10⁻³Pa was reached, and the surface of the vitreous carbon was arc-ignited to discharge by an arc current of 80A.

FIG. 65 is a perspective view of the vitreous carbon before discharge. With reference to FIG. 65, the vitreous carbon has an even surface before discharge.

FIG. 66 is a view of the vitreous carbon after the first discharge is completed. Sparkless discharge continued for 131 seconds after the discharge arc-ignition and then arc-extinguished. Rearc-ignition was performed but was not successful. Therefore, the vacuum container 1 was opened to atmosphere for observation. The depth of the discharge trace was about 4 mm, and a plurality of streaky micro-cracks were observed on the bottom of the discharge trace (the base side). It is considered that only the portion near the arc spot was heated, which resulted in partial heat distortion and heat stress and led to the occurrence of the micro-cracks.

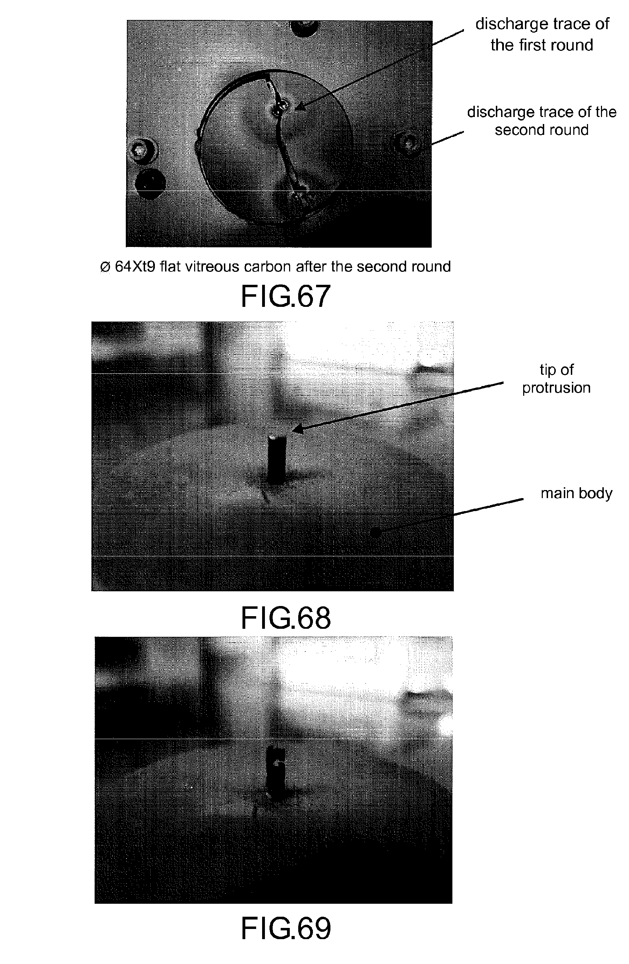

FIG. 67 is a view of the vitreous carbon after the second discharge is completed. Discharge arc-ignition was carried out at a position different from that in the first experiment, and sparkless discharge continued for 35 seconds and then arc-extinguished with an abnormal noise. Rearc-ignition was performed but was not successful. Therefore, the vacuum container 1 was opened to atmosphere for observation. Two cracks were generated from the discharge trace of the second embodiment, wherein one directly reached the outer circumferential edge and the other reached the outer circumferential edge through the discharge trace of the first experiment. In addition, the two cracks both reached the depth of 9 mm. Due to the two cracks, the flat vitreous carbon having the diameter of 64 mmΦ and the thickness of 9 mm was completely damaged and became unusable.

It is considered that the abnormal noise resulted from the generation of the two cracks. Moreover, it is considered that only the portion near the arc spot was heated, which resulted in partial heat distortion and heat stress and led to the occurrence of the two cracks.

In comparison with the first experiment, the duration became extremely short, i.e. about 1/4. Regarding the reason, it is considered that due to the first experiment (discharge), the micro-cracks were also generated outside the bottom of the discharge trace and made the vitreous carbon very fragile. Accordingly, it is considered that the first experiment has caused substantial damage, and it is very difficult to use the flat vitreous carbon without damaging it.

### (ii) in the case of using a columnar vitreous carbon

A vitreous carbon (GC20SS, produced by Tokai Fine Carbon Machining Co., Ltd.) having a diameter of 3 mmΦ and a length of 60 mm was used as the protrusion 42 and a sintered graphite (IG510, produced by Toyo Tanso Co., Ltd.) having a diameter of 64 mmΦ and a thickness of 20 mm was used as the main body 41. In addition, a ring-shaped magnet (NR0018, produced by Magnet Japan Ltd.) made of neodymium and having an outer diameter of 59 mm, an inner diameter of 19 mm, and a thickness of 10 mm was used as the permanent magnet 901.

The permanent magnet 901 was disposed on the backing plate, the main body 41 was disposed on the permanent magnet 901, and the protrusion 42 was disposed on the main body 41.

In this case, the magnetic field intensity in the axial direction at the tip of the protrusion 41 was 112Gauss and the magnetic field intensity in the radial direction was 13Gauss. At a position that was on the side of the main body 41 and 30 mm away from the tip of the protrusion 42, the magnetic field intensity in the axial direction was 350Gauss and the magnetic field intensity in the radial direction was 45Gauss. The values of these magnetic field intensities were measured by a gauss meter (Model 410-SCT produced by Lake Shore Cryotronics, Inc.).

The vacuum container 1 was exhausted by an exhaust device (not shown) until 9.9 × 10⁻³Pa was reached and the tip of the protrusion 42 was arc-ignited to discharge by an arc current of 80A.

### (Experiment Result)

FIG. 68 is a view of the negative electrode member 4 before discharge. With reference to FIG. 68, the protrusion 42 is disposed on the center of the main body 41. Moreover, the main body 41 and the protrusion 42 having smooth surfaces with no crack, etc. thereon. The negative electrode member 4 before discharge, as shown in FIG. 68, is one specific example and the protrusion 42 has a diameter of 3 mmϕ and a length of 10 mm in the example of the photo.

When the tip of the protrusion 42 was arc-ignited to discharge, sparkless discharge continued for 484 seconds. Then, the discharge was forced to extinguish by stopping the arc power. It did not extinguish during the discharge nor did the arc spot move to the main body 41. It is confirmed that the sparkless discharge was very stable and lasted for a long time. After the experiment, the vacuum container 1 was opened to the atmosphere for observation, and the result showed that the negative electrode material was consumed with a remainder of 3 mm.

It is considered that, by setting the diameter of the vitreous carbon of the negative electrode member 4 to 3 mmϕ, particularly, partial heat distortion and heat stress in the radial direction were alleviated. Therefore, cracking or damage that occurred on the flat vitreous carbon was suppressed, and the sparkless discharge continued very stably for a long time.

According to the foregoing result, forming the shape of the vitreous carbon into the protrusion is effective and may achieve stable sparkless discharge for a long time.

### <Experiment 3>

The discharge trace was examined. Regarding the structure of the negative electrode member 4, the diameter of the protrusion 42 was set to 2 mmϕ, 3 mmϕ, and 5.2 mmϕ. In this case, the magnetic field intensity in the axial direction at the tip of the protrusion 42 was 85Gauss and the magnetic field intensity in the radial direction was 14Gauss. The values of these magnetic field intensities were measured by a gauss meter (Model 410-SCT produced by Lake Shore Cryotronics, Inc.).

The vacuum container 1 was exhausted by an exhaust device (not shown) until 9.9 × 10⁻³Pa was reached and the tip of the protrusion 42 was arc-ignited to discharge by each set arc current. Then, after each set time has elapsed, the discharge was forced to extinguish by stopping the arc power.

Here, when the vitreous carbon having the diameter of 3 mmϕ was used, the arc current was 80A and the duration of sparkless discharge was 60 seconds. In addition, when the vitreous carbon having the diameter of 5.2 mmϕ was used, the arc current was 100A and the duration of sparkless discharge was 120 seconds. Further, when the vitreous carbon having the diameter of 2 mmϕ was used, the arc current was 40A and the duration of sparkless discharge was 60 seconds.

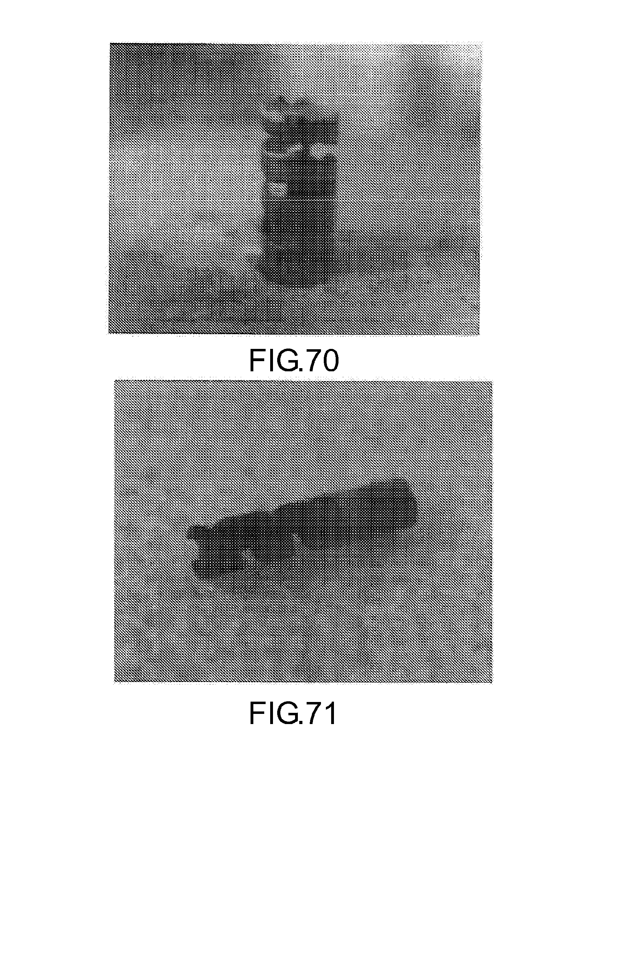

FIG. 69 is a view of the protrusion 42 after discharge, which uses the vitreous carbon (protrusion 42) having the diameter of 3 mmϕ. FIG. 70 is a view of the protrusion 42 after discharge, which uses the vitreous carbon (protrusion 42) having the diameter of 5.2 mmϕ. FIG. 71 is a view of the protrusion 42 after discharge, which uses the vitreous carbon (protrusion 42) having the diameter of 2 mmϕ.

No matter the diameter of the vitreous carbon (protrusion 42) was set to 2 mmϕ, 3 mmϕ, or 5.2 mmϕ, the discharge status was sparkless discharge only. The discharge did not extinguish nor did the arc spot move to the main body 41. After the discharge, a spiral discharge trace was formed in the protrusion 42 (see FIG. 69 to FIG. 71).

As described above, when the negative electrode member 4 including the protrusion 42 is used to generate the arc discharge, due to the magnetic field of the permanent magnet 901, the arc spot moves spirally on the surface of the protrusion 42. Consequently, the discharge did not extinguish and the arc spot did not move to the main body 41. Accordingly, formation of the spiral discharge trace in the protrusion 42 after discharge shows that the discharge did not extinguish and the arc spot did not move to the main body 41.

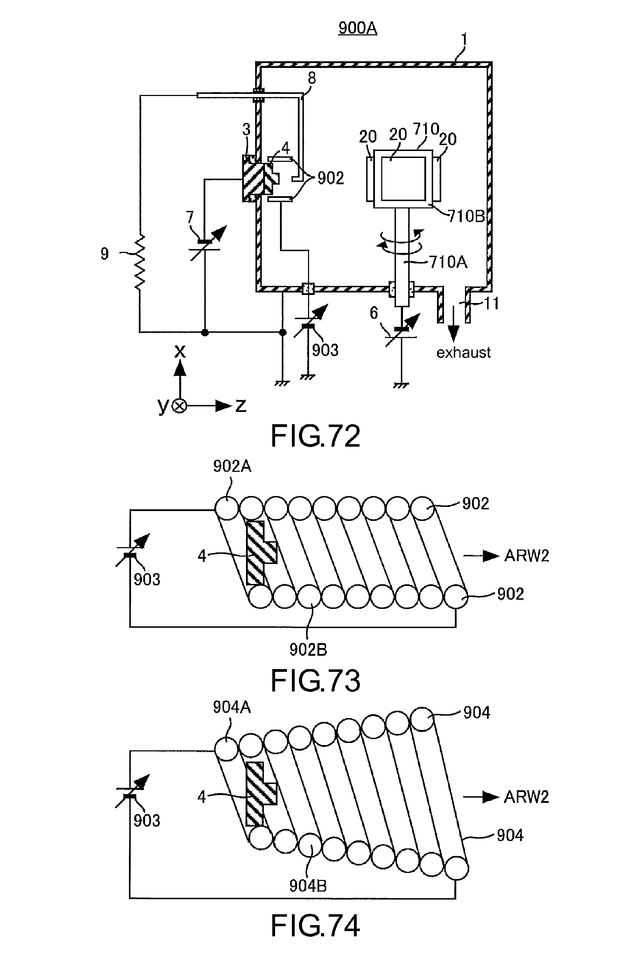

FIG. 72 is a schematic diagram showing the structure of another plasma device according to the tenth embodiment. The plasma device of the tenth embodiment may be a plasma device 900A as shown in FIG. 72.

With reference to FIG. 72, the plasma device 900A is the same as the plasma device 900 except that the permanent magnet 901 of the plasma device 900 of FIG. 62 is replaced by a coil 902 and a power source 903.

The coil 902 is disposed in the vacuum container 1 to surround the negative electrode member 4. The power source 903 is connected to the coil 902. The power source 903 applies a desired current to the coil 902.

FIG. 73 is an enlarged diagram of the negative electrode member 4 and the coil 902 shown in FIG. 72. With reference to FIG. 73, the coil 902 is wound a desired number of times. The negative electrode member 4 is disposed in the coil 902 with the central axis coinciding with the central axis of the coil 902. In other words, the negative electrode member 4 is surrounded by the coil 902. The power source 903 is connected between one end and the other end of the coil 902.

The power source 903 applies the desired current to the coil 902 for the coil 902 to generate a magnetic field. When the current flowing through an upper portion 902A of the coil 902 is in the direction from the far side to the near side of the paper surface of FIG. 73 and the current flowing through a lower portion 902B of the coil 902 is in the direction from the near side to the far side of the paper surface of FIG. 73, the magnetic field is generated in the coil 902 in the direction of the arrow ARW2 (the z axis direction). Consequently, the coil 902 applies the magnetic field in the axial direction to the protrusion 42 of the negative electrode member 4.

Therefore, as described above, the discharge is not arc-extinguished and the arc spot does not move to the main body 41, and stable sparkless discharge may be achieved for a long time.

In the plasma device 900A, the magnetic field may also be generated in the direction (the z axis direction) opposite to the arrow ARW2. In that case, the current in the direction from the near side to the far side of the paper surface of FIG. 73 is applied to the upper portion 902A of the coil 902 and the current in the direction from the far side to the near side of the paper surface of FIG. 73 is applied to the lower portion 902B of the coil 902. Since the axial magnetic field is applied to the negative electrode member 4, the aforementioned effect may be achieved.

Thus, in the plasma device 900A, the magnetic field in the direction from the negative electrode member 4 to the substrate 20 or the magnetic field in the direction from the substrate 20 to the negative electrode member 4 may be applied to the negative electrode member 4. Generally, it is fine to apply the magnetic field in the axial direction (the z axis direction) to the negative electrode member 4.

FIG. 74 is a diagram showing another coil according to the tenth embodiment. The plasma device 900A may be provided with a coil 904, as shown in FIG. 74, in place of the coil 902.

With reference to FIG. 74, the diameter of the coil 904 increases in the direction of the arrow ARW2. The negative electrode member 4 is disposed in the coil 904 with the central axis coinciding with the central axis of the coil 904.

By applying a current in the direction from the far side to the near side of the paper surface of FIG. 74 to an upper portion 904A of the coil 904 and applying a current in the direction from the near side to the far side of the paper surface of FIG. 74 to a lower portion 904B of the coil 904, the coil 904 generates a magnetic field in the direction of the arrow ARW2 (the z axis direction) therein. Moreover, by applying the current in the direction from the near side to the far side of the paper surface of FIG. 74 to the upper portion 904A of the coil 904 and applying the current in the direction from the far side to the near side of the paper surface of FIG. 74 to the lower portion 904B of the coil 904, the coil 904 generates a magnetic field in the direction opposite to the arrow ARW2 (the z axis direction) therein.

Therefore, even though the coil 904 has a diameter that increases from the negative electrode member 4 toward the substrate 20, the discharge is not arc-extinguished and the arc spot does not move to the main body 41, and stable sparkless discharge may be achieved for a long time.

Nevertheless, the plasma device 900A may also be provided with a coil that has a diameter decreasing from the negative electrode member 4 toward the substrate 20.

Besides, in the plasma device 900A, the coils 902 and 904 may be disposed on the side opposite to the substrate 20 with respect to the negative electrode member 4 outside the vacuum container 1.

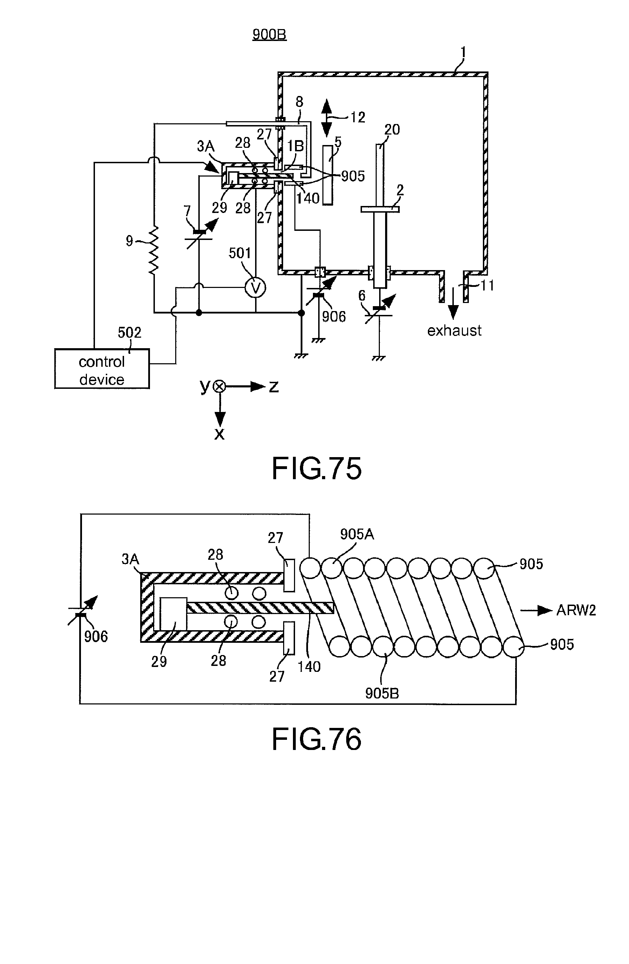

FIG. 75 is a structural diagram showing the structure of yet another plasma device according to the tenth embodiment. The plasma device of the tenth embodiment may be a plasma device 900B as shown in FIG. 75.

With reference to FIG. 75, the plasma device 900B is the same as the plasma device 200 except that a coil 905 and a power source 906 are further added to the plasma device 200 of FIG. 37.

The coil 905 is disposed in the vacuum container 1 to surround a portion of the negative electrode member 140. The power source 906 is connected to the coil 905. The power source 906 applies a desired current to the coil 905.

FIG. 76 is an enlarged diagram of the arc-type evaporation source 3A, the negative electrode member 140, and the coil 905 shown in FIG. 75. With reference to FIG. 76, the coil 905 has the same structure as the coil 902 shown in FIG. 73. A portion of the negative electrode member 140 on the tip portion side is disposed in the coil 905 with the central axis coinciding with the central axis of the coil 905. In other words, a portion of the negative electrode member 140 is surrounded by the coil 905. The power source 906 is connected between one end and the other end of the coil 905.

The power source 906 applies the desired current to the coil 905 for the coil 905 to generate a magnetic field. When the current flowing through an upper portion 905A of the coil 905 is in the direction from the far side to the near side of the paper surface of FIG. 76 and the current flowing through a lower portion 905B of the coil 905 is in the direction from the near side to the far side of the paper surface of FIG. 76, a magnetic field is generated in the coil 905 in the direction of the arrow ARW2 (the z axis direction). Consequently, the coil 905 applies the magnetic field in the axial direction to the negative electrode member 140. When the tip portion of the negative electrode member 140 is consumed, the delivery mechanism 29 sends the negative electrode member 140 toward the side of the substrate 20 to keep the tip portion of the negative electrode member 140 (the tip portion on the side of the substrate 20) at the same position before consumption. Therefore, a constant magnetic field is applied to the tip portion of the negative electrode member 140.

Accordingly, the discharge is not arc-extinguished and the arc spot does not move outside the negative electrode member 140, and stable sparkless discharge may be achieved for a long time.

In the plasma device 900B, the magnetic field may also be generated in the direction (the z axis direction) opposite to the arrow ARW2. In that case, the current in the direction from the near side to the far side of the paper surface of FIG. 76 is applied to the upper portion 905A of the coil 905 and the current in the direction from the far side to the near side of the paper surface of FIG. 76 is applied to the lower portion 905B of the coil 905. Since the axial magnetic field is applied to the negative electrode member 140, the aforementioned effect may be achieved.

In addition, the plasma device 900B may be provided with the coil 904, as shown in FIG. 74, in place of the coil 905.

Furthermore, in the plasma device 900B, the coil 905 or the coil 904 may be disposed on the side opposite to the substrate 20 with respect to the negative electrode member 140 outside the vacuum container 1.

Thus, in the plasma device 900B, the magnetic field in the direction from the negative electrode member 140 to the substrate 20 or the magnetic field in the direction from the substrate 20 to the negative electrode member 140 may be applied to the negative electrode member 140. Generally, it is fine to apply the magnetic field in the axial direction (the z axis direction) to the negative electrode member 140.

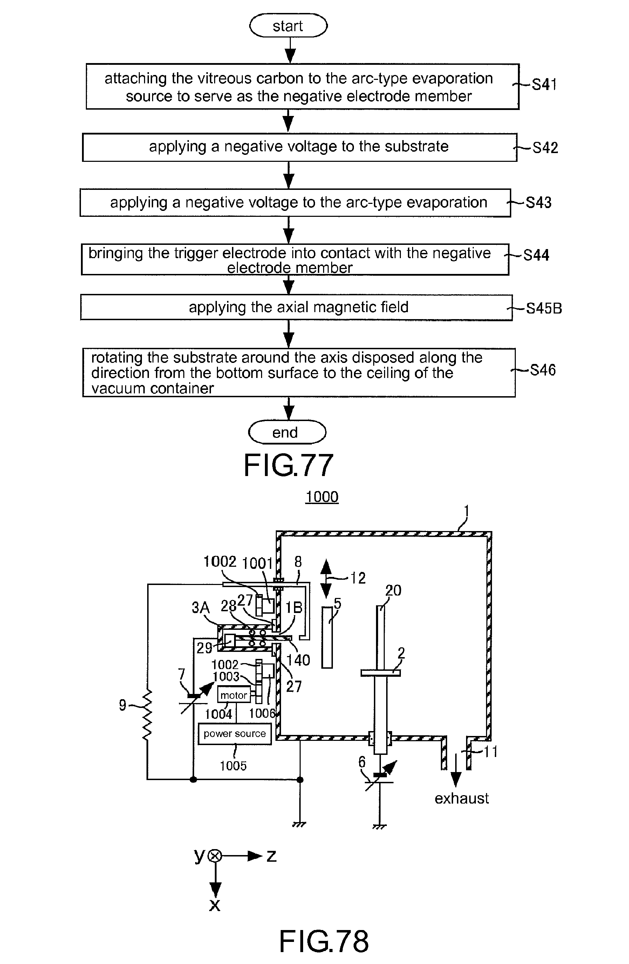

FIG. 77 is a flow chart showing the carbon thin film manufacturing method using the plasma device 900 shown in FIG. 62.

The flow chart of FIG. 77 is the same as the flow chart of FIG. 56 except that Step S45 in the flow chart of FIG. 56 is replaced by Step S45B.

With reference to FIG. 77, when the production of a carbon thin film starts, the aforementioned Steps 41 to S44 are performed sequentially. After Step S44, the axial magnetic field is applied (Step S45B). Thereafter, the aforementioned Step S46 is performed, and the production of the carbon thin film is completed.

The carbon thin film manufacturing method using the plasma device 900A of FIG. 72 and the plasma device 900B of FIG. 75 is carried out according to Steps S41 to S44, S45B, and S46 in the flow chart of FIG. 77.

By applying the axial magnetic field to the negative electrode member 4 (or the negative electrode member 140), the discharge is not arc-extinguished and the arc spot does not move outside the protrusion 42 of the negative electrode member 4 (or the negative electrode member 140), and stable sparkless discharge may be achieved for a long time. By manufacturing the carbon thin film using Steps S41 to S44, S45B, and S46 in the flow chart of FIG. 77, the carbon thin film may be manufactured with high quality and low costs.

### [Eleventh Embodiment]

FIG. 78 is a schematic diagram showing the structure of the plasma device according to the eleventh embodiment. With reference to FIG. 78, a plasma device 1000 of the eleventh embodiment is the same as the plasma device 200 except that a permanent magnet 1001, gears 1002 and 1003, a motor 1004, a power source 1005, and a counterweight 1006 are further added to the plasma device 200 of FIG. 37.

The permanent magnet 1001 is disposed close to the side wall of the vacuum container 1 where the arc-type evaporation source 3A is fixed. The permanent magnet 1001 is disposed with the N pole on the side of the vacuum container 1 and the S pole on the side of the gear 1002, for example. The permanent magnet 1001 is fixed to the gear 1002.

The gear 1002 meshes with the gear 1003. The motor 1004 is connected with the gear 1003. The motor 1004 rotates the gear 1003 when driven by the power source 1005. The power source 1005 drives the motor 1004. The counterweight 1006 is fixed to the gear 1002.

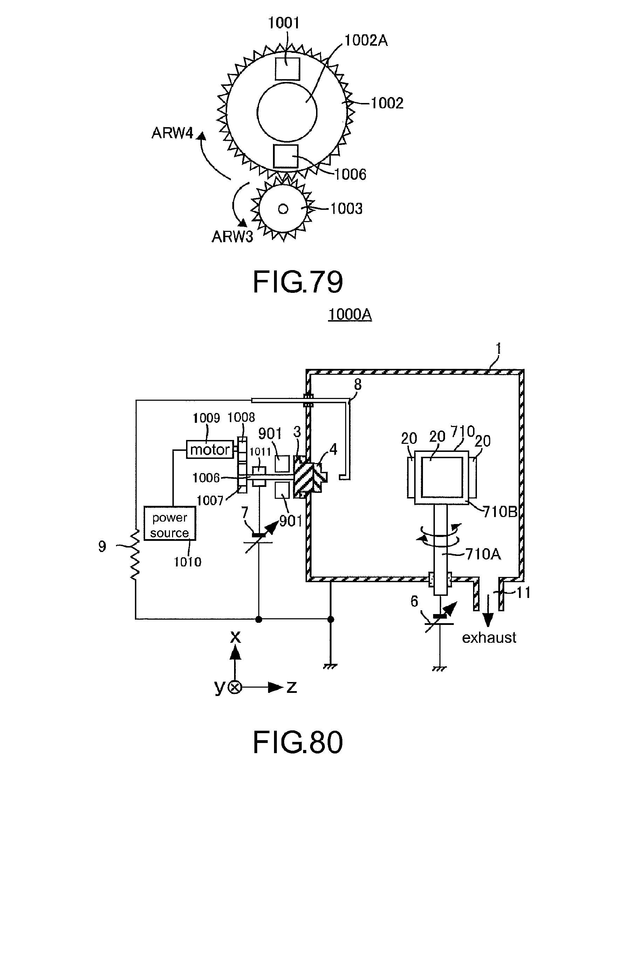

FIG. 79 is a plan view of the permanent magnet 1001, the gears 1002 and 1003, and the counterweight 1006 shown in FIG. 78 when viewed from the side of the substrate 20.

With reference to FIG. 79, the permanent magnet 1001 and the counterweight 1006 are disposed on the gear 1002 symmetrically with respect to the rotation shaft of the gear 1002. As a result, the counterweight 1006 functions as a weight for balancing against the permanent magnet 1001. The gear 1002 has a through hole 1002A in the center. The arc-type evaporation source 3A is disposed through the through hole 1002A with the central axis coinciding with the central axis of the through hole 1002A. The gear 1003 meshes with the gear 1002.

When the gear 1003 is rotated in the direction of the arrow ARW3 by the motor 1004, the gear 1002 rotates in the direction of the arrow ARW4. As the gear 1002 rotates in the direction of the arrow ARW4, the permanent magnet 1001 and the counterweight 1006 also rotate in the direction of the arrow ARW4.

By rotating the permanent magnet 1001 around the central axis of the negative electrode member 140, the magnetic field formed by the permanent magnet 1001 rotates as well and the plasma emitted from the negative electrode member 140 also rotates due to the rotating magnetic field (plasma scanning due to the rotating magnetic field). Accordingly, wherever the arc spot is located on the surface of the negative electrode member 140, the arc spot may be rotated forcibly.

When the permanent magnet 1001 comes to the upper end of the y axis direction of FIG. 78, the plasma is scanned in the lower end direction of the y axis (downward direction of the paper surface); and when the permanent magnet 1001 comes to the lower end of the y axis direction, the plasma is scanned in the upper end direction of the y axis (upward direction of the paper surface).

Moreover, if the position of the permanent magnet 1001 is further separated from the central axis of the negative electrode member 140, the plasma is scanned toward a position further away from the central axis; and if the permanent magnet 1001 is brought closer to the central axis of the negative electrode member 140, the plasma is scanned toward a position closer to the central axis.

Accordingly, with different configurations of the permanent magnet 1001, the scanning range of the plasma may be controlled and at the same time the film formation area may be controlled.

In addition, through rotation of the permanent magnet 1001, the magnetic field is symmetrically applied to the negative electrode member 140 in the axial direction (the z axis direction) and the radial direction of the negative electrode member 140. Therefore, extinguishing of the discharge and movement of the arc spot outside the negative electrode member 140 are prevented, and simultaneously stable sparkless discharge may be achieved for a long time.

Furthermore, by disposing the counterweight 1006, unbalanced load may be eliminated to prevent uneven rotation of the permanent magnet 1001.

The number of the permanent magnets is not necessarily one, and the plasma device 1000 may also be provided with two or more permanent magnets. The shape of the permanent magnet is not limited to a rectangular shape and may be a circular shape or a ring shape.

FIG. 80 is a schematic diagram showing the structure of another plasma device according to the eleventh embodiment. The plasma device of the eleventh embodiment may also be a plasma device 1000A as shown in FIG. 80.

With reference to FIG. 80, the plasma device 1000A is the same as the plasma device 900 except that a supporting member 1006, gears 1007 and 1008, a motor 1009, a power source 1010, and a brush 1011 are further added to the plasma device 900 of FIG. 62.

The supporting member 1006 has a columnar shape and has one end fixed to the arc-type evaporation source 3 and the other end fixed to the gear 1007. In this case, the central axis of the supporting member 1006 coincides with the central axes of the arc-type evaporation source 3 and the gear 1007. The supporting member 1006 includes a conductive material such as a metal.

The gear 1007 is fixed to one end of the supporting member 1006. The gear 1008 meshes with the gear 1007. The motor 1009 is connected with the gear 1008. The motor 1009 rotates the gear 1008 in a desired direction when driven by the power source 1010.

The brush 1011 includes a conductive material and is disposed in contact with the supporting member 1006. The brush 1011 is connected to the negative electrode of the power source 7. The brush 1011 does not rotate even when the supporting member 1006 rotates around the central axis. Thus, the negative voltage from the power source 7 is stably applied to the supporting member 1006.

The plan view of the gears 1007 and 1008 viewed from the side of the negative electrode member 4 is the same as the plan view of the gears 1002 and 1003 shown in FIG. 79.

When driven by the power source 1010, the motor 1009 rotates the gear 1008 in the desired direction and rotates the gear 1007 in the direction opposite to the gear 1008. Consequently, the supporting member 1006 rotates around the central axis, and the arc-type evaporation source 3 and the negative electrode member 4 also rotate around the central axis.

The power source 7 applies a negative voltage to the arc-type evaporation source 3 through the brush 1011 and the supporting member 1006. In addition, the permanent magnet 901 applies a magnetic field in the axial direction and a magnetic field in the radial direction of the negative electrode member 4.

Then, when the trigger electrode 8 is brought into contact with the protrusion 42 of the negative electrode member 4 and separated therefrom, the discharge starts from the protrusion 42 while the negative electrode member 4 is rotating.

Thus, in the plasma device 1000A, the arc discharge is performed while the negative electrode member 4 is moved with respect to the permanent magnet 901.

This case also achieves the same effect as the plasma device 1000. The reason is that, no matter where the arc spot is located on the surface of the protrusion 42, the arc spot is rotated in the magnetic field formed by the permanent magnet 901, and consequently the plasma emitted from the arc spot is forced to rotate as well.

If the outer diameter of the permanent magnet 901 is increased, the plasma is scanned toward a position further away from the protrusion 42; and if the outer diameter of the permanent magnet 901 is decreased, the plasma is scanned toward a position closer to the protrusion 42. Accordingly, with different configurations of the permanent magnet 901, the scanning range of the plasma may be controlled and at the same time the film formation area may be controlled.

Since the permanent magnet 901 applies the magnetic field in the axial direction of the negative electrode member 4 and the magnetic field in the radial direction, extinguishing of the discharge and movement of the arc spot outside the protrusion 42 are prevented, and simultaneously stable sparkless discharge may be achieved for a long time. Accordingly, the same effect as the plasma device 1000 may be achieved.

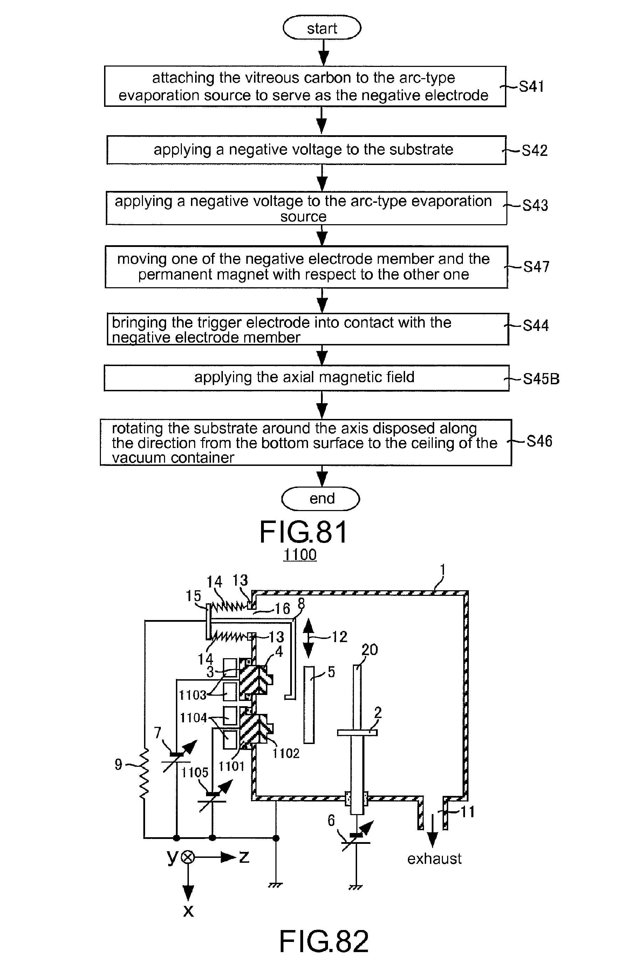

FIG. 81 is a flow chart showing the carbon thin film manufacturing method using the plasma device 1000 shown in FIG. 78.

The flow chart of FIG. 81 is the same as the flow chart of FIG. 77 except that Step S47 is further added between Step S43 and Step S44 in the flow chart of FIG. 77.

With reference to FIG. 81, when the production of a carbon thin film starts, the aforementioned Steps S41 to S43 are performed sequentially. After Step S43, one of the negative electrode member and the permanent magnet is moved with respect to the other one (Step S47).

Thereafter, the aforementioned Steps S44, S45B, and S46 are performed sequentially, and the production of the carbon thin film is completed.

The carbon thin film manufacturing method using the plasma device 1000A of FIG. 80 is also carried out according to the flow chart of FIG. 81.

By moving one of the negative electrode member 4 (or the negative electrode member 140) and the permanent magnet 901 (or the permanent magnet 1001) with respect to the other, even if the arc spot is present at a random position on the outer circumferential surface of the protrusion 42 of the negative electrode member 4 (or the negative electrode member 140), the magnetic field is still applied to the arc spot. As a result, the force for moving spirally on the outer circumferential surface of the protrusion 42 of the negative electrode member 4 (or the negative electrode member 140) acts on the arc spot.

Accordingly, extinguishing of the discharge and movement of the arc spot outside the protrusion 42 (or the negative electrode member 140) are suppressed, and stable sparkless discharge may be achieved for a long time.

### [Twelfth Embodiment]

FIG. 82 is a schematic diagram showing the structure of the plasma device according to the twelfth embodiment. With reference to FIG. 82, a plasma device 1100 of the twelfth embodiment is the same as the plasma device l0A except that an arc-type evaporation source 1101, a negative electrode member 1102, permanent magnets 1103 and 1104, and a power source 1105 are further added to the plasma device 10A of FIG. 29.

The arc-type evaporation source 1101 has the same structure as the arc-type evaporation source 3 and is fixed to the side wall of the vacuum container 1 in the same manner as the arc-type evaporation source 3. The arc-type evaporation source 1101 is connected to a negative electrode of the power source 1105.

The negative electrode member 1102 has the same structure, material, and shape as the negative electrode member 4. The negative electrode member 1102 is fixed to a surface of the arc-type evaporation source 1101 on the side of the substrate 20.

The permanent magnet 1103 has a ring shape and is disposed close to the arc-type evaporation source 3 outside the vacuum container 1. The permanent magnet 1103 applies a magnetic field to the negative electrode member 4.

The permanent magnet 1104 has a ring shape and is disposed close to the arc-type evaporation source 1101 outside the vacuum container 1. The permanent magnet 1104 applies a magnetic field to the negative electrode member 1102.

The power source 1105 is connected between the arc-type evaporation source 1102 and the ground node GND.

As described above, the plasma device 1100 includes two arc-type evaporation sources.

The production of the carbon thin film using the plasma device 1100 is carried out according to the flow chart of FIG. 77. In this case, in Step S44, the trigger electrode 8 is brought into contact with the negative electrode members 4 and 1102 sequentially to generate plasma from the protrusions 42 of the two negative electrode members 4 and 1102 respectively.

Accordingly, the carbon thin film of a large area may be formed.

The number of the arc-type evaporation sources is not limited to two (i.e. the arc-type evaporation sources 3 and 1101), and the plasma device 1100 may also be provided with a plurality of arc-type evaporation sources. When a plurality of arc-type evaporation sources are provided, the carbon thin film may be formed over a larger area in comparison with using one arc-type evaporation source.

Other descriptions of the twelfth embodiment are the same as those of the first embodiment.

### [Thirteenth Embodiment]

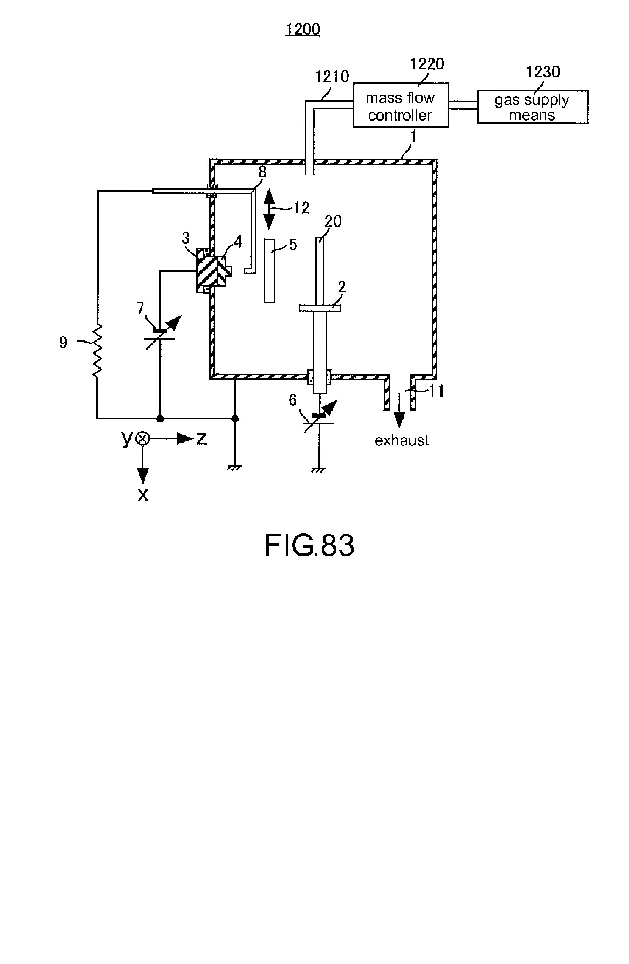

FIG. 83 is a schematic diagram showing the structure of the plasma device according to the thirteenth embodiment. With reference to FIG. 83, a plasma device 1200 of the thirteenth embodiment is the same as the plasma device 10 except that a pipe 1210, a mass flow controller 1220, and a gas supply means 1230 are further added to the plasma device 10 of FIG. 1.

One end of the pipe 1210 passes through the ceiling of the vacuum container 1 to be disposed in the vacuum container 1 while the other end of the pipe 1210 is connected to the gas supply means 1230.

The mass flow controller 1220 sets the flow of the gas received from the gas supply means 1230 to a desired flow and introduces the gas into the vacuum container 1.

The gas supply means 1230 retains argon (Ar) gas by using a cylinder, for example. The gas supply means 1230 supplies the Ar gas into the vacuum container 1 through the pipe 1210 and the mass flow controller 1220.

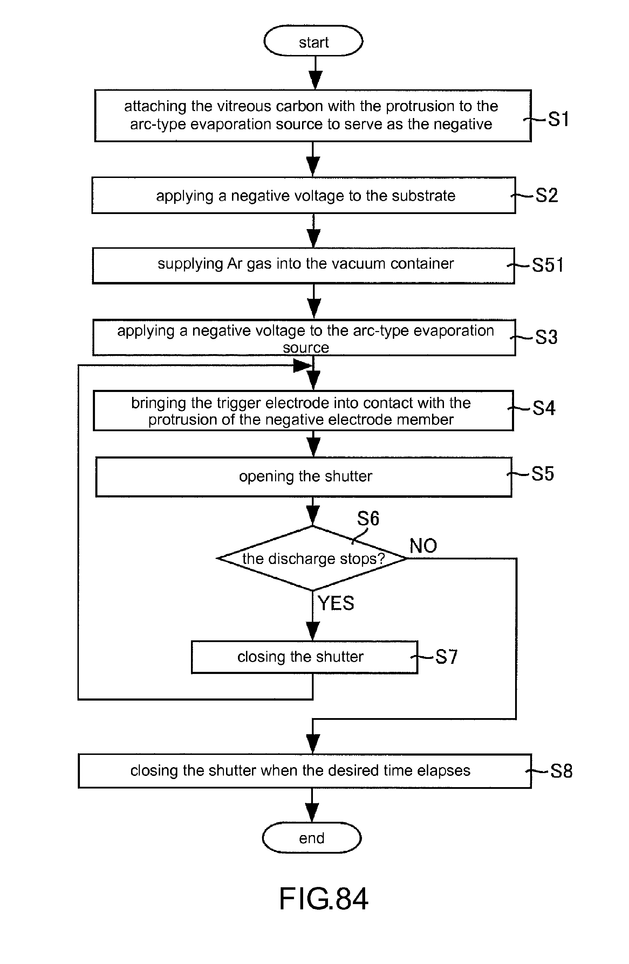

FIG. 84 is a flow chart showing the carbon thin film manufacturing method using the plasma device 1200 shown in FIG. 83.

The flow chart of FIG. 84 is the same as the flow chart of FIG. 4 except that Step S51 is further added between Step S2 and Step S3 in the flow chart of FIG. 4.

With reference to FIG. 84, when the production of a carbon thin film starts, the aforementioned Steps S1 and S2 are performed sequentially. After Step S2, the gas supply means 1230 supplies the Ar gas of a desired flow into the vacuum container 1 through the mass flow controller 1220 and the pipe 1210.

Thereafter, the aforementioned Steps S3 to S8 are performed sequentially, and the production of the carbon thin film is completed.

In the plasma device 1200, the carbon is manufactured while the Ar gas is supplied into the vacuum container 1. Since the Ar gas is a gas that can be easily ionized, the arc discharge may be stabilized. In addition, by incorporating Ar atoms into the carbon thin film, the hardness and stress of the carbon thin film may be controlled.

In the plasma device 1200, the gas supply means 1230 may supply other gases into the vacuum container 1, not limited to the Ar gas.

Furthermore, the plasma device of the thirteenth embodiment may also be one of the plasma devices 10A, 100, 100A, 200, 300, 400, 500, 600, 700, 800, 800A, 900, 900A, 900B, 1000, 1000A, 1100, and 1200 added with the pipe 1210, the mass flow controller 1220, and the gas supply means 1230.

Other descriptions of the thirteenth embodiment are the same as those of the first to the twelfth embodiments.

### [Fourteenth Embodiment]

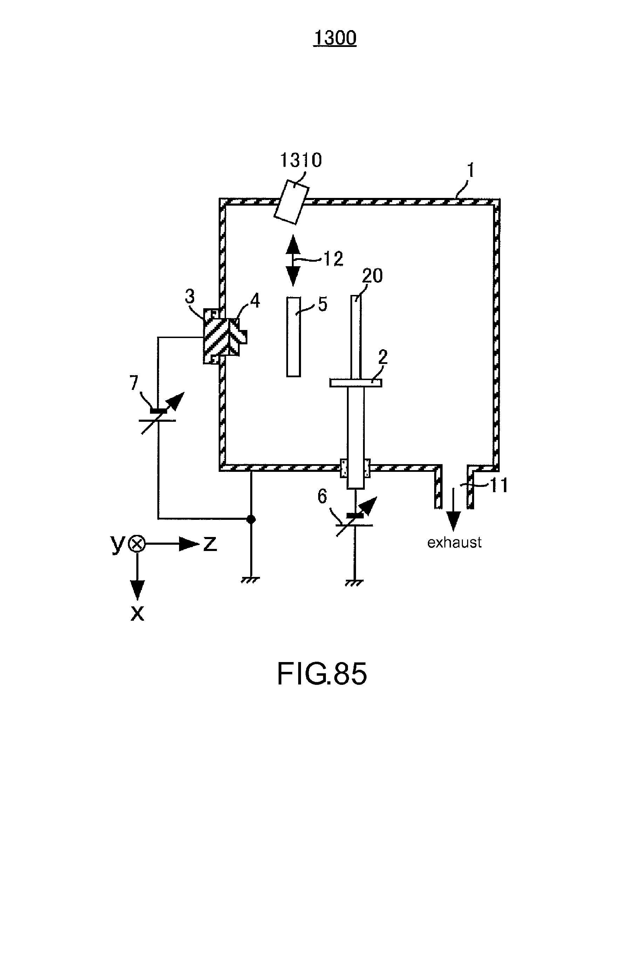

FIG. 85 is a schematic diagram showing the structure of the plasma device according to the fourteenth embodiment. With reference to FIG. 85, a plasma device 1300 of the fourteenth embodiment is the same as the plasma device 10 except that the trigger electrode 8 and the resistor 9 of the plasma device 10 of FIG. 1 are omitted and a laser light source 1310 is further added thereto.

The laser light source 1310 is fixed to the ceiling of the vacuum container 1, for example. The laser light source 1310 irradiates the tip of the protrusion 42 of the negative electrode member 4 with a laser beam. The laser beam may be YAG laser with a continuous output of 1kW and a spot diameter of 0.8 mm, for example.

The laser light source 1310 may be separated from the vacuum container 1 and be disposed on the atmosphere side, for example. In that case, the tip of the protrusion 42 may be irradiated by the laser beam through a quartz viewing port (not shown) attached to the vacuum container 1.

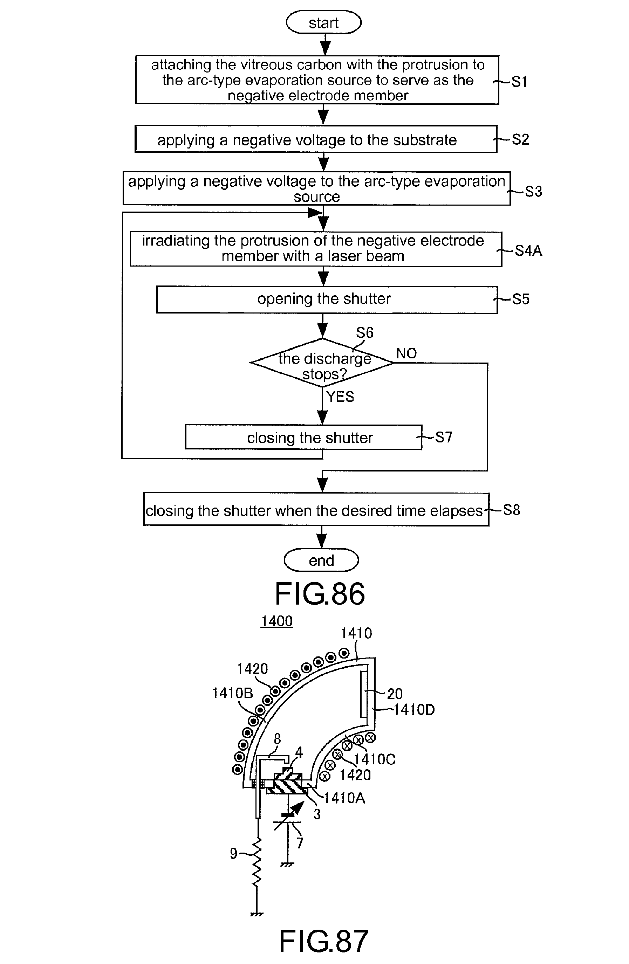

FIG. 86 is a flow chart showing the carbon thin film manufacturing method using the plasma device 1300 shown in FIG. 85.

The flow chart of FIG. 86 is the same as the flow chart of FIG. 4 except that Step S4 in the flow chart of FIG. 4 is replaced by Step S4A.

With reference to FIG. 86, when the production of a carbon thin film starts, the aforementioned Steps S1 to S3 are performed sequentially. After Step S3, the laser light source 1310 irradiates the tip of the protrusion 42 of the negative electrode member 4 with a laser beam (Step S4A).

Thereafter, the aforementioned Steps S5 to S8 are performed sequentially, and the production of the carbon thin film is completed.

As described above, in the production of the carbon thin film using the plasma device 1300, the tip of the protrusion 42 is irradiated by the laser beam to achieve arc-ignition. As a result, arc discharge is generated from the protrusion 42.

Consequently, in comparison with the case where the trigger electrode 8 is used to contact the negative electrode member 4 to achieve arc-ignition, damage of the negative electrode member 4 may be prevented.

The plasma device 1300 may also be provided with one of the negative electrode members 4A to 4L, 40, and 140 in place of the negative electrode member 4. In that case, if a negative electrode member including a plurality of protrusions or a plurality of columnar members is used, the laser light source 1310 may be rotated so as to irradiate the tips of the protrusions or the columnar members with the laser beam.

Furthermore, the plasma device of the fourteenth embodiment may also be one of the plasma devices 10A, 100, 100A, 200, 300, 400, 500, 600, 700, 800, 800A, 900, 900A, 900B, 1000, 1000A, 1100, and 1200 added with the laser light source 1310 but without the trigger electrodes 8, 17, 25, 301, 410, and 410A and the resistor 9.

Other descriptions of the fourteenth embodiment are the same as those of the first to the thirteenth embodiments.

### [Fifteenth Embodiment]

FIG. 87 is a schematic diagram showing the structure of the plasma device according to the fifteenth embodiment. With reference to FIG. 87, a plasma device 1400 of the fifteenth embodiment includes the arc-type evaporation source 3, the power source 7, the trigger electrode 8, the resistor 9, a vacuum container 1410, and a coil 1420.

The vacuum container 1410 is a cylindrical member which is curved in an arc shape. The vacuum container 1410 is exhausted by an exhaust device (not shown) to create a vacuum therein.

The arc-type evaporation source 3 is fixed to a wall 1410A of the vacuum container 1410. The arc-type evaporation source 3 is connected to the negative electrode of the power source 7. The negative electrode member 4 is fixed to a surface of the arc-type evaporation source 3 on the side of the substrate 20.

The power source 7 is connected between the arc-type evaporation source 3 and the ground node GND.

An end of the trigger electrode 8 passes through the wall 1410A of the vacuum container 1410 to be disposed in the vacuum container 1410 and faces the protrusion 42 of the negative electrode member 4. The other end of the trigger electrode 8 is connected with the resistor 9.

The resistor 9 is connected between the trigger electrode 8 and the ground node GND.

The coil 1420 is disposed around the vacuum container 1410 along walls 1410B and 1410C of the vacuum container 1410. Two ends of the coil 1420 are connected to a power source (not shown).

The substrate 20 is fixed to a wall 1410D of the vacuum container 1410.

When the power source (not shown) applies a current to the coil 1420, the coil 1420 generates a magnetic field in the vacuum container 1410. This magnetic field bends the carbon ions emitted from the protrusion 42 of the negative electrode member 4 in an arc along the vacuum container 1410 to reach the substrate 20. Particles emitted from the negative electrode member 4 and neutral particles collide with the walls 1410B and 1410C of the vacuum container 1410 and do not reach the substrate 20.

Accordingly, when the plasma device 1400 is used, even the slight particles recognized in FIG. 5(a) may be removed, by which a carbon thin film having extremely few particles, i.e. an extremely low surface roughness, may be manufactured.

In addition, when the plasma device 1400 is used, a high-quality carbon thin film that has few impurities may be manufactured.

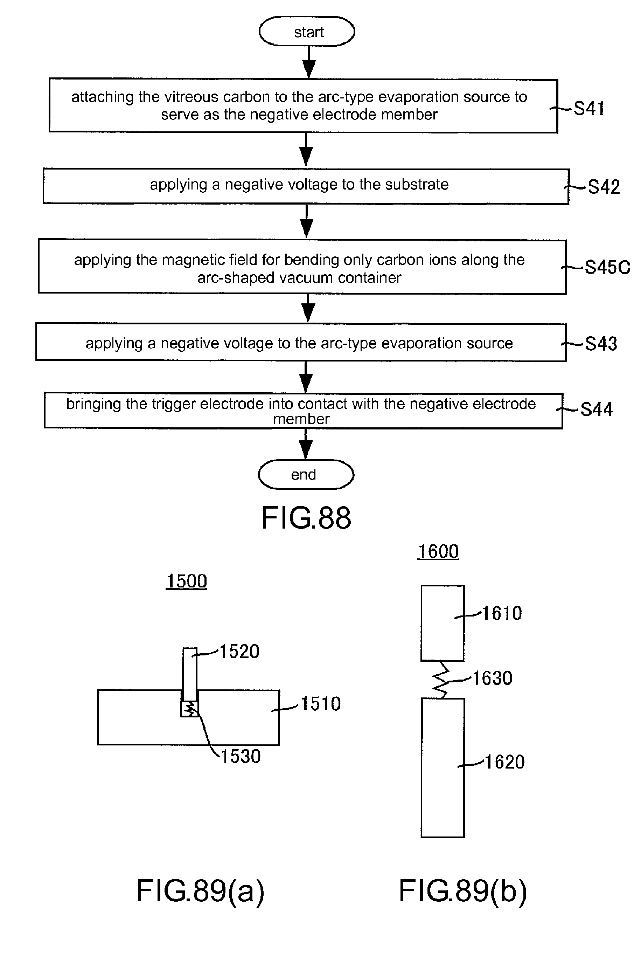

FIG. 88 is a flow chart showing a carbon thin film manufacturing method using the plasma device 1400 shown in FIG. 87.

The flow chart of FIG. 88 is the same as the flow chart of FIG. 77 except that Steps S45B and S46 in the flow chart of FIG. 77 are omitted, and Step S45C is inserted between Step S42 and Step S43.

With reference to FIG. 88, when the production of a carbon thin film starts, the aforementioned Steps S41 and S42 are performed sequentially. After Step S42, a magnetic field is applied to bend the carbon ions emitted from the protrusion 42 of the negative electrode member 4 into the vacuum container 1410 along the arc-shaped vacuum container 1410 (Step S45C). Thereafter, the aforementioned Steps S43 and S44 are performed sequentially. Therefore, particles and neutral particles do not reach the substrate 20, and only the carbon ions reach the substrate 20 for manufacturing the carbon thin film and the series of operations ends.

Thus, with the plasma device 1400, a high-quality carbon thin film may be manufactured.

In the plasma device 1400, the wall 1410D of the vacuum container 1410 constitutes the "holding member" for holding the substrate 20.

Moreover, in the fifteenth embodiment, the plasma device 1400 may be provided with one of the negative electrode members 4A to 4L, 40, and 140 in place of the negative electrode member 4 and one of the trigger electrodes 17, 25, 301, 410, and 410A in place of the trigger electrode 8.

Furthermore, in the fifteenth embodiment, the plasma device 1400 may be provided with the laser light source 1310 in place of the trigger electrode 8 and the resistor 9.

Other descriptions of the fifteenth embodiment are the same as those of the first to the fourteenth embodiments.

FIG. 89 is a diagram of the negative electrode member according to an embodiment of the invention. With reference to FIG. 89, a negative electrode member 1500 includes a main body 1510, a protrusion 1520, and a spring 1530. The main body 1510 has a disc shape and includes sintered graphite, for example. The protrusion 1520 includes the vitreous carbon and has a columnar shape. The protrusion 1520 is fixed to the main body 1510 through the spring 1530 (see FIG. 89(a)).

In addition, a negative electrode member 1600 includes columnar members 1610 and 1620 and a spring 1630. The columnar member 1610 includes the vitreous carbon. The columnar member 1620 includes sintered graphite, for example. The columnar member 1610 is fixed to the columnar member 1620 through the spring 1630 (see FIG. 89(b)).

By using the negative electrode members 1500 and 1600, damage of the tip portions of the negative electrode members 1500 and 1600 may be prevented. The reason is that, when the trigger electrode 8, etc. comes in contact with the tip portions of the negative electrode members 1500 and 1600, the impact of contact of the trigger electrode 8, etc. is absorbed by the springs 1530 and 1630.

The negative electrode member 1500 or 1600 may be used in any of the plasma devices 10, 10A, 100, 100A, 200, 300, 400, 500, 600, 700, 800, 800A, 900, 900A, 900B, 1000, 1000A, 1100, 1200, 1300, and 1400 of the first to the fifteenth embodiments described above.

The above illustrates the various plasma devices 10, 10A, 100, 100A, 200, 300, 400, 500, 600, 700, 800, 800A, 900, 900A, 900B, 1000, 1000A, 1100, 1200, 1300, and 1400. The plasma devices 10, 10A, 100, 100A, 200, 300, 400, 500, 600, 700, 800, 800A, 900, 900A, 900B, 1000, 1000A, 1100, 1200, 1300, and 1400 respectively include the negative electrode member including the vitreous carbon having at least one protrusion.

Accordingly, the plasma device according to the embodiment of the invention includes the vacuum container, the arc-type evaporation source which is fixed to the vacuum container, the negative electrode member attached to the arc-type evaporation source, the discharge starting means starting the discharge, and the power source applying a negative voltage to the arc-type evaporation source, wherein the negative electrode member includes at least one columnar portion that includes the vitreous carbon and has a columnar shape, and the discharge starting means may start the discharge such that the plasma is emitted from the at least one columnar portion of the negative electrode member.

The at least one columnar portion each has a shape including any of a columnar shape, a conical shape, a truncated conical shape, a prismatic shape, and a truncated pyramidal shape. In this case, the cross-sectional shape perpendicular to the length direction of the columnar shape, the conical shape, and the truncated conical shape is not limited to a circle and may be an ellipse.

The above illustrates the carbon thin film manufacturing method that uses the various plasma devices 10, 10A, 100, 100A, 200, 300, 400, 500, 600, 700, 800, 800A, 900, 900A, 900B, 1000, 1000A, 1100, 1200, 1300, and 1400. The plasma devices 10, 10A, 100, 100A, 200, 300, 400, 500, 600, 700, 800, 800A, 900, 900A, 900B, 1000, 1000A, 1100, 1200, 1300, and 1400 respectively include the negative electrode member including the vitreous carbon having at least one protrusion.

Accordingly, the carbon thin film manufacturing method according to the embodiment of the invention may include a first process of attaching the negative electrode member to the arc-type evaporation source that is fixed to the vacuum container to face the substrate, wherein the negative electrode member includes at least one columnar portion that includes the vitreous carbon and has a columnar shape; a second process of applying a negative voltage to the arc-type evaporation source; and a third process of starting the discharge such that the plasma is emitted from the at least one columnar portion of the negative electrode member.

The reason is that, when the negative electrode member including the vitreous carbon having the at least one protrusion is used to generate the arc discharge, heat distortion of the at least one protrusion is reduced and cracking of the negative electrode members may be suppressed.

Moreover, in the embodiment of the invention, any of the plasma devices 10, 10A, 100, 100A, 200, 300, 400, 500, 600, 700, 800, 800A, 900, 900A, 900B, 1000, 1000A, 1100, 1200, 1300, and 1400 may be used for coating the carbon thin film on the surface of the substrate.

In this case, the substrate includes any of a metal, ceramics, a resin, a semiconductor, and any combination of the foregoing. The carbon thin film coating method is for coating a carbon thin film on the surface of the substrate that includes any of a metal, ceramics, a resin, a semiconductor, and any combination of the foregoing. The carbon thin film coating method may include a first process of holding the substrate to face the arc-type evaporation source fixed to the vacuum container; a second process of attaching the negative electrode member to the arc-type evaporation source, wherein the negative electrode member includes at least one columnar portion that includes a vitreous carbon and has a columnar shape; a third process of applying a negative voltage to the arc-type evaporation source; and a fourth process of starting the discharge such that the plasma is emitted from the at least one columnar portion of the negative electrode member.

The metal includes tungsten carbide, steel, aluminum, and a cobalt chromium alloy, for example. Besides, the ceramics include aluminum oxide, silicon nitride, cubic boron nitride, and silicon oxide, for example. Furthermore, the resin includes polycarbonate, polyethylene terephthalate, and polyvinyl chloride, for example. The semiconductor includes silicon, gallium nitride, and zinc oxide, for example.

The eighth embodiment illustrates the case where the carbon thin film is formed on the entire surface of the substrate 20 by diffusing the beam-shaped plasma PLZ1. In addition, the ninth embodiment illustrates the case where the carbon thin film is formed on the entire surface of the substrate 20 by scanning the beam-shaped plasma PLZ1.

Although the eighth embodiment illustrates that two permanent magnets 711 and 712 are disposed along the direction from the bottom surface to the ceiling of the vacuum container 1, the two permanent magnets 711 and 712 may also be disposed substantially in parallel along any direction to diffuse the beam-shaped plasma PLZ1 in any direction. In that case, the substrate 20 is rotated around the axis that is arranged along the direction of diffusing the plasma PLZ1.

Furthermore, although the second embodiment illustrates that the permanent magnet 802 is reciprocated along the direction from the bottom surface to the ceiling of the vacuum container 1, the permanent magnet 802 may be reciprocated along any direction to scan the beam-shaped plasma PLZ1 in any direction. In that case, the substrate 20 is rotated around the axis that is arranged along the direction of scanning the plasma PLZ1.

According to the embodiment of the invention, the two permanent magnets 711 and 712 or two electromagnets constitute the "magnetic field generating mechanism", the supporting member 801 and the permanent magnet 802 constitute the "magnetic field generating mechanism", the coil 803 and the power source 804 constitute the "magnetic field generating mechanism", and the permanent magnet 901 constitutes the "magnetic field generating mechanism".

Furthermore, the coil 902 (or the coil 904) and the power source 903 constitute the "magnetic field generating mechanism", the coil 905 (or the coil 904) and the power source 906 constitute the "magnetic field generating mechanism", the permanent magnet 1001 constitutes the "magnetic field generating mechanism", the permanent magnets 1003 and 1004 constitute the "magnetic field generating mechanism", and the coil 1420 and the power source (not shown) constitute the "magnetic field generating mechanism".

In addition, according to the embodiment of the invention, the holding member 710 and the rotating device constitute the "rotating mechanism".

It should be understood that the embodiments disclosed herein are illustrative rather than restrictive in all respects. The scope of the invention is defined by the claims rather than by the description of the above embodiments, and is intended to include any equivalent of the claims and any modification within the scope of the claims.

### Industrial Applicability

The invention is suitable for a plasma device and a carbon thin film manufacturing method and a coating method that use the plasma device.

## Claims

1. A plasma device, comprising:
a vacuum container;
an arc-type evaporation source fixed to the vacuum container;
a negative electrode member attached to the arc-type evaporation source;
a holding member holding a substrate that is disposed to face the negative electrode member;
a discharge starting means starting a discharge; and
a power source applying a negative voltage to the arc-type evaporation source,
wherein the negative electrode member comprises at least one columnar portion that comprises a vitreous carbon and has a columnar shape, and
the discharge starting means starts the discharge such that a plasma is emitted from the at least one columnar portion of the negative electrode member.

2. The plasma device according to claim 1, wherein the plasma is beam-shaped.

3. The plasma device according to claim 1 or 2, wherein a discharge trace formed on the at least one columnar portion of the negative electrode member has a spiral shape after the discharge.

4. The plasma device according to any of claims 1-3, wherein the negative electrode member comprises:
a base; and
the at least one columnar portion attached to the base.

5. The plasma device according to any of claims 1-4, wherein the at least one columnar portion each has a shape comprising any of a columnar shape, a conical shape, a truncated conical shape, a prismatic shape, and a truncated pyramidal shape.

6. The plasma device according to any of claims 1-5, wherein the at least one columnar portion each comprises a walled structure.

7. The plasma device according to claim 6, wherein a planar shape of the walled structure viewed from the substrate side has any of a ring shape, a rectangular ring shape, a linear shape, and an arc shape.

8. The plasma device according to claim 1, wherein the negative electrode member comprises:
a plurality of columnar portions each comprising the vitreous carbon and having a columnar shape; and
an insulating frame disposed among the columnar portions.

9. The plasma device according to any of claims 1-8, further comprising a delivery mechanism that sends out the negative electrode member.

10. The plasma device according to claim 9, wherein the delivery mechanism sends out the negative electrode member such that a film thickness distribution of a carbon thin film deposited on the substrate or a film formation rate of the carbon thin film falls in a desired range.

11. The plasma device according to any of claims 1-10, further comprising a magnetic field generating means that is disposed in a position surrounding the negative electrode member, between the substrate and the negative electrode member, or in a desired position on a side opposite to the substrate with respect to the negative electrode member, and generates a magnetic field to diffuse or scan the plasma.

12. The plasma device according to claim 11, further comprising a rotating mechanism that rotates the magnetic field generating means around a central axis of the negative electrode member.

13. The plasma device according to claim 11, further comprising a moving means that moves the negative electrode member with respect to the magnetic field generating means.

14. The plasma device according to claim 11 or 13, wherein the magnetic field generating means comprises two permanent magnets that are disposed substantially in parallel with a length direction being a direction for diffusing or scanning the plasma.

15. The plasma device according to claim 11 or 13, wherein the magnetic field generating means comprises two permanent magnets that are disposed substantially in parallel with the length direction being a direction from the negative electrode member to the substrate, and the two permanent magnets are rotated around a central axis of the at least one columnar portion.

16. The plasma device according to claim 11 or 13, wherein the magnetic field generating means comprises one permanent magnet that reciprocates along the direction for diffusing or scanning the plasma.

17. The plasma device according to claim 11 or 13, wherein the magnetic field generating means comprises:
a coil disposed along the direction for diffusing or scanning the plasma and wound around a central axis; and
a power source periodically changing a magnitude of a current flowing in the coil.

18. The plasma device according to any of claims 1-17, further comprising a gas introducing means that introduces a gas into the vacuum container when the carbon thin film is deposited on the substrate.

19. The plasma device according to any of claims 1-18, wherein the discharge generating means generates the plasma by irradiating the at least one columnar member with a laser beam.

20. The plasma device according to any of claims 1-18, wherein the discharge starting means generates the discharge by bringing a trigger electrode into contact with the at least one columnar member and separating the trigger electrode therefrom, and
the trigger electrode comprises a flexible member.

21. The plasma device according to any of claims 1-20, wherein the negative electrode member further comprises a shock absorbing member that is disposed in contact with an end of the at least one columnar member on the side opposite to the substrate.

22. The plasma device according to claim 1, wherein the vacuum container comprises:
a cylindrical member curved in an arc shape; and
a magnetic field generating means generating a magnetic field in the cylindrical member,
wherein the arc-type evaporation source is disposed on an end of the cylindrical member,
the holding member holds the substrate on another end of the cylindrical member, and
the negative electrode member is attached to the arc-type evaporation source such that the at least one columnar portion protrudes into the cylindrical member.

23. The plasma device according to claim 1, wherein a plurality of the arc-type evaporation sources are fixed to the vacuum container.

24. A manufacturing method of a carbon thin film, the manufacturing method comprising:
a first process of attaching a negative electrode member to an arc-type evaporation source that is fixed to a vacuum container to face a substrate, wherein the negative electrode member comprises at least one columnar portion that comprises a vitreous carbon and has a columnar shape;
a second process of applying a negative voltage to the arc-type evaporation source; and
a third process of starting a discharge such that a plasma is emitted from the at least one columnar portion of the negative electrode member.

25. The manufacturing method of the carbon thin film according to claim 24, further comprising:
a fourth process of applying a magnetic field in an axial direction of the columnar portion, such that a percentage that an arc spot of the discharge is not arc-extinguished is greater than 0% and a percentage that the arc spot does not move outside the at least one columnar portion is greater than 0%,
wherein, in the second process, the negative voltage is applied to the arc-type evaporation source, such that an arc current flows to make the percentage that the arc spot is not arc-extinguished greater than 0% and make the percentage that the arc spot does not move outside the at least one columnar portion greater than 0%.

26. A coating method for coating a carbon thin film on a surface of a substrate that comprises any of a metal, ceramics, a resin, a semiconductor, and any combination of the foregoing, the coating method comprising:
a first process of holding the substrate to face an arc-type evaporation source fixed to a vacuum container;
a second process of attaching a negative electrode member to the arc-type evaporation source, wherein the negative electrode member comprises at least one columnar portion that comprises a vitreous carbon and has a columnar shape;
a third process of applying a negative voltage to the arc-type evaporation source; and
a fourth process of starting a discharge such that a plasma is emitted from the at least one columnar portion of the negative electrode member.
